(19) Europäisches Patentamt
European Patent Office
Office européen des brevets

(11) EP 4 293 055 A1

(12) # EUROPEAN PATENT APPLICATION
published in accordance with Art. 153(4) EPC

(43) Date of publication:
**20.12.2023 Bulletin 2023/51**

(21) Application number: **21925840.7**

(22) Date of filing: **20.12.2021**

(51) International Patent Classification (IPC):
***C08F 212/14** (2006.01)* ***C08F 220/38** (2006.01)*
***C08F 220/54** (2006.01)* ***C08F 228/02** (2006.01)*
***G03F 7/004** (2006.01)* ***G03F 7/039** (2006.01)*
***G03F 7/20** (2006.01)*

(52) Cooperative Patent Classification (CPC):
**C08F 212/14; C08F 220/38; C08F 220/54; C08F 228/02; G03F 7/004; G03F 7/039; G03F 7/20**

(86) International application number:
**PCT/JP2021/047008**

(87) International publication number:
**WO 2022/172597 (18.08.2022 Gazette 2022/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **09.02.2021 JP 2021019087**

(71) Applicant: **FUJIFILM Corporation**
**Tokyo 106-8620 (JP)**

(72) Inventors:
- **YAMAGUCHI Shuhei**
  **Haibara-gun, Shizuoka 421-0396 (JP)**
- **MIYOSHI Taro**
  **Haibara-gun, Shizuoka 421-0396 (JP)**

(74) Representative: **HGF**
**HGF Limited**
**1 City Walk**
**Leeds LS11 9DX (GB)**

(54) **ACTIVE-RAY-SENSITIVE OR RADIATION-SENSITIVE RESIN COMPOSITION, RESIST FILM, METHOD FOR FORMING POSITIVE-WORKING PATTERN, AND METHOD FOR MANUFACTURING ELECTRONIC DEVICE**

(57) Provided are an actinic ray-sensitive or radiation-sensitive resin composition having excellent temporal stability and excellent LWR suppression property of a pattern to be formed; a resist film; a positive tone pattern forming method; and a method for manufacturing an electronic device, which relate to the actinic ray-sensitive or radiation-sensitive resin composition.

The actinic ray-sensitive or radiation-sensitive resin composition contains a resin (A) having a repeating unit (a) and a basic compound, a pKa of a conjugate acid of which is 13.00 or less, in which the repeating unit (a) has a non-ionic group which generates an acid in a case where a leaving group is eliminated by irradiation with an actinic ray or a radiation, in which a repeating unit obtained by replacing the leaving group with a hydrogen atom has a molecular weight of 300 or less, and the repeating unit (a) is a predetermined amount with respect to a total solid content of the actinic ray-sensitive or radiation-sensitive resin composition.

EP 4 293 055 A1

## Description

## BACKGROUND OF THE INVENTION

1. Field of the Invention

The present invention relates to an actinic ray-sensitive or radiation-sensitive resin composition, a resist film, a positive tone pattern forming method, and a method for manufacturing an electronic device.

2. Description of the Related Art

Various methods have been studied as a pattern forming method, and examples thereof include the following methods.

That is, an actinic ray-sensitive or radiation-sensitive resin film (hereinafter, also referred to as "resist film") formed of an actinic ray-sensitive or radiation-sensitive resin composition is exposed to light to cause a change in solubility of the resist film in a developer in a region reflecting the exposed pattern. Thereafter, development is performed using a developer (alkali developer, organic solvent-based developer, or the like) to remove an exposed portion or non-exposed portion of the resist film, thereby obtaining a desired pattern.

For example, JP2011-186341A discloses an actinic ray-sensitive or radiation-sensitive resin composition containing a resin (P) including a repeating unit represented by General Formula (I).

General Formula (I)

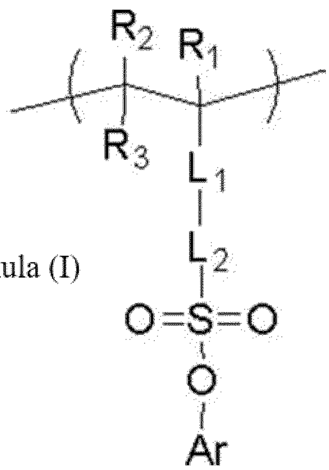

## SUMMARY OF THE INVENTION

The present inventors have studied the actinic ray-sensitive or radiation-sensitive resin composition disclosed in JP2011-186341A, and have found that it is difficult to achieve both temporal stability of the actinic ray-sensitive or radiation-sensitive resin composition and a small line width roughness (LWR) in a case of forming a pattern using the actinic ray-sensitive or radiation-sensitive resin composition.

An object of the present invention is to provide an actinic ray-sensitive or radiation-sensitive resin composition having excellent temporal stability and excellent LWR suppression property of a pattern to be formed.

Another object of the present invention is to provide a resist film, a positive tone pattern forming method, and a method for manufacturing an electronic device, which relate to the actinic ray-sensitive or radiation-sensitive resin composition.

The present inventors have found that the above-described objects can be achieved by the following configurations.

[1] An actinic ray-sensitive or radiation-sensitive resin composition comprising:

a resin (A) having a repeating unit (a); and
a basic compound, a pKa of a conjugate acid of which is 13.00 or less,
in which the repeating unit (a) has a non-ionic group which generates an acid in a case where a leaving group is eliminated by irradiation with an actinic ray or a radiation, in which a repeating unit obtained by replacing the leaving group with a hydrogen atom has a molecular weight of 300 or less,

in a case where the actinic ray-sensitive or radiation-sensitive resin composition does not contain a compound which generates an acid by irradiation with an actinic ray or a radiation, a molar amount of the repeating unit (a) is 0.50 mmol/g or more with respect to a total solid content of the actinic ray-sensitive or radiation-sensitive resin composition, and

in a case where the actinic ray-sensitive or radiation-sensitive resin composition contains the compound which generates an acid by irradiation with an actinic ray or a radiation, a total molar amount of the repeating unit (a) and the compound is 0.50 mmol/g or more with respect to the total solid content of the actinic ray-sensitive or radiation-sensitive resin composition.

[2] The actinic ray-sensitive or radiation-sensitive resin composition according to [1],

in which the repeating unit (a) is a repeating unit represented by General Formula (1),

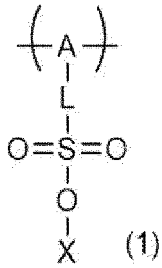

(1)

in General Formula (1), A represents a group constituting a main chain of a resin,
L represents a single bond or a divalent linking group, and
X represents a group which is eliminated by irradiation with an actinic ray or a radiation.

[3] The composition according to [1] or [2],

in which the repeating unit (a) is a repeating unit represented by General Formula (1-2),

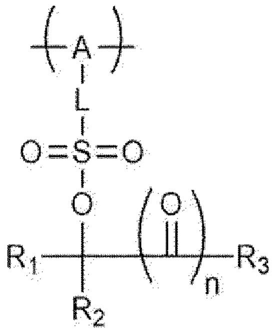

(1-2)

in General Formula (1-2), A represents a group constituting a main chain of a resin,
L represents a single bond or a divalent linking group,
$R_1$ and $R_2$ each independently represent a hydrogen atom or an organic group,
$R_3$ represents an organic group, and
n represents 0 or 1,
where two of $R_1$ to $R_3$ may be bonded to each other to form a ring.

[4] The actinic ray-sensitive or radiation-sensitive resin composition according to [2] or [3],

in which A is a group consisting of only atoms selected from the group consisting of a hydrogen atom and a carbon atom, and
L is a single bond or a group consisting of only atoms selected from the group consisting of a hydrogen atom and a carbon atom.

[5] The actinic ray-sensitive or radiation-sensitive resin composition according to any one of [1] to [4], in which the repeating unit (a) is a repeating unit which generates an acid having a pKa of -1.50 or more by irradiation with an actinic ray or a radiation.

[6] The actinic ray-sensitive or radiation-sensitive resin composition according to any one of [1] to [5], in which, in the repeating unit (a), the repeating unit obtained by replacing the leaving group with a hydrogen atom has a molecular weight of 200 or less.

[7] The actinic ray-sensitive or radiation-sensitive resin composition according to any one of [1] to [6], in which the resin (A) is a resin in which solubility in an alkali developer is improved by action of acid.

[8] The actinic ray-sensitive or radiation-sensitive resin composition according to any one of [1] to [7],

in which the resin (A) has a repeating unit represented by General Formula (A2),

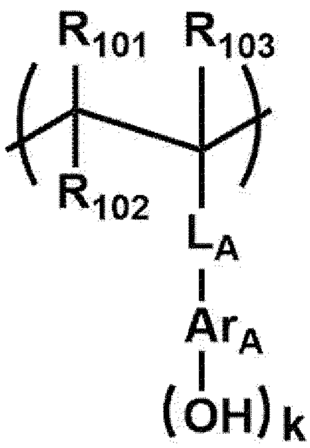

(A2)

in General Formula (A2), $R_{101}$, $R_{102}$, and $R_{103}$ each independently represent a hydrogen atom, an alkyl group, a cycloalkyl group, a halogen atom, a cyano group, or an alkyloxycarbonyl group,
$L_A$ represents a single bond or a divalent linking group,
$Ar_A$ represents an aromatic ring group, and
k represents an integer of 1 to 5,
where $R_{102}$ may be bonded to $Ar_A$, and in this case, $R_{102}$ represents a single bond or an alkylene group.

[9] The actinic ray-sensitive or radiation-sensitive resin composition according to any one of [1] to [8],

in which the resin (A) has a repeating unit having an acid-decomposable group, and
the repeating unit having an acid-decomposable group is decomposed by action of acid to generate one or more groups selected from the group consisting of a carboxyl group and an aromatic hydroxyl group.

[10] The actinic ray-sensitive or radiation-sensitive resin composition according to [9],

in which the repeating unit having an acid-decomposable group is a repeating unit represented by any one of General Formulae (3) to (7),

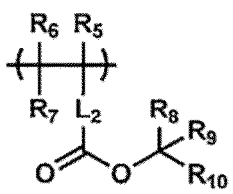

(3)

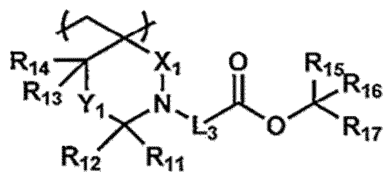

(4)

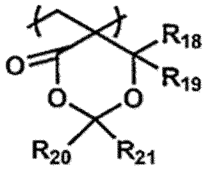

(5)

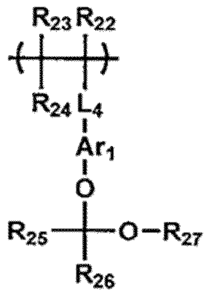

(6)

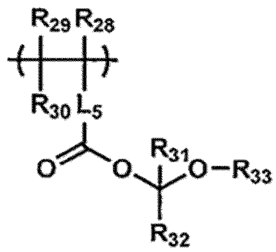

(7)

in General Formula (3), $R_5$ to $R_7$ each independently represent a hydrogen atom, an alkyl group, a cycloalkyl group, a halogen atom, a cyano group, or an alkoxycarbonyl group,
$L_2$ represents a single bond or a divalent linking group, and
$R_8$ to $R_{10}$ each independently represent an alkyl group, a cycloalkyl group, an aryl group, an aralkyl group, or an alkenyl group, where two of $R_8$ to $R_{10}$ may be bonded to each other to form a ring,
in General Formula (4), $R_{11}$ to $R_{14}$ each independently represent a hydrogen atom or an organic group, where at least one of $R_{11}$ or $R_{12}$ represents an organic group,
$X_1$ represents -CO-, -SO-, or $-SO_2-$,
$Y_1$ represents -O-, -S-, -SO-, $-SO_2-$, or $-NR_{34}-$, where $R_{34}$ represents a hydrogen atom or an organic group,
$L_3$ represents a single bond or a divalent linking group, and
$R_{15}$ to $R_{17}$ each independently represent an alkyl group, a cycloalkyl group, an aryl group, an aralkyl group, or an alkenyl group, where two of $R_{15}$ to $R_{17}$ may be bonded to each other to form a ring,
in General Formula (5), $R_{18}$ and $R_{19}$ each independently represent a hydrogen atom or an organic group, and
$R_{20}$ and $R_{21}$ each independently represent a hydrogen atom, an alkyl group, a cycloalkyl group, an aryl group, an aralkyl group, or an alkenyl group, where $R_{20}$ and $R_{21}$ may be bonded to each other to form a ring,
in General Formula (6), $R_{22}$ to $R_{24}$ each independently represent a hydrogen atom, an alkyl group, a cycloalkyl group, a halogen atom, a cyano group, or an alkoxycarbonyl group,
$L_4$ represents a single bond or a divalent linking group,
An represents an aromatic ring group, and
$R_{25}$ to $R_{27}$ each independently represent a hydrogen atom, an alkyl group, a cycloalkyl group, an aryl group, an aralkyl group, or an alkenyl group,
where $R_{26}$ and $R_{27}$ may be bonded to each other to form a ring, and
$R_{24}$ or $R_{25}$ may be bonded to An,
in General Formula (7), $R_{28}$ to $R_{30}$ each independently represent a hydrogen atom, an alkyl group, a cycloalkyl group, a halogen atom, a cyano group, or an alkoxycarbonyl group,
$L_5$ represents a single bond or a divalent linking group,
$R_{31}$ and $R_{32}$ each independently represent a hydrogen atom, an alkyl group, a cycloalkyl group, an aryl group, an aralkyl group, or an alkenyl group, and
$R_{33}$ represents an alkyl group, a cycloalkyl group, an aryl group, an aralkyl group, or an alkenyl group, where $R_{32}$ and $R_{33}$ may be bonded to each other to form a ring.

[11] The actinic ray-sensitive or radiation-sensitive resin composition according to [10],
in which the repeating unit having an acid-decomposable group is a repeating unit represented by any one of General Formula (6) or (7).
[12] The actinic ray-sensitive or radiation-sensitive resin composition according to any one of [1] to [11],

in which, in the case where the actinic ray-sensitive or radiation-sensitive resin composition does not contain the compound which generates an acid by irradiation with an actinic ray or a radiation, the molar amount of the repeating unit (a) is 0.70 mmol/g or more with respect to the total solid content of the actinic ray-sensitive or radiation-sensitive resin composition, and
in the case where the actinic ray-sensitive or radiation-sensitive resin composition contains the compound which generates an acid by irradiation with an actinic ray or a radiation, the total molar amount of the repeating unit (a) and the compound is 0.70 mmol/g or more with respect to the total solid content of the actinic ray-sensitive or radiation-sensitive resin composition.

[13] The actinic ray-sensitive or radiation-sensitive resin composition according to any one of [1] to [12],

in which, in the case where the actinic ray-sensitive or radiation-sensitive resin composition does not contain the compound which generates an acid by irradiation with an actinic ray or a radiation, the molar amount of the repeating unit (a) is 1.00 mmol/g or more with respect to a total solid content of the actinic ray-sensitive or radiation-sensitive resin composition, and
in the case where the actinic ray-sensitive or radiation-sensitive resin composition contains the compound which generates an acid by irradiation with an actinic ray or a radiation, the total molar amount of the repeating unit (a) and the compound is 1.00 mmol/g or more with respect to the total solid content of the actinic ray-sensitive or radiation-sensitive resin composition.

[14] The actinic ray-sensitive or radiation-sensitive resin composition according to any one of [1] to [13], in which the basic compound is a compound having an aromatic ring group.
[15] The actinic ray-sensitive or radiation-sensitive resin composition according to any one of [1] to [14], in which the basic compound is a non-ionic compound having an aromatic ring group.
[16] A resist film formed of the actinic ray-sensitive or radiation-sensitive resin composition according to any one of [1] to [15].
[17] A positive tone pattern forming method comprising:

a step of forming a resist film on a substrate using the actinic ray-sensitive or radiation-sensitive resin composition according to any one of [1] to [15];
a step of exposing the resist film; and
a step of developing the exposed resist film using an alkali developer.

[18] A method for manufacturing an electronic device, comprising:
the positive tone pattern forming method according to [17].

According to the present invention, it is possible to provide an actinic ray-sensitive or radiation-sensitive resin composition having excellent temporal stability and excellent LWR suppression property of a pattern to be formed.
In addition, according to the present invention, it is possible to provide a resist film, a positive tone pattern forming method, and a method for manufacturing an electronic device, which relate to the actinic ray-sensitive or radiation-sensitive resin composition.

## DESCRIPTION OF THE PREFERRED EMBODIMENTS

Hereinafter, the present invention will be described in detail.
Description of configuration requirements described below may be made on the basis of representative embodiments of the present invention in some cases, but the present invention is not limited to such embodiments.
In notations for a group (atomic group) in the present specification, in a case where the group is cited without specifying that it is substituted or unsubstituted, the group includes both a group having no substituent and a group having a substituent as long as it does not impair the spirit of the present invention. For example, an "alkyl group" includes not only an alkyl group having no substituent (unsubstituted alkyl group), but also an alkyl group having a substituent (substituted alkyl group).
In addition, an "organic group" in the present specification refers to a group including at least one carbon atom.
A substituent is a monovalent substituent unless otherwise specified.
"Actinic ray" or "radiation" in the present specification means, for example, a bright line spectrum of a mercury lamp, far ultraviolet rays typified by an excimer laser, extreme ultraviolet rays (EUV), X-rays, electron beams (EB), or the like. "Light" in the present specification means actinic ray or radiation.
Unless otherwise specified, "exposure" in the present specification encompasses not only exposure by a bright line spectrum of a mercury lamp, far ultraviolet rays typified by an excimer laser, extreme ultraviolet rays, X-rays, EUV, or the like, but also drawing by particle beams such as electron beams and ion beams.
In the present specification, a numerical range expressed using "to" is used in a meaning of a range that includes the preceding and succeeding numerical values of "to" as the lower limit value and the upper limit value, respectively.
A bonding direction of divalent groups cited in the present specification is not limited unless otherwise specified. For example, in a case where Y in a compound represented by Formula "X-Y-Z" is -COO-, Y may be -CO-O- or -O-CO-. In addition, the above-described compound may be "X-CO-O-Z" or "X-O-CO-Z".
In the present specification, (meth)acrylate represents acrylate and methacrylate, and (meth)acryl represents acryl and methacryl.

In the present specification, a weight-average molecular weight (Mw), a number-average molecular weight (Mn), and a dispersity (also referred to as a molecular weight distribution) (Mw/Mn) of a resin are defined as values expressed in terms of polystyrene by means of gel permeation chromatography (GPC) measurement (solvent: tetrahydrofuran, flow amount (amount of a sample injected): 10 μL, columns: TSK gel Multipore HXL-M manufactured by Tosoh Corporation, column temperature: 40°C, flow rate: 1.0 mL/min, and detector: differential refractive index detector) using a GPC apparatus (HLC-8120GPC manufactured by Tosoh Corporation).

In the present specification, a compositional ratio (molar ratio, mass ratio, or the like) of a resin is measured by $^{13}C$-nuclear magnetic resonance (NMR).

In the present specification, an acid dissociation constant (pKa) represents a pKa in an aqueous solution, and is specifically a value determined by computation from a value based on a Hammett's substituent constant and database of publicly known literature values, using the following software package 1. Any of the pKa values described in the present specification indicates values determined by computation using the software package.

Software Package 1: Advanced Chemistry Development (ACD/Labs) Software V 8.14 for Solaris (1994 - 2007 ACD/Labs).

On the other hand, the pKa can also be determined by a molecular orbital computation method. Examples of a specific method therefor include a method for performing calculation by computing $H^+$ dissociation free energy in an aqueous solution based on a thermodynamic cycle. With regard to a computation method for $H^+$ dissociation free energy, the $H^+$ dissociation free energy can be computed by, for example, density functional theory (DFT), but various other methods have been reported in literature and the like, and are not limited thereto. There are a plurality of software applications capable of performing DFT, and examples thereof include Gaussian 16.

As described above, the pKa in the present specification refers to a value determined by computation from a value based on a Hammett's substituent constant and database of publicly known literature values, using the software package 1, but in a case where the pKa cannot be calculated by the method, a value obtained by Gaussian 16 based on density functional theory (DFT) shall be adopted.

In addition, the pKa in the present specification refers to a "pKa in an aqueous solution" as described above, but in a case where the pKa in an aqueous solution cannot be calculated, a "pKa in a dimethyl sulfoxide (DMSO) solution" shall be adopted.

In the present specification, examples of the halogen atom include a fluorine atom, a chlorine atom, a bromine atom, and an iodine atom.

[Actinic Ray-Sensitive or Radiation-Sensitive Resin Composition (Resist Composition)]

The actinic ray-sensitive or radiation-sensitive resin composition according to the embodiment of the present invention contains a resin (A) having a repeating unit (a) that has a non-ionic group which generates an acid in a case of being decomposed by irradiation with an actinic ray or a radiation, and

a basic compound, a pKa of a conjugate acid of which is 13.00 or less,
in which a molecular weight of the repeating unit (a) after irradiation with an actinic ray or a radiation is 300 or less,
in a case where the actinic ray-sensitive or radiation-sensitive resin composition does not contain a compound which generates an acid by irradiation with an actinic ray or a radiation, a molar amount of the repeating unit (a) is 0.50 mmol/g or more with respect to a total solid content of the actinic ray-sensitive or radiation-sensitive resin composition, and
in a case where the actinic ray-sensitive or radiation-sensitive resin composition contains the compound which generates an acid by irradiation with an actinic ray or a radiation, a total molar amount of the repeating unit (a) and the compound (which generates an acid by irradiation with an actinic ray or a radiation) is 0.50 mmol/g or more with respect to the total solid content of the actinic ray-sensitive or radiation-sensitive resin composition.

Hereinafter, the actinic ray-sensitive or radiation-sensitive resin composition will also be referred to as "resist composition".

A working mechanism by which the objects of the present invention can be achieved by adopting such configurations is not always clear, but is presumed to be as follows by the present inventors.

The resist composition according to the embodiment of the present invention includes a moiety (acid generation moiety) having a function of generating an acid in a case of being decomposed by irradiation with an actinic ray or a radiation in an amount of 0.50 mmol/g or more with respect to the total solid content. This increases acid generation contrast in a case where a resist film formed of the resist film is exposed, and contributes to improvement of LWR of a pattern to be formed. In the resist composition according to the embodiment of the present invention, since a part or all of the acid generation moiety is carried on the resin, plasticization of the resist film can be suppressed, and good exposure latitude (EL) can be maintained. In addition, since the above-described acid generation moiety carried on the resin is

non-ionic, it is possible to suppress occurrence of aggregation of the acid generation moiety in the film. It is considered that the LWR of the pattern to be formed is improved by synergistic action of these characteristics.

In addition, since the resist composition according to the embodiment of the present invention contains, as a basic compound, a weakly basic compound, a pKa of a conjugate acid of which is 13.00 or less, decomposition of the acid generation moiety is suppressed. In addition, a molecular weight of the repeating unit after the non-ionic acid generation moiety carried on the resin is decomposed by exposure is as small as 300 or less, and the above-described acid generation moiety is located near a main chain of the resin, reaction between the above-described acid generation moiety and the basic compound is sterically inhibited. It is considered that temporal stability of the resist composition is also improved by synergistic action of these characteristics.

Hereinafter, the fact that the resist composition according to the embodiment of the present invention is more excellent in at least one of temporal stability or LWR suppression property of the pattern to be formed is also referred to that the effect of the present invention is more excellent.

Hereinafter, the resist composition according to the embodiment of the present invention will be described in detail.

The resist composition according to the embodiment of the present invention may be a positive tone resist composition (resist composition for forming a positive tone pattern) or a negative tone resist composition (resist composition for forming a negative tone pattern). In addition, the resist composition according to the embodiment of the present invention may be either a resist composition for alkali development or a resist composition for organic solvent development.

Among these, the resist composition according to the embodiment of the present invention is preferably a positive tone resist composition. In addition, the resist composition according to the embodiment of the present invention is preferably a resist composition for alkali development.

Although the resist composition according to the embodiment of the present invention has characteristics as a non-chemically amplified resist composition, a mechanism as a chemically amplified resist composition may be used in combination with the resist composition according to the embodiment of the present invention.

Hereinafter, first, various components of the resist composition will be described in detail.

[Resin (A)]

The resist composition contains a resin (A).

The resin (A) has a repeating unit (a) which is a non-ionic group generating an acid in a case where a leaving group is eliminated by irradiation with actinic ray or radiation.

In the repeating unit (a), the above-described acid is usually generated by forming an acidic group on the main chain side of the resin. In addition, the above-described acid may be generated by eliminating a leaving group to be the acid.

That is, the resin (A) usually has a repeating unit having a group which is decomposed by exposure to generate an acidic group. Therefore, the resin (A) usually has an increased polarity by the exposure, an increased solubility in an alkali developer, and a decreased solubility in an organic solvent.

That is, in the pattern forming method according to the embodiment of the present invention, typically, in a case where an alkali developer is adopted as a developer, a positive tone pattern is suitably formed, and in a case where an organic developer is adopted as a developer, a negative tone pattern is suitably formed.

In addition, the resin (A) is also preferably a resin in which solubility in the alkali developer is improved by action of acid. For example, in a case where the resin (A) has a repeating unit having an acid-decomposable group, the resin (A) can have a property of improving solubility in the alkali developer by action of acid.

The repeating unit having an acid-decomposable group will be described later.

<Repeating Unit a1>

The resin (A) has the repeating unit (a).

The repeating unit (a) is a repeating unit having a non-ionic group (hereinafter, also referred to as "specific functional group") generating an acid in a case where a leaving group is eliminated by irradiation with actinic ray or radiation.

Examples of the acid generated from the specific functional group include sulfonic acid, sulfonimide, carboxylic acid, and phosphonic acid, and sulfonic acid is preferable.

In the specific functional group, the above-described acid is usually generated by forming an acidic group on the main chain side of the resin.

That is, the specific functional group is usually a group which is decomposed by irradiation with actinic ray or radiation to generate an acidic group (sulfonic acid group, sulfonimide group, carboxylic acid group, phosphonic acid

group, or the like) on the main chain side of the resin (A), and it is preferably a group which generates a sulfonic acid group on the main chain side of the resin (A).

The specific functional group is preferably a group represented by any one of General Formulae (a1) to (a6), more preferably a group represented by any one of General Formulae (a1) to (a3), and still more preferably a group represented by General Formula (a3).

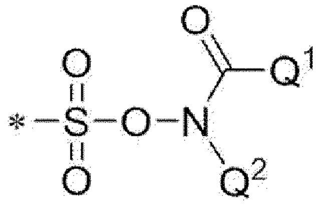
(a1)

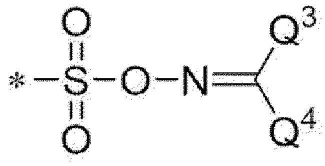
(a2)

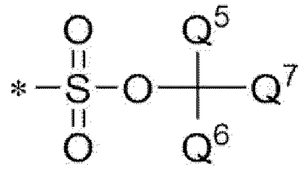
(a3)

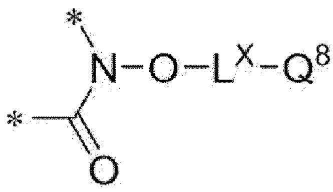
(a4)

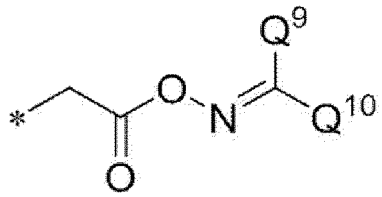
(a5)

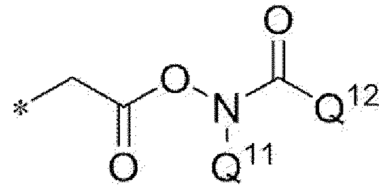
(a6)

In General Formula (a1), * represents a bonding position.

In General Formula (a1), $Q^1$ and $Q^2$ each independently represent an organic group.

Examples of the above-described organic group include a cyano group, an alkyl group, an alkoxy group, an alkoxycarbonyl group, an alkenyl group, a cycloalkyl group, and an aromatic ring group.

The above-described alkyl group may be linear or branched, and the number of carbon atoms therein is preferably 1 to 5. Examples of the above-described alkyl group include a methyl group, an ethyl group, an n-propyl group, an isopropyl group, an n-butyl group, an isobutyl group, and a t-butyl group.

Examples of an alkyl group moiety in the above-descried alkoxy group and the above-described alkoxycarbonyl group include the same groups as those in the above-described alkyl group.

The above-described alkenyl group may be linear or branched, and the number of carbon atoms therein is preferably 1 to 5. Examples of the above-described alkenyl group include a vinyl group.

The above-described cycloalkyl group preferably has 3 to 15 ring member atoms. As the above-described cycloalkyl, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable. In the above-described cycloalkyl group, for example, one or more (for example, one to three) of methylene groups constituting the ring may be replaced with a heteroatom (-O-, -S-, or the like), $-SO_2-$, $-SO_3-$, an ester group, a carbonyl group, or a vinylidene group. In addition, in the cycloalkyl group, one or more (for example, one or two) of ethylene groups constituting the cycloalkane ring may be replaced with a vinylene group.

An aromatic ring (benzene ring or the like) may be fused to the above-described cycloalkyl group.

The above-described aromatic ring group may be monocyclic or polycyclic, and the number of ring member atoms therein is preferably 5 to 15. The above-described aromatic ring group may have one or more (for example, one to five) heteroatoms (oxygen atom, sulfur atom, nitrogen atom, and/or the like) as the ring member atom. Examples of the above-described aromatic ring group include a benzene ring group, a naphthalene ring group, an anthracene ring group, a thiazole ring group, and a benzothiazole ring group.

Examples of the substituent which may be included in the above-described alkyl group, the above-described alkoxy group, the above-described alkoxycarbonyl group, and the above-described alkenyl group include a halogen atom (a fluorine atom or the like), a hydroxyl group, a nitro group, a cyano group, a cycloalkyl group, and an aromatic ring group. For example, the above-described alkyl group may have a fluorine atom as the substituent and may be a perfluoroalkyl group. Examples of the cycloalkyl group and the aromatic ring group as the substituent include the above-described cycloalkyl group and the above-described aromatic ring group, which can be adopted as the organic group.

Examples of the substituent which can be included in the above-described cycloalkyl group and the above-described aromatic ring group include a halogen atom, a hydroxyl group, a nitro group, a cyano group, an alkyl group, an alkoxy group, an alkoxycarbonyl group, an alkenyl group, an aromatic ring group (which may be monocyclic or polycyclic, and the number of ring member atoms is, for example, 5 to 15), and a cycloalkyl group (which may be monocyclic or polycyclic, and the number of ring member atoms is, for example, 3 to 15). Examples of the alkyl group, the alkoxy group, the alkoxycarbonyl group, and the alkenyl group as the substituent include the above-described alkyl group, the above-described alkoxy group, the above-described alkoxycarbonyl group, and the above-described alkenyl group, which can be adopted as the organic group. The alkyl group, the alkoxy group, the alkoxycarbonyl group, and the alkenyl group as the substituent may further have a substituent as described above.

In addition, the organic group represented by $Q^1$ and $Q^2$ is also preferably a group represented by "-CO-organic group". Examples of the "organic group" in the "-CO-organic group" above include the same organic group already described as an example of the organic group represented by $Q^1$ and $Q^2$.

$Q^1$ and $Q^2$ may be bonded to each other to form a ring.

The ring formed by bonding $Q^1$ and $Q^2$ to each other may be monocyclic or polycyclic. The number of ring member atoms in the above-described ring is preferably 4 to 15.

In a case where $Q^1$ and $Q^2$ are bonded to each other to form a ring, it is preferable that $Q^1$ and $Q^2$ are bonded to each other to form a group represented by General Formula (aLC).

$$*^{V}\text{-}L^{C1}\text{-}L^{L1}\text{-}L^{A1}\text{-}L^{A2}\text{-}L^{L2}\text{-}L^{C2}\text{-}*^{W} \qquad \text{(aLC)}$$

In General Formula (aLC), $*^V$ represents a bonding position on the $Q^1$ side. In other words, $*^V$ is a bonding position with -CO- specified in General Formula (a1).

In General Formula (aLC), $*^W$ represents a bonding position on the $Q^2$ side. In other words, $*^W$ is a bonding position with the nitrogen atom specified in General Formula (a1).

In General Formula (aLC), $L^{C1}$ and $L^{C2}$ each independently represent a single bond, -CO-, or $-SO_2-$.

In General Formula (aLC), $L^{L1}$ and $L^{L2}$ each independently represent a single bond or an alkylene group.

The above-described alkylene group may be linear or branched, and the number of carbon atoms therein is preferably 1 to 15.

One or more (for example, one to three) of methylene groups constituting the above-described alkylene group may be replaced with a heteroatom (-O-, -S-, or the like), $-SO_2-$, $-SO_3-$, an ester group, a carbonyl group, or a vinylidene group. The above-described vinylidene group may have a substituent, and examples of the substituent included in the above-described vinylidene group include an organic group. Examples of the organic group which can be included in the above-described vinylidene group include the same organic group described as the organic group represented by $Q^1$.

In addition, one or more (for example, one or two) of ethylene groups of the above-described alkylene group may be replaced with a vinylene group or $-CR^N=N-$ ($R^N$ is a hydrogen atom or a substituent such as an alkyl group).

The above-described alkylene group may be, for example, "-alkylene group in which methylene group or the like is not replaced-", "-alkylene group in which methylene group or the like is not replaced-O-", "-S-vinylene group-vinylidene group-", or "-vinylene group-".

The fact that the alkylene group in which a methylene group or the like is not replaced means a linear or branched alkylene group, in which the methylene group constituting the alkylene group is not replaced with a heteroatom or the like and the ethylene group constituting the alkylene group is not replaced with a vinylene group. The number of carbon atoms in the alkylene group in which a methylene group or the like is preferably 1 to 8.

In General Formula (aLC), $L^{A1}$ and $L^{A2}$ each independently represent a single bond, an aromatic ring group, or a cycloalkylene group.

The above-described aromatic ring group may be monocyclic or polycyclic, and the number of ring member atoms therein is preferably 5 to 15. The above-described aromatic ring group may have one or more (for example, one to five) heteroatoms (oxygen atom, sulfur atom, nitrogen atom, and/or the like) as the ring member atom. Examples of the above-described aromatic ring group include a benzene ring group (benzene-1,2-diyl group or the like), a naphthalene ring group (naphthalene-1,2-diyl or the like), an anthracene ring group, a thiazole ring group, and a benzothiazole ring group.

The above-described cycloalkylene group may be monocyclic or polycyclic, and the number of ring member atoms therein is preferably 5 to 15. One or more (for example, one to three) of methylene groups constituting the above-described cycloalkylene group may be replaced with a heteroatom (-O-, -S-, or the like), $-SO_2-$, $-SO_3-$, an ester group, a carbonyl group, or a vinylidene group. The above-described vinylidene group may have a substituent, and examples of the substituent included in the above-described vinylidene group include an organic group. Examples of the organic group which can be included in the above-described vinylidene group include the same organic group described as the organic group represented by $Q^1$.

In addition, one or more (for example, one or two) of ethylene groups of the above-described cycloalkylene group may be replaced with a vinylene group or $-CR^N=N-$ ($R^N$ is a hydrogen atom or a substituent such as an alkyl group).

In General Formula (aLC), at least one of $L^{C1}$, $L^{L1}$, $L^{A1}$, $L^{A2}$, $L^{L2}$, or $L^{C2}$ is not a single bond, and it is preferable that at least one of $L^{L1}$, $L^{A1}$, $L^{A2}$, or $L^{L2}$ is not a single bond. In addition, in a case where both $L^{A1}$ and $L^{A2}$ are a single bond, it is also preferable that $L^{L2}$ is a single bond.

The total number of atoms other than a hydrogen atom in the group represented by General Formula (aLC) is preferably 3 to 100 and more preferably 4 to 20.

With regard to General Formula (a1), it is preferable that, in the group formed by bonding $Q^1$ and $Q^2$ to each other, represented by General Formula (aLC), $L^{C1}$ is a single bond, $L^{L1}$ is a single bond, $L^{A1}$ is an aromatic ring group, $L^{A2}$ is a single bond, $L^{L2}$ is a single bond, and $L^{C2}$ is -CO-.

In General Formula (a2), * represents a bonding position.

In General Formula (a2), $Q^3$ and $Q^4$ each independently represent an organic group.

Examples of the organic group represented by $Q^3$ and $Q^4$ in General Formula (a2) include the same organic group described as the organic group represented by $Q^1$ and $Q^2$ in General Formula (a1).

$Q^3$ and $Q^4$ may be bonded to each other to form a ring.

The ring formed by bonding $Q^3$ and $Q^4$ to each other may be monocyclic or polycyclic. The number of ring member atoms in the above-described ring is preferably 4 to 15.

In a case where $Q^3$ and $Q^4$ are bonded to each other to form a ring, it is preferable that $Q^3$ and $Q^4$ are bonded to each other to form the group represented by General Formula (aLC) described above.

However, in General Formula (aLC) in this case, $*^V$ is a bonding position on the $Q^3$ side, and $*^W$ is a bonding position on the $Q^4$ side.

With regard to General Formula (a2), it is preferable that, in the group formed by bonding $Q^3$ and $Q^4$ to each other, represented by General Formula (aLC), $L^{C1}$ is a single bond, $L^{L1}$ is an alkylene group, $L^{A1}$ is a single bond or an aromatic ring group, $L^{A2}$ is a single bond, $L^{L2}$ is a single bond, and $L^{C2}$ is a single bond.

In General Formula (a3), * represents a bonding position.

In General Formula (a3), $Q^5$ to $Q^7$ each independently represent a hydrogen atom or an organic group.

However, at least one (one to three) of $Q^5$ to $Q^7$ represents an organic group.

Examples of the organic group represented by $Q^5$ to $Q^7$ in General Formula (a3) include the same organic group described as the organic group represented by $Q^1$ and $Q^2$ in General Formula (a1).

Among these, it is preferable that $Q^7$ is an organic group.

In addition, in at least one (one to three) of $Q^5$ to $Q^7$, it is preferable that an atom directly bonded to a central carbon atom is an sp2-hybrid orbit carbon atom (a carbon atom having a double bond).

The "central carbon atom" means a carbon atom in Formula (a3), which is bonded to an oxygen atom of -SOz-O- specified in Formula (a3).

Examples of the sp2-hybrid orbit carbon atom include a carbon atom having a double bond, which constitutes a vinyl group, a vinylene group, a vinylidene group, an aromatic ring group (aryl group and the like), a formyl group, a carboxy group, or a carbonyl group.

$Q^5$ to $Q^7$ in a case where the atom directly bonded to the central carbon atom is an sp2-hybrid orbit carbon atom are preferably a formyl group, an acyl group (for example, having 2 to 15 carbon atoms), an alkoxycarbonyl group (for example, having 2 to 15 carbon atoms), a carboxy group, a vinyl group, or an aryl group (which may be monocyclic or polycyclic; for example, having 6 to 15 carbon atoms).

Two selected from $Q^5$ to $Q^7$ may be bonded to each other to form a ring.

The ring formed by bonding two selected from $Q^5$ to $Q^7$ to each other may be monocyclic or polycyclic. The number of ring member atoms in the above-described ring is preferably 4 to 15.

In a case where two selected from $Q^5$ to $Q^7$ are bonded to each other to form a ring, it is preferable that two selected from $Q^5$ to $Q^7$ are bonded to each other to form the group represented by General Formula (aLC) described above.

However, in General Formula (aLC) in this case, $*^V$ is a bonding position on one side of two selected from $Q^5$ to $Q^7$ bonded to each other, and $*^W$ is a bonding position on the other side of the two selected from $Q^5$ to $Q^7$ bonded to each other.

With regard to General Formula (a3), it is preferable that, in the group formed by bonding two selected from $Q^5$ to $Q^7$ to each other, represented by General Formula (aLC), $L^{C1}$ is a single bond, $L^{L1}$ is an alkylene group, $L^{A1}$ is a single bond, $L^{A2}$ is a single bond, $L^{L2}$ is a single bond, and $L^{C2}$ is a single bond.

Even in a case where two selected from $Q^5$ to $Q^7$ are bonded to each other to form a ring, it is preferable that at least one (for example, one to three) of the above-described sp2-hybrid orbit carbon atoms (carbon atoms having a double bond) are directly bonded to the above-described central carbon atom in General Formula (a3).

In addition, it is also preferable that the group represented by General Formula (a3) constitutes an acid-decomposable group obtained by protecting a sulfonic acid group as a polar group with "$-C(Q^5)(Q^6)(Q^7)$" as a protective group.

In General Formula (a4), * represents a bonding position.

It is preferable that two *'s (bonding positions) in General Formula (a4) are each independently a bonding position to the main chain side of the resin (A).

In General Formula (a4), $Q^8$ represents an organic group.

Examples of the organic group represented by $Q^8$ in General Formula (a4) include the same organic group described as the organic group represented by $Q^1$ and $Q^2$ in General Formula (a1).

In General Formula (a4), $L^X$ represents -CO- or -SOz-.

In General Formula (a5), * represents a bonding position.

In General Formula (a5), $Q^9$ and $Q^{10}$ each independently represent an organic group.

Examples of the organic group represented by $Q^9$ and $Q^{10}$ in General Formula (a5) include the same organic group described as the organic group represented by $Q^1$ and $Q^2$ in General Formula (a1).

$Q^9$ and $Q^{10}$ may be bonded to each other to form a ring.

The ring formed by bonding $Q^9$ and $Q^{10}$ to each other may be monocyclic or polycyclic. The number of ring member atoms in the above-described ring is preferably 4 to 15.

In a case where $Q^9$ and $Q^{10}$ are bonded to each other to form a ring, it is preferable that $Q^9$ and $Q^{10}$ are bonded to each other to form the group represented by General Formula (aLC) described above.

However, in General Formula (aLC) in this case, $*^V$ is a bonding position on the $Q^9$ side, and $*^W$ is a bonding position on the $Q^{10}$ side.

With regard to General Formula (a5), it is preferable that, in the group formed by bonding $Q^9$ and $Q^{10}$ to each other, represented by General Formula (aLC), $L^{C1}$ is a single bond, $L^{L1}$ is an alkylene group, $L^{A1}$ is a single bond or an aromatic ring group, $L^{A2}$ is a single bond or an aromatic ring group, $L^{L2}$ is a single bond, and $L^{C2}$ is a single bond.

In General Formula (a6), * represents a bonding position.

In General Formula (a6), $Q^{11}$ and $Q^{12}$ each independently represent an organic group.

Examples of the organic group represented by $Q^{11}$ and $Q^{12}$ in General Formula (a6) include the same organic group described as the organic group represented by $Q^1$ and $Q^2$ in General Formula (a1).

$Q^{11}$ and $Q^{12}$ may be bonded to each other to form a ring.

The ring formed by bonding $Q^{11}$ and $Q^{12}$ to each other may be monocyclic or polycyclic. The number of ring member atoms in the above-described ring is preferably 4 to 15.

In a case where $Q^{11}$ and $Q^{12}$ are bonded to each other to form a ring, it is preferable that $Q^{11}$ and $Q^{12}$ are bonded to each other to form the group represented by General Formula (aLC) described above.

However, in General Formula (aLC) in this case, $*^v$ is a bonding position on the $Q^{11}$ side, and $*^W$ is a bonding position on the $Q^{12}$ side.

With regard to General Formula (a6), it is preferable that, in the group formed by bonding $Q^{11}$ and $Q^{12}$ to each other, represented by General Formula (aLC), $L^{C1}$ is -CO-, $L^{L1}$ is a single bond, $L^{A1}$ is an aromatic ring group, $L^{A2}$ is a single bond, $L^{L2}$ is a single bond, and $L^{C2}$ is a single bond.

In addition, examples of the specific functional group include a group represented by "$-SO_2-SO_2-$organic group", a group represented by "$-SO_2-C(=N_2)-SO_2-$organic group", a group represented by "$-SO_2-O-SO_2-$organic group", a group represented by "$-SO_2-O-C(=N_2)-SO_2-$organic group", and a group represented by "$-SO_2$-O-O-organic group".

Examples of the organic group in the above-described "$-SO_2-SO_2-$organic group", "$-SO_2-C(=N_2)-SO_2-$organic group", "$-SO_2-O-SO_2-$organic group", "$-SO_2-O-C(=N_2)-SO_2-$organic group", and "$-SO_2-O-O-$organic group" include the same organic group described as the organic group represented by $Q^1$ and $Q^2$ in General Formula (a1) described above.

It is sufficient that the repeating unit (a) has at least one specific functional group, and the repeating unit (a) may have two or more (for example, two to four) specific functional groups. In a case where the repeating unit (a) has two or more specific functional groups, the two or more specific functional groups may have the same structure or different structures from each other. In addition, each of the two or more specific functional groups may be a specific functional group represented by the same general formula, or a specific functional group represented by different general formulae.

The repeating unit (a) is preferably a repeating unit represented by General Formula (1).

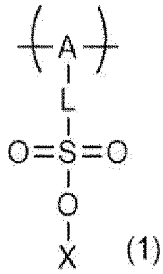

(1)

In General Formula (1), A represents a group constituting a main chain of a resin.

A is preferably a group represented by any of General Formulae (a-1) to (a-6).

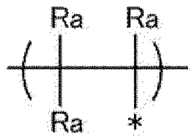

(a-1)

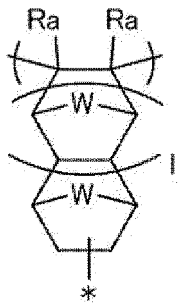

(a-2)

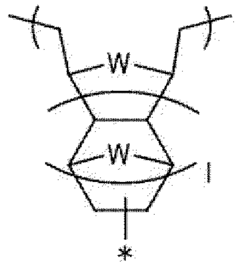

(a-3)

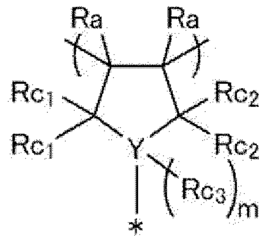

(a-4)

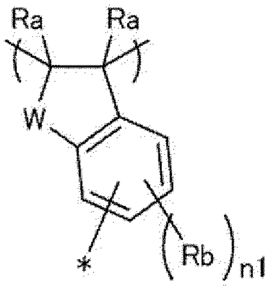

(a-5)

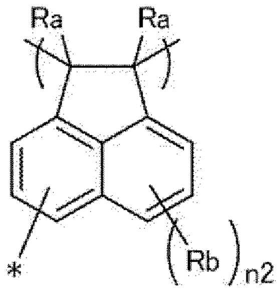

(a-6)

In General Formulae (a-1) to (a-6), Ra's each independently represent a hydrogen atom, an alkyl group, or $-CH_2-O-Ra_2$. $Ra_2$ represents a hydrogen atom, an alkyl group, or an acyl group. In a case where a plurality of Ra's are present in the same general formula, two Ra's may be bonded to each other to form a ring. The above-described alkyl group may be linear or branched, and the number of carbon atoms therein is preferably 1 to 6.

W's each independently represents a methylene group, an oxygen atom, or a sulfur atom.

$Rc_1$ and $Rc_2$ each independently represent a hydrogen atom, an alkyl group, or an alkoxy group. In addition, two $Rc_1$'s or $Rc_2$'s bonded to the same carbon atom may jointly form one oxygen atom. That is, $-C(Rc_1)_2-$ or $-C(Rc_2)_2-$ may be -CO-.

Y represents a nitrogen atom or a carbon atom. In a case where Y is a nitrogen atom, m is 0, and in a case where Y is a carbon atom, m is 1.

$Rc_3$ represents a hydrogen atom or a substituent.

Rb's each independently represent an organic group.

n1 represents an integer of 0 to 3.
n2 represents an integer of 0 to 5.
l represents 0 or 1.
* represents a bonding position to L.

In addition, it is also preferable that A in General Formula (1) is a group consisting of only atoms selected from the group consisting of a hydrogen atom and a carbon atom.

In General Formula (1), L represents a single bond or a divalent linking group.

The above-described divalent linking group is preferably an alkylene group, a phenylene group, -CO-, -O-, -S-, -NRd-, or a group consisting of a combination of these groups. Rd represents a hydrogen atom or an alkyl group (for example, having 1 to 6 carbon atoms).

The above-described alkylene group may be linear or branched, and the number of carbon atoms therein is, for example, 1 to 6. As a substituent which may be included in the above-described alkylene group and the above-described phenylene group, a halogen atom (a fluorine atom or the like) is preferable.

Examples of the "group consisting of a combination of these groups" include -CO-O-, -CO-O-alkylene group-, -CO-O-phenylene group-, -CO-NRd-, -CO-NRd-alkylene group-, and -CO-NRd-phenylene group-.

In addition, it is also preferable that L in General Formula (1) is a single bond or a group consisting of only atoms selected from the group consisting of a hydrogen atom and a carbon atom.

In General Formula (1), X represents a group which is eliminated by action of radiation or actinic ray.

X is preferably the group represented by $-NQ^2-CO-Q^1$ in General Formula (a1) described above, the group represented by $-N=CQ^3Q^4$ in General Formula (a2) described above, or the group represented by $-CQ^5Q^6Q^7$ in General Formula (a3) described above.

That is, it is preferable that $-SO_2-O-X$ in General Formula (1) is the group represented by any of General Formulae (a1) to (a3) described above.

The repeating unit (a) is more preferably a repeating unit represented by General Formula (1-2).

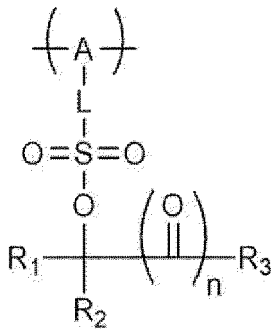

(1-2)

In General Formula (1-2), A represents a group constituting a main chain of a resin.

A in General Formula (1-2) has the same meaning as that described with respect to A in General Formula (1), and a preferred aspect thereof is also the same.

In General Formula (1-2), L represents a single bond or a divalent linking group.

L in General Formula (1-2) has the same meaning as that described with respect to L in General Formula (1), and a preferred aspect thereof is also the same.

In General Formula (1-2), $R_1$ and $R_2$ each independently represent a hydrogen atom or an organic group.

In General Formula (1-2), $R_3$ represents an organic group.

Examples of the organic group represented by $R_1$ to $R_3$ include the same organic group described as the organic group represented by $Q^1$ and $Q^2$ in General Formula (a1) described above.

In General Formula (1-2), two of $R_1$ to $R_3$ (for example, $R_1$ and $R_2$, or $R_1$ and $R_3$) may be bonded to each other to form a ring.

The ring formed by bonding two selected from $R_1$ to $R_3$ to each other may be monocyclic or polycyclic. The number of ring member atoms in the above-described ring is preferably 4 to 15.

In a case where two selected from $R_1$ to $R_3$ are bonded to each other to form a ring, it is preferable that two selected from $R_1$ to $R_3$ are bonded to each other to form the group represented by General Formula (aLC) described above.

However, in General Formula (aLC) in this case, $*^V$ is a bonding position on one side of two selected from $R_1$ to $R_3$ bonded to each other, and $*^W$ is a bonding position on the other side of the two selected from $R_1$ to $R_3$ bonded to each other.

In addition, it is preferable that at least one (for example, one to three) of sp2-hybrid orbit carbon atoms (carbon atoms having a double bond) are directly bonded to a central carbon atom in General Formula (1-2).

The "central carbon atom" in General Formula (1-2) means a carbon atom in Formula (1-2), which is bonded to an oxygen atom of $-SO_2-O-$ specified in Formula (1-2).

Examples of the sp2-hybrid orbit carbon atom include a carbon atom having a double bond, which constitutes a vinyl group, a vinylene group, a vinylidene group, an aromatic ring group (aryl group and the like), a formyl group, a carboxy group, or a carbonyl group.

For example, in a case where n is 0, at least one (one to three) of $R_1$ to $R_3$ is preferably a formyl group, an acyl group (for example, having 2 to 15 carbon atoms), an alkoxycarbonyl group (for example, having 2 to 15 carbon atoms), a carboxy group, a vinyl group, or an aryl group (which may be monocyclic or polycyclic; for example, having 6 to 15 carbon atoms).

In General Formula (1-2), n represents 0 or 1.

A pKa of the acid generated by the elimination of the leaving group by the irradiation of the repeating unit (a) with actinic ray or radiation is preferably -4.00 or more, more preferably -1.50 or more, and particularly preferably -1.00 or more. The pKa is preferably 3.00 or less, and more preferably 2.00 or less.

In a case where the resin (A) has two or more kinds of repeating units (a), a content of a repeating unit (a) among all repeating units (a), in which the pKa of the acid generated by the elimination of the leaving group by the irradiation with actinic ray or radiation is within the above-described range, is preferably 10% to 100% by mole, more preferably 30% to 100% by mole, and still more preferably more than 50% by mole and 100% by mole or less.

The above-described two or more kinds of repeating units (a) may be included in the same resin (A), or may be included in different resins (A), respectively.

The pKa of the acid generated by the irradiation of the repeating unit with actinic ray or radiation is obtained as follows.

That is, first, for a repeating unit after the leaving group is eliminated from the repeating unit (a), a molecule that the repeating unit is bonded to a methyl group instead of being bonded to another repeating unit is assumed. A pKa of the above-described molecule assumed in this way is defined as the pKa of the acid generated from the repeating unit (a).

Specifically, for example, in a case where a repeating unit after elimination of a leaving group from a certain repeating unit (a) is a repeating unit represented by General Formula (X0), a pKa of a molecule represented by General Formula (X1) is obtained, and the obtained value of pKa is defined as the pKa of the acid generated by irradiation of the repeating unit (a) with actinic ray or radiation.

Similarly, for example, in a case where a repeating unit after elimination of a leaving group from a certain repeating unit (a) is a repeating unit represented by General Formula (Y0), a pKa of a molecule represented by General Formula (Y1) is obtained, and the obtained value of pKa is defined as the pKa of the acid generated by irradiation of the repeating unit (a) with actinic ray or radiation.

Similarly, for example, in a case where a repeating unit after elimination of a leaving group from a certain repeating unit (a) is a repeating unit represented by General Formula (Z0), a pKa of a molecule represented by General Formula (Z1) is obtained, and the obtained value of pKa is defined as the pKa of the acid generated by irradiation of the repeating unit (a) with actinic ray or radiation.

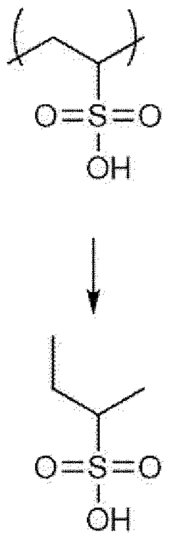

(X0)

(X1)

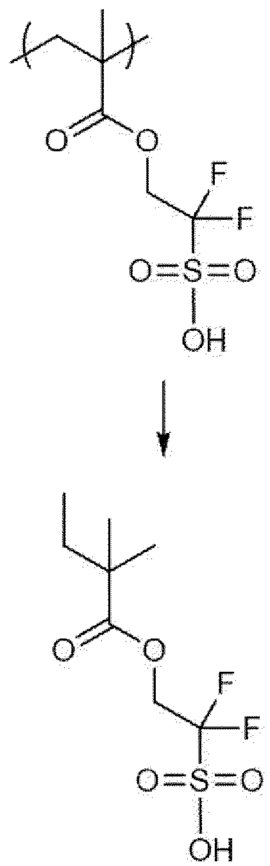

(Y0)

(Y1)

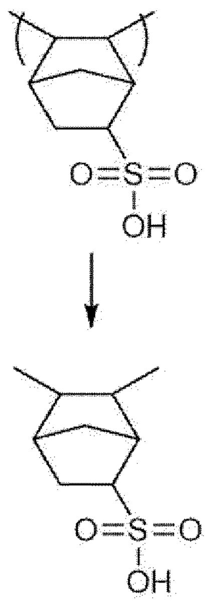

(Z0)

(Z1)

A molecular weight of a repeating unit obtained by replacing the leaving group of the repeating unit (a) with a hydrogen atom is 300 or less, preferably 200 or less. The lower limit of the above-described molecular weight is preferably 72 or more and more preferably 100 or more. The molecular weight of the repeating unit can also be rephrased as a formula weight of the repeating unit.

For example, in a case where the repeating unit (a) has a group represented by any of General Formulae (a1) to (a3) as the specific functional group, a repeating unit in which the specific functional group is changed to $-SO_3H$ corresponds to the "repeating unit obtained by replacing the leaving group of the repeating unit (a) with a hydrogen atom" in the repeating unit (a).

In a case where the resin (A) has two or more kinds of repeating units (a), a content of a repeating unit (a) among all repeating units (a), in which the molecular weight of the repeating unit obtained by replacing the leaving group of the repeating unit (a) with a hydrogen atom is within the above-described range, is preferably 10% to 100% by mole, more preferably 30% to 100% by mole, and still more preferably more than 50% by mole and 100% by mole or less.

The above-described two or more kinds of repeating units (a) may be included in the same resin (A), or may be included in different resins (A), respectively.

The repeating unit (a) is exemplified below.

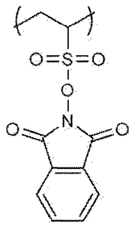
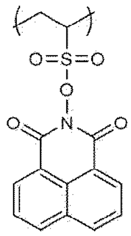
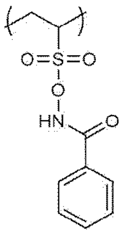
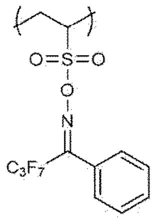
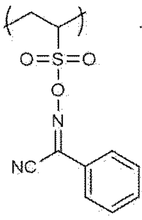
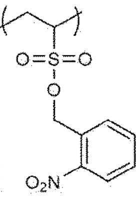

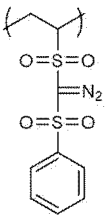
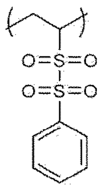
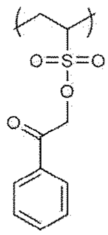
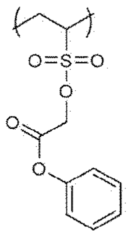
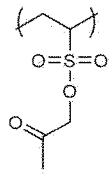
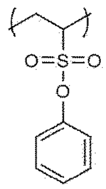

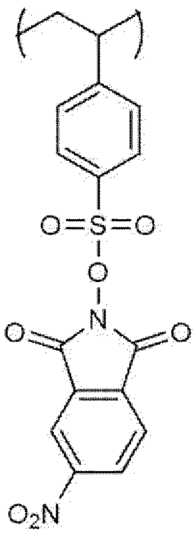
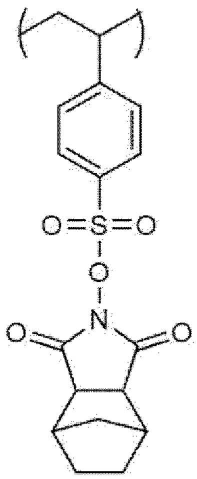
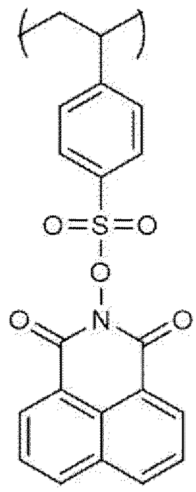
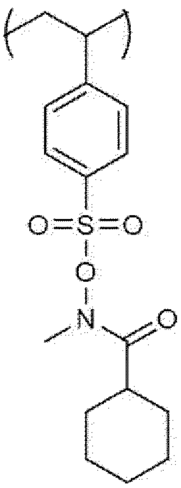
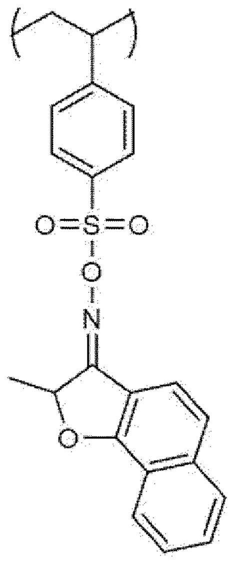

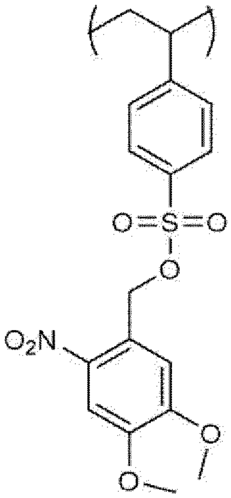 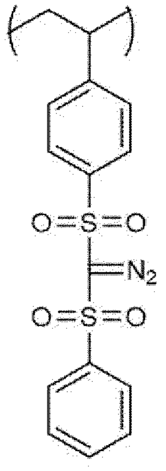 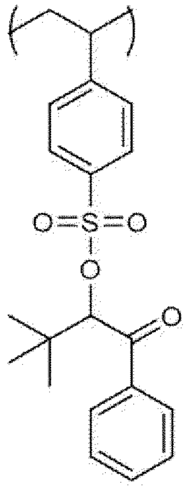 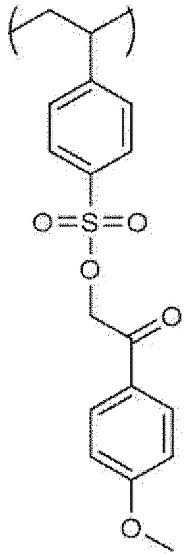 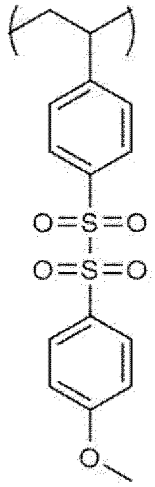

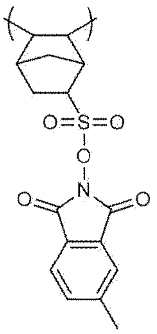 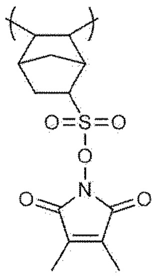 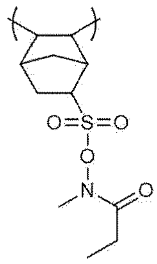 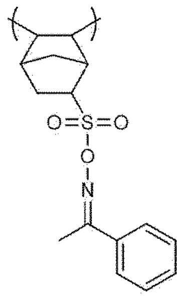 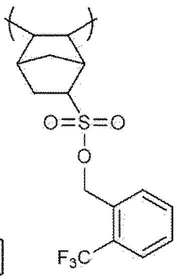

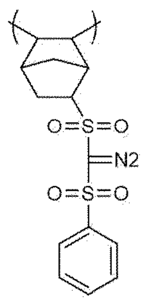 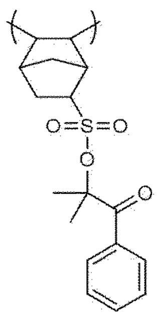 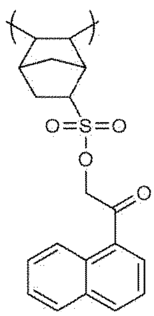 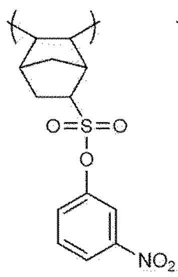 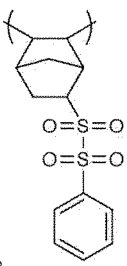

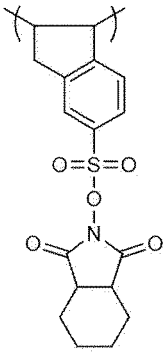 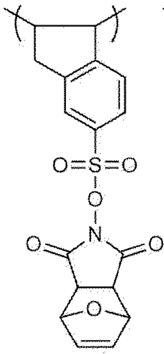 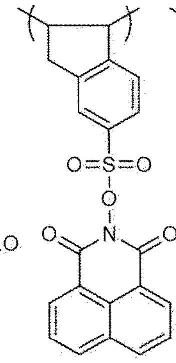 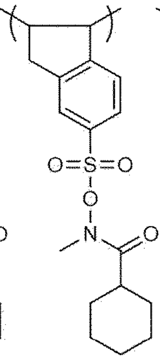 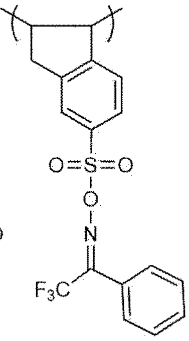

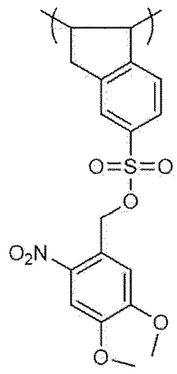
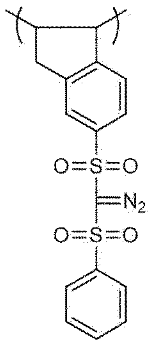
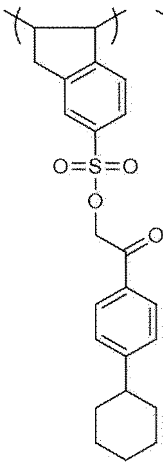
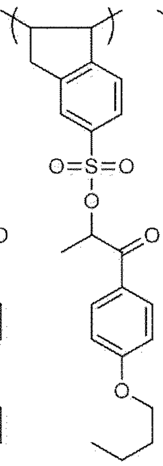
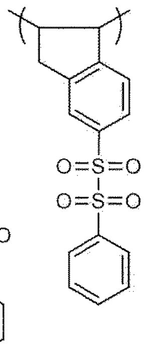

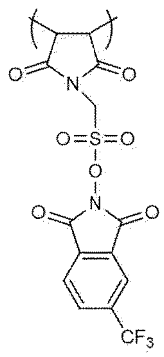
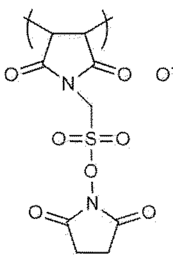
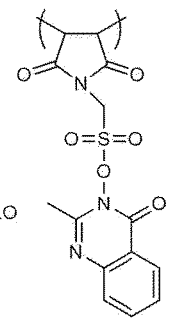
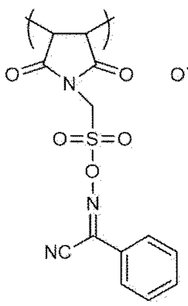
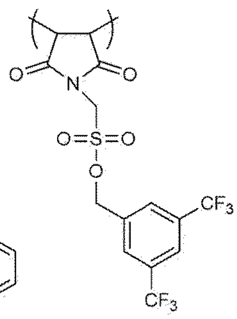

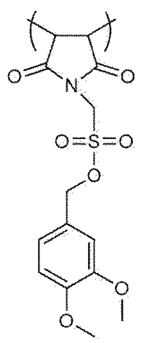
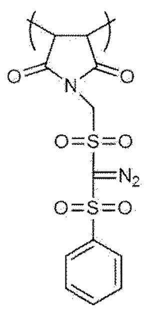
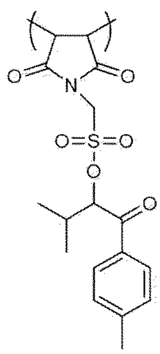
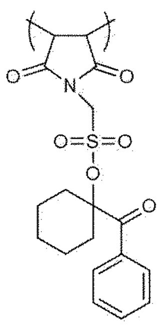
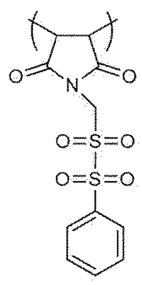

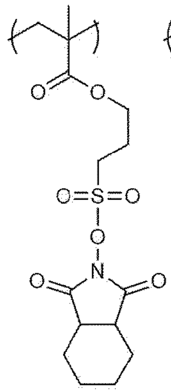
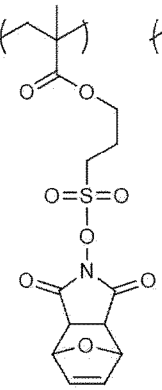
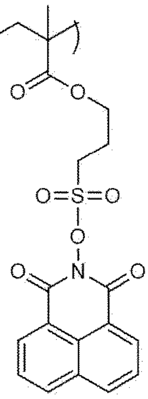
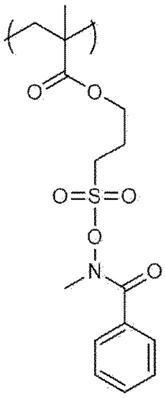
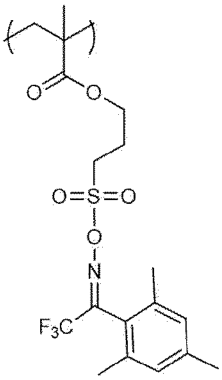

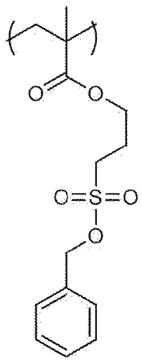
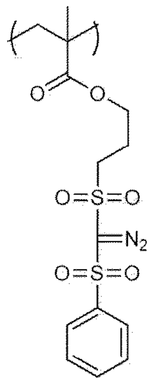
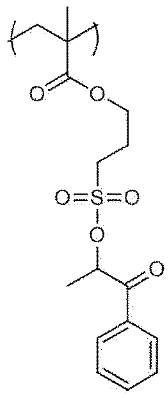
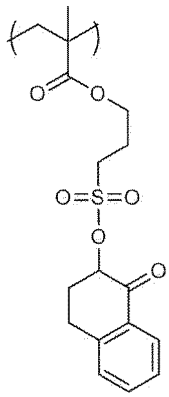
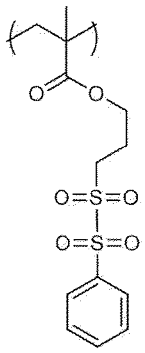

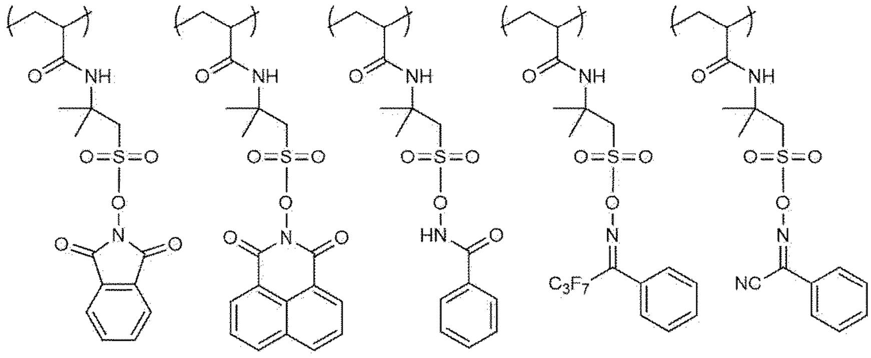

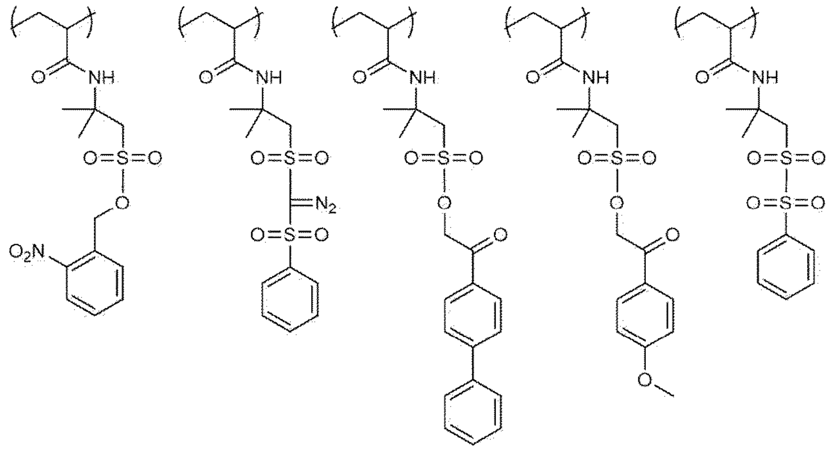

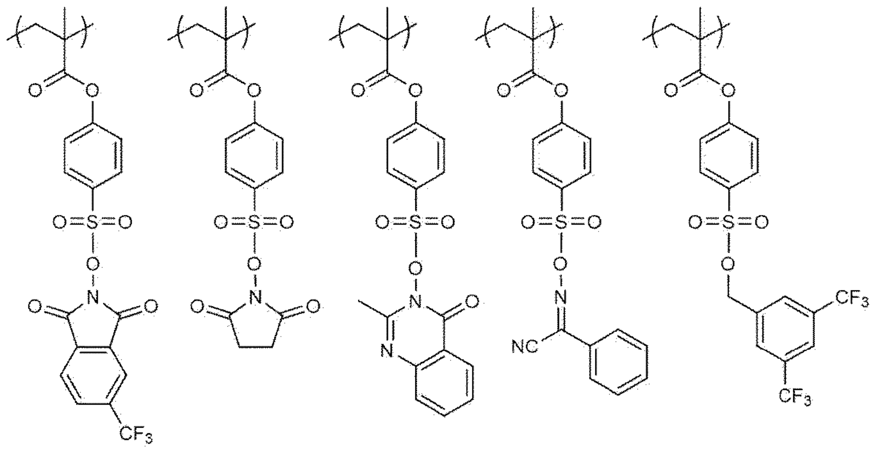

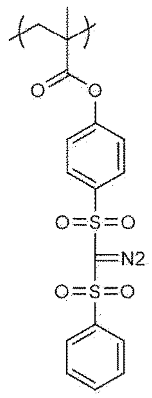
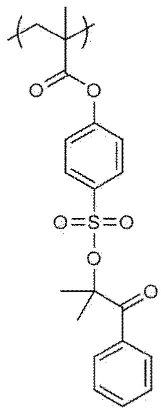
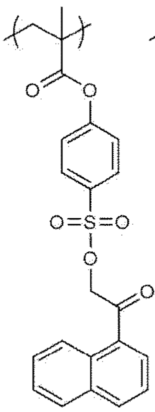
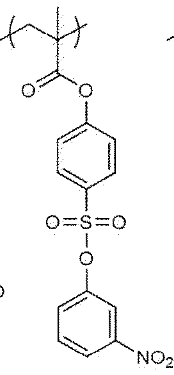
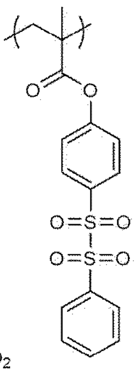

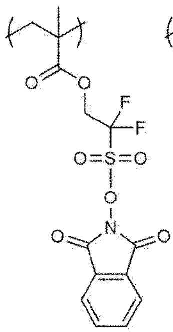
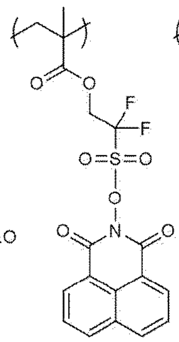
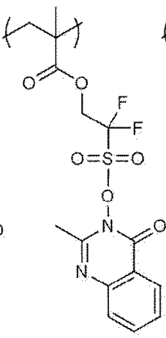
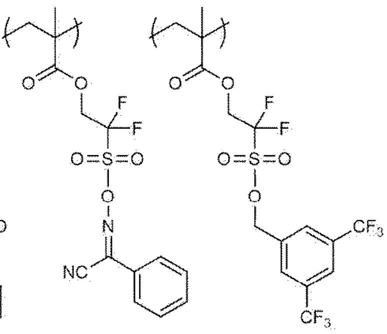

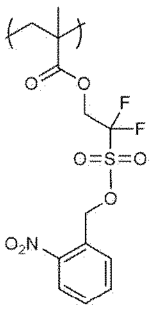
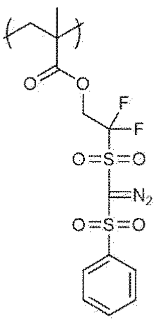
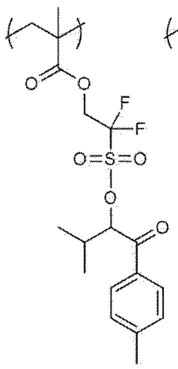
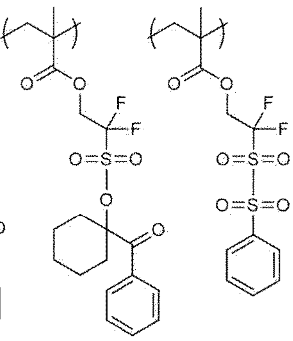

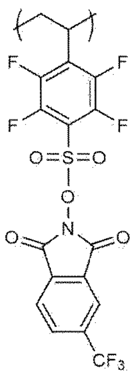
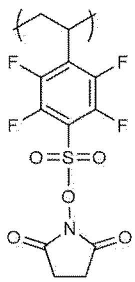
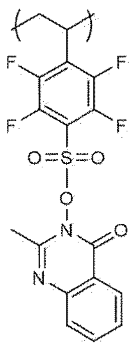
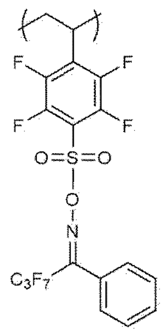
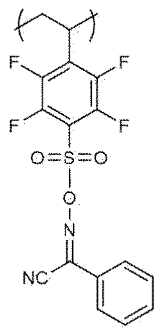

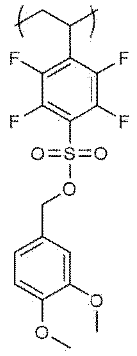
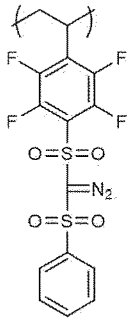
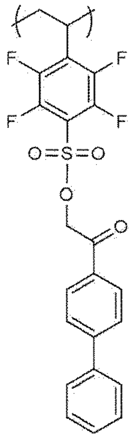
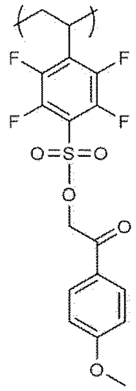
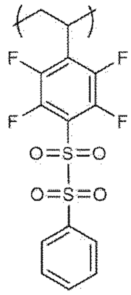

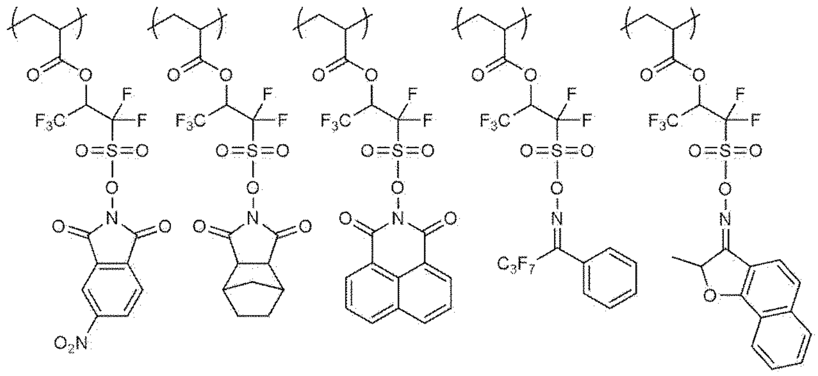

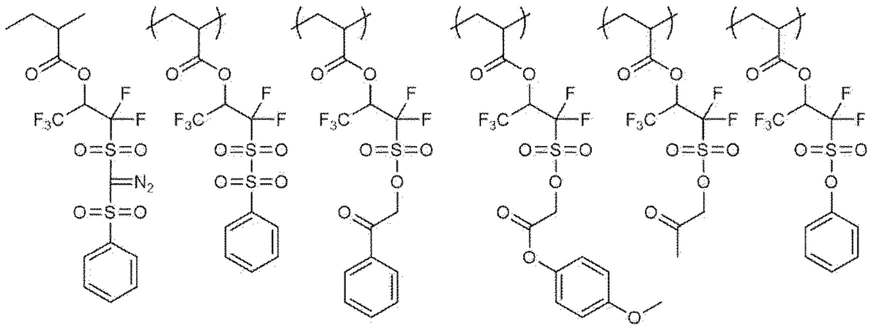

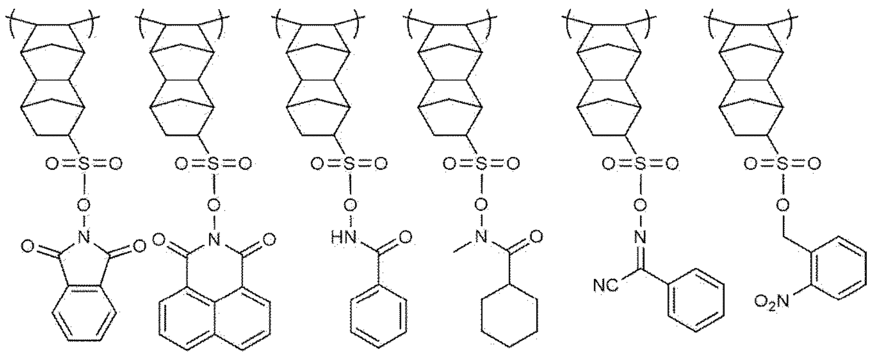

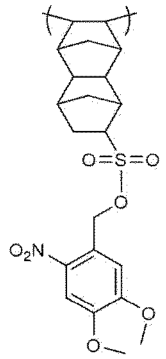
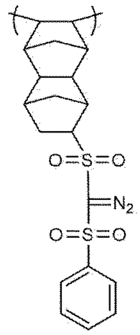
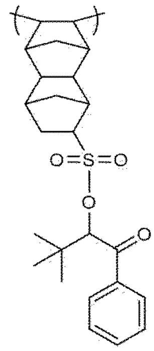
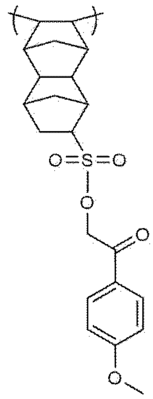
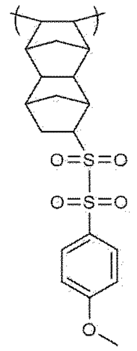

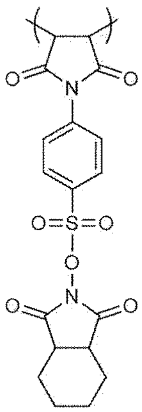
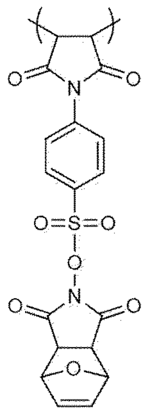
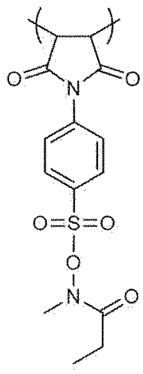
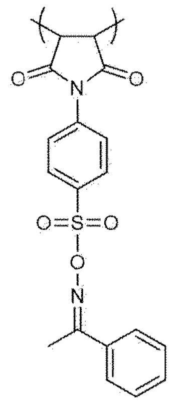
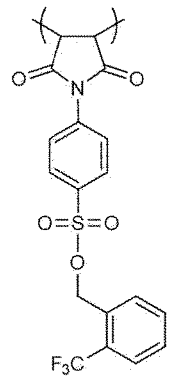

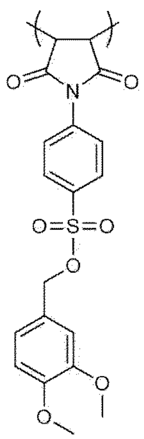
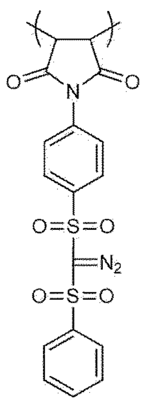
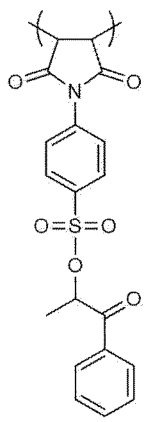
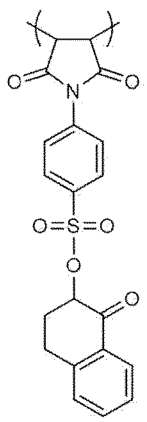
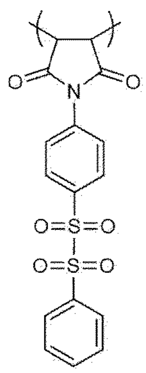

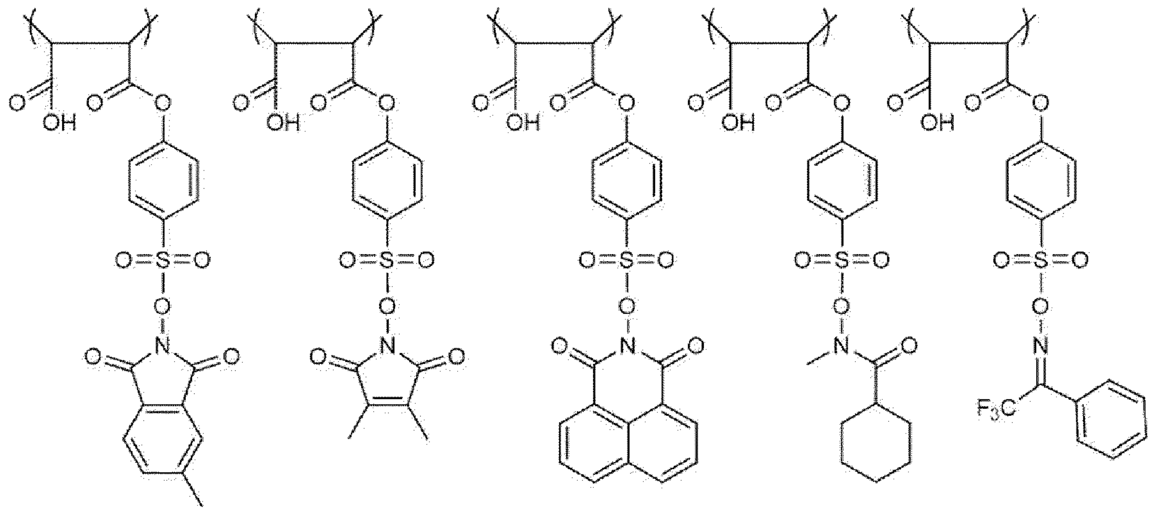

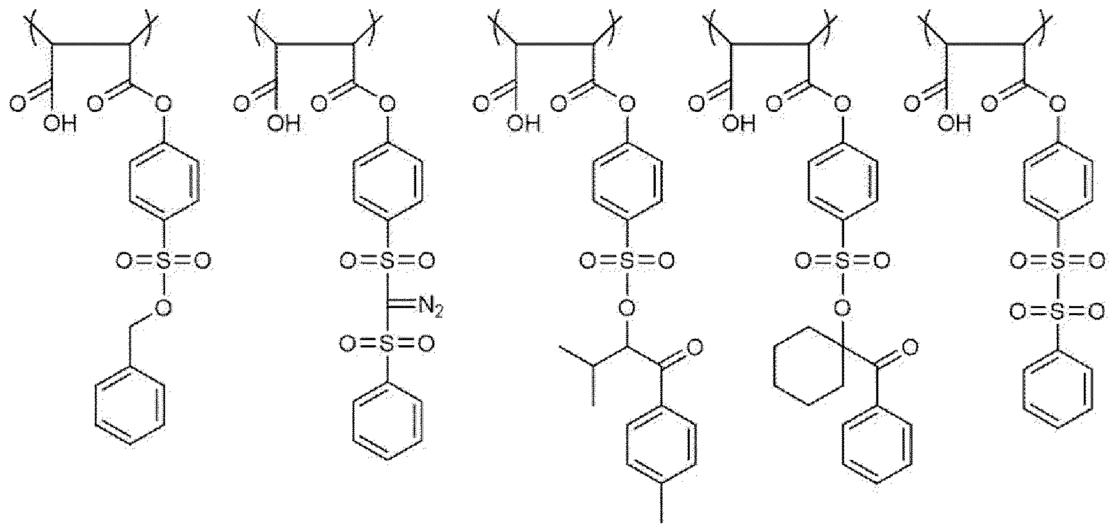

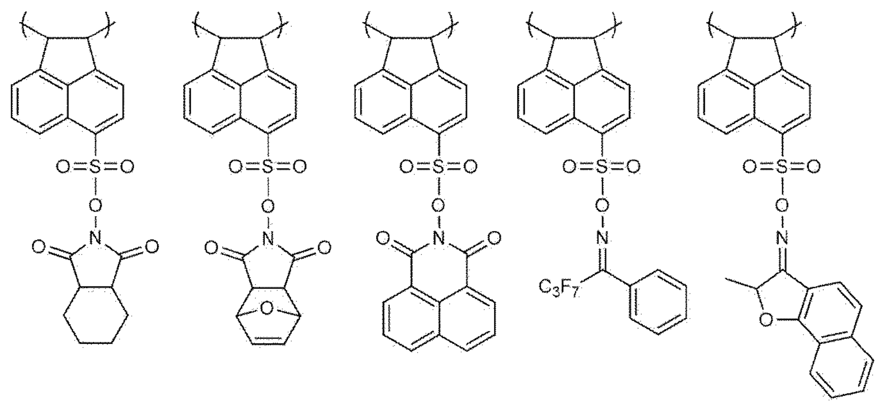

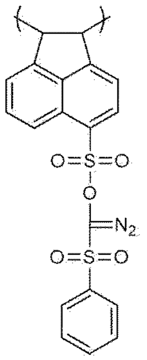
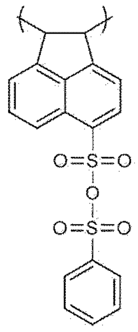
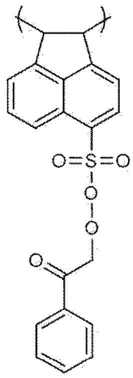
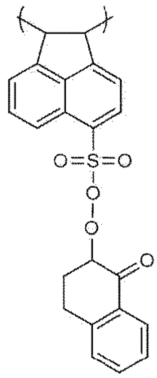
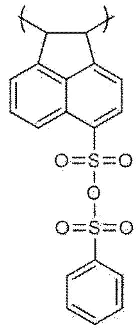

The repeating unit (a) may be used alone or in combination of two or more kinds thereof.

In a case where the resin (A) has two or more kinds of repeating units (a), a repeating unit (a) satisfying any of the above-described preferred requirements and a repeating unit (a) not satisfying any of the above-described preferred requirements may be present in combination. A content of the repeating unit (a) satisfying any of the above-described preferred requirements in all repeating units (a) is preferably 10% to 100% by mole, more preferably 30% to 100% by mole, and still more preferably more than 50% by mole and 100% by mole or less.

The above-described two or more kinds of repeating units (a) may be included in the same resin (A), or may be included in different resins (A), respectively.

A content of the repeating unit (a) is preferably 1% to 80% by mole, more preferably 5% to 60% by mole, and still more preferably 10% to 45% by mole with respect to all repeating units of the resin (A).

<Repeating Unit having Acid-decomposable Group>

The resin (A) also preferably has a repeating unit having an acid-decomposable group.

The repeating unit having an acid-decomposable group is preferably a repeating unit different from the above-described repeating unit.

The acid-decomposable group is a group which is decomposed by action of acid to form a polar group. The acid-decomposable group preferably has a structure in which a polar group is protected by an acid-leaving group which is eliminated by action of acid. That is, the resin (A) having a repeating unit having an acid-decomposable group is decomposed by action of acid to generate a polar group. The resin having this repeating unit has an increased polarity by action of acid, an increased solubility in an alkali developer, and a decreased solubility in an organic solvent.

As the polar group, an alkali-soluble group is preferable, and examples thereof include an acidic group, such as a carboxyl group, an aromatic hydroxyl group (a phenolic hydroxyl group and the like), a fluorinated alcohol group, a sulfonic acid group, a phosphoric acid group, a sulfonamide group, a sulfonylimide group, an (alkylsulfonyl)(alkylcarbonyl)methylene group, an (alkylsulfonyl)(alkylcarbonyl)imide group, a bis(alkylcarbonyl)methylene group, a bis(alkylcarbonyl)imide group, a bis(alkylsulfonyl)methylene group, a bis(alkylsulfonyl)imide group, a tris(alkylcarbonyl)methylene group, and a tris(alkylsulfonyl)methylene group; and an alcoholic hydroxyl group.

Among those, as the polar group, a carboxyl group, an aromatic hydroxyl group (a phenolic hydroxyl group and the like), a fluorinated alcohol group (preferably, a hexafluoroisopropanol group), or a sulfonic acid group is preferable, and a carboxyl group or an aromatic hydroxyl group (a phenolic hydroxyl group and the like) is more preferable.

That is, the repeating unit having an acid-decomposable group is preferably decomposed by action of acid to generate one or more groups selected from the group consisting of a carboxyl group, an aromatic hydroxyl group (a phenolic hydroxyl group and the like), a fluorinated alcohol group, and a sulfonic acid group, and is more preferably decomposed by action of acid to generate one or more groups selected from the group consisting of a carboxyl group and an aromatic hydroxyl group (a phenolic hydroxyl group and the like).

Examples of the acid-leaving group which is eliminated by action of acid include groups represented by Formulae (Y1) to (Y4).

Formula (Y1): $-C(Rx_1)(Rx_2)(Rx_3)$

Formula (Y2): $-C(=O)OC(Rx_1)(Rx_2)(Rx_3)$

Formula (Y3): $-C(R_{36})(R_{37})(OR_{38})$

Formula (Y4): -C(Rn)(H)(Ar)

In Formula (Y1) and Formula (Y2), $Rx_1$ to $Rx_3$ each independently represent a (linear or branched) alkyl group, a (monocyclic or polycyclic) cycloalkyl group, a (monocyclic or polycyclic) aryl group, an aralkyl group, or a (linear or branched) alkenyl group. If possible, these groups preferably have a fluorine atom or a group having a fluorine atom as a substituent.

In a case where all of $Rx_1$ to $Rx_3$ are (linear or branched) alkyl groups, it is preferable that at least two of $Rx_1$ to $Rx_3$ are methyl groups.

Among these, it is preferable that $Rx_1$ to $Rx_3$ each independently represent a linear or branched alkyl group, and it is more preferable that $Rx_1$ to $Rx_3$ each independently represent a linear alkyl group.

Two of $Rx_1$ to $Rx_3$ may be bonded to each other to form a ring (monocycle or polycycle).

As the alkyl group of $Rx_1$ to $Rx_3$, an alkyl group having 1 to 5 carbon atoms, such as a methyl group, an ethyl group, an n-propyl group, an isopropyl group, an n-butyl group, an isobutyl group, and a t-butyl group, is preferable.

As the cycloalkyl group of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable.

As the aryl group of $Rx_1$ to $Rx_3$, an aryl group having 6 to 10 carbon atoms is preferable, and examples thereof include a phenyl group, a naphthyl group, and an anthryl group.

As the aralkyl group of $Rx_1$ to $Rx_3$, an aralkyl group having 7 to 20 carbon atoms is preferable.

As the alkenyl group of $Rx_1$ to $Rx_3$, a vinyl group is preferable.

A cycloalkyl group is preferable as the ring formed by the bonding of two of $Rx_1$ to $Rx_3$. As a cycloalkyl group formed by the bonding of two of $Rx_1$ to $Rx_3$, a monocyclic cycloalkyl group such as a cyclopentyl group and a cyclohexyl group, or a polycyclic cycloalkyl group such as a norbornyl group, a tetracyclodecanyl group, a tetracyclododecanyl group, and an adamantyl group is preferable, and a monocyclic cycloalkyl group having 5 or 6 carbon atoms is more preferable.

In the cycloalkyl group formed by the bonding of two of $Rx_1$ to $Rx_3$ to each other, for example, one of methylene groups constituting the ring may be replaced with a heteroatom such as an oxygen atom, with a group having a heteroatom, such as a carbonyl group, or with a vinylidene group. In addition, in such a cycloalkyl group, one or more (for example, one or two) of ethylene groups constituting the cycloalkane ring may be replaced with a vinylene group.

With regard to the group represented by Formula (Y1) or Formula (Y2), for example, an aspect in which $Rx_1$ is a methyl group or an ethyl group and $Rx_2$ and $R_{X3}$ are bonded to each other to form the above-described cycloalkyl group is also preferable.

In addition, in Formula (Y1) or Formula (Y2), in a case where two of $Rx_1$ to $Rx_3$ are bonded to form a cycloalkenyl group, and in the cycloalkenyl group, a vinylene group is present at a position adjacent to C (carbon atom) specified in "$C(Rx_1)(Rx_2)(Rx_3)$" of Formula (Y1) or Formula (Y2), the remaining one of Rx to $Rx_3$ may be a hydrogen atom.

In General Formula (Y3), $R_{36}$ to $R_{38}$ each independently represent a hydrogen atom or an organic group. $R_{37}$ and $R_{38}$ may be bonded to each other to form a ring. Examples of the organic group include an alkyl group, a cycloalkyl group, an aryl group, an aralkyl group, and an alkenyl group. It is also preferable that $R_{36}$ is a hydrogen atom.

Examples of the alkyl group, the cycloalkyl group, the aryl group, the aralkyl group, and the alkenyl group represented by $R_{36}$ to $R_{38}$ in Formula (Y3) include the same groups described as the alkyl group, the cycloalkyl group, the aryl group, the aralkyl group, and the alkenyl group represented by $Rx_1$ to $Rx_3$ in Formula (Y1) and Formula (Y2).

$R_{37}$ and $R_{38}$ may be bonded to each other to form a ring.

In addition, $R_{38}$ may be bonded to the main chain of the repeating unit. In this case, $R_{38}$ is preferably an alkylene group such as a methylene group.

As Formula (Y3), a group represented by Formula (Y3-1) is preferable.

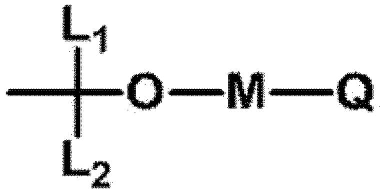

(Y3-1)

Here, $L_1$ and $L_2$ each independently represent a hydrogen atom, an alkyl group, a cycloalkyl group, an aryl group, or a group formed by a combination thereof (for example, a group formed by a combination of an alkyl group and an aryl group).

M represents a single bond or a divalent linking group.

Q represents an alkyl group which may include a heteroatom, a cycloalkyl group which may include a heteroatom, an aryl group which may include a heteroatom, an amino group, an ammonium group, a mercapto group, a cyano group, an aldehyde group, or a group formed by a combination thereof (for example, a group formed by a combination of an alkyl group and a cycloalkyl group).

In the alkyl group and the cycloalkyl group, for example, one of methylene groups may be replaced with a heteroatom such as an oxygen atom or with a group having a heteroatom, such as a carbonyl group.

It is preferable that one of $L_1$ or $L_2$ is a hydrogen atom, and the other is an alkyl group, a cycloalkyl group, an aryl group, or a group formed by a combination of an alkylene group and an aryl group.

At least two of Q, M, or $L_1$ may be bonded to each other to form a ring (preferably a 5- or 6-membered ring). Q may be bonded to a part of the acid group protected by the group represented by Formula (Y3-1) to form a ring. Q may be bonded to the main chain of the repeating unit to form a ring.

From the viewpoint of pattern miniaturization, $L_2$ is preferably a secondary or tertiary alkyl group, and more preferably a tertiary alkyl group. Examples of the secondary alkyl group include an isopropyl group, a cyclohexyl group, and a norbornyl group, and examples of the tertiary alkyl group include a tert-butyl group and an adamantane group. In these aspects, since a glass transition temperature (Tg) and an activation energy are increased, it is possible to suppress fogging in addition to ensuring a film hardness.

In Formula (Y4), Ar represents an aromatic ring group. Rn represents an alkyl group, a cycloalkyl group, or an aryl group. Rn and Ar may be bonded to each other to form a non-aromatic ring. Ar is preferably an aryl group.

From the viewpoint that the acid decomposability of the repeating unit is excellent, in a case where a non-aromatic ring is directly bonded to a polar group (or a residue thereof) in the acid-leaving group which protects the polar group, it is also preferable that a ring member atom adjacent to the ring member atom directly bonded to the polar group (or a residue thereof) in the non-aromatic ring has no halogen atom such as a fluorine atom as a substituent.

In addition, the acid-leaving group which is eliminated by action of acid may be a 2-cyclopentenyl group having a substituent (an alkyl group and the like), such as a 3-methyl-2-cyclopentenyl group, and a cyclohexyl group having a substituent (an alkyl group and the like), such as a 1,1,4,4-tetramethylcyclohexyl group.

The repeating unit having an acid-decomposable group is preferably a repeating unit represented by any one of General Formulae (3) to (7), and more preferably a repeating unit represented by General Formula (6) or (7).

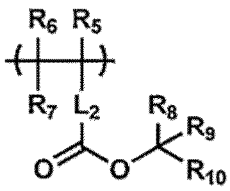

(3)

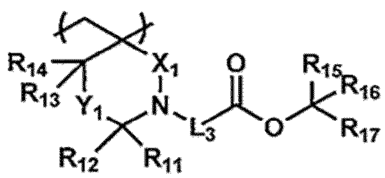

(4)

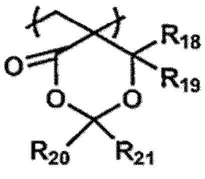

(5)

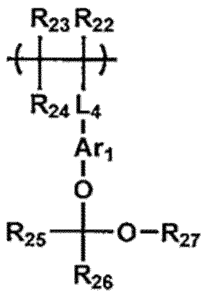

(6)

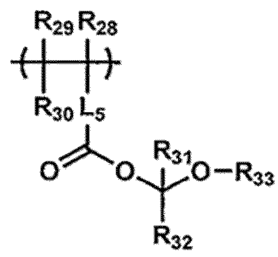

(7)

In General Formula (3), $R_5$ to $R_7$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

Among these, $R_5$ is preferably a hydrogen atom or an alkyl group.

$R_6$ and $R_7$ are each independently preferably a hydrogen atom.

In General Formula (3), $L_2$ represents a single bond or a divalent linking group.

Examples of the above-described divalent linking group include -CO-, -NR-, -CO-, -O-, -S-, -SO-, $-SO_2-$, an

alkylene group (preferably having 1 to 6 carbon atoms; which may be linear or branched), a cycloalkylene group (preferably having 3 to 15 carbon atoms), an alkenylene group (preferably having 2 to 6 carbon atoms), a divalent aliphatic heterocyclic group (preferably a ring having the number of ring member atoms of 5 to 10, in which at least one of a nitrogen atom, an oxygen atom, a sulfur atom, or a selenium atom is included as the ring member atom), a divalent aromatic heterocyclic group (preferably a ring having the number of ring member atoms of 5 to 10, in which at least one of a nitrogen atom, an oxygen atom, a sulfur atom, or a selenium atom is included as the ring member atom), a divalent aromatic hydrocarbon ring group (preferably a ring having the number of ring member atoms of 6 to 10), and a divalent linking group formed by a combination of a plurality of these groups. R in -NR- represents a hydrogen atom or an organic group. The above-described organic group is preferably an alkyl group (for example, having 1 to 6 carbon atoms).

In General Formula (3), $R_8$ to $R_{10}$ each independently represent an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_8$ to $R_{10}$ in General Formula (3) include the same groups described as the alkyl group, the cycloalkyl group, the aryl group, the aralkyl group, and the alkenyl group represented by $Rx_1$ to $Rx_3$ in Formula (Y1) and Formula (Y2) described above.

Two of $R_8$ to $R_{10}$ may be bonded to each other to form a ring.

Examples of the ring formed by bonding two of $R_8$ to $R_{10}$ in General Formula (3) to each other include the same ring described as the ring formed by bonding two of $Rx_1$ to $Rx_3$ in Formula (Y1) and Formula (Y2) above.

In General Formula (4), $R_{11}$ to $R_{14}$ each independently represent a hydrogen atom or an organic group (preferably having 1 to 6 carbon atoms). However, at least one of $R_{11}$ or $R_{12}$ represents an organic group.

In General Formula (4), $X_1$ represents -CO-, -SO-, or $-SO_2-$.

In General Formula (4), $Y_1$ represents -O-, -S-, -SO-, $-SO_2-$, or $-NR_{34}-$. $R_{34}$ represents a hydrogen atom or an organic group. The above-described organic group is preferably an alkyl group (for example, having 1 to 6 carbon atoms).

In General Formula (4), $L_3$ represents a single bond or a divalent linking group.

Examples of the divalent linking group represented by $L_3$ in General Formula (4) include the same group described as the divalent linking group represented by $L_2$ in General Formula (3) described above.

In General Formula (4), $R_{15}$ to $R_{17}$ each independently represent an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_{15}$ to $R_{17}$ in General Formula (4) include the same groups described as the alkyl group, the cycloalkyl group, the aryl group, the aralkyl group, and the alkenyl group represented by $Rx_1$ to $Rx_3$ in Formula (Y1) and Formula (Y2) described above.

Two of $R_{15}$ to $R_{17}$ may be bonded to each other to form a ring.

Examples of the ring formed by bonding two of $R_{15}$ to $R_{17}$ in General Formula (4) to each other include the same ring described as the ring formed by bonding two of $Rx_1$ to $Rx_3$ in Formula (Y1) and Formula (Y2) above.

In General Formula (5), $R_{18}$ and $R_{19}$ each independently represent a hydrogen atom or an organic group (preferably having 1 to 6 carbon atoms).

In General Formula (5), $R_{20}$ and $R_{21}$ each independently represent a hydrogen atom, an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_{20}$ and $R_{21}$ in General Formula (5) include the same groups described as the alkyl group, the cycloalkyl group, the aryl group, the aralkyl group, and the alkenyl group represented by $Rx_1$ to $Rx_3$ in Formula (Y1) and Formula (Y2) described above.

$R_{20}$ and $R_{21}$ may be bonded to each other to form a ring.

Examples of the ring formed by bonding $R_{20}$ and $R_{21}$ in General Formula (5) to each other include the same ring described as the ring formed by bonding two of $Rx_1$ to $Rx_3$ in Formula (Y1) and Formula (Y2) above.

In General Formula (6), $R_{22}$ to $R_{24}$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

In General Formula (6), $L_4$ represents a single bond or a divalent linking group.

Examples of the divalent linking group represented by $L_4$ in General Formula (6) include the same group described as the divalent linking group represented by $L_2$ in General Formula (3) described above.

In General Formula (6), An represents an aromatic ring group. The above-described aromatic ring group may be monocyclic or polycyclic, and may or may not have one or more (for example, one to three) heteroatoms as ring member atoms. The number of ring member atoms in the above-described aromatic ring group is preferably 5 to 15.

An is preferably a benzene ring group.

In General Formula (6), $R_{25}$ to $R_{27}$ each independently represent a hydrogen atom, an alkyl group, a cycloalkyl

group, an aryl group, an aralkyl group, or an alkenyl group.

Examples of the alkyl group, the cycloalkyl group, the aryl group, the aralkyl group, and the alkenyl group represented by $R_{25}$ to $R_{27}$ in General Formula (6) include the same groups described as the alkyl group, the cycloalkyl group, the aryl group, the aralkyl group, and the alkenyl group represented by $Rx_1$ to $Rx_3$ in Formula (Y1) and Formula (Y2) described above.

$R_{26}$ and $R_{27}$ may be bonded to each other to form a ring.

In a case where $R_{26}$ and $R_{27}$ in General Formula (6) are bonded to each other to form a ring, it is preferable that $R_{26}$ and $R_{27}$ jointly form one divalent linking group. Examples of such a divalent linking group include the same group described as the divalent linking group represented by $L_2$ in General Formula (3) described above, and an alkylene group is preferable.

In addition, $R_{24}$ or $R_{25}$ may be bonded to An.

In a case where $R_{24}$ is bonded to $Ar_1$, it is preferable that $R_{24}$ is a single bond or a divalent linking group and is bonded to a ring member atom of the aromatic ring group represented by An. Examples of such a divalent linking group include the same group described as the divalent linking group represented by $L_2$ in General Formula (3) described above, and an alkylene group is preferable.

In addition, in a case where $R_{25}$ is bonded to $Ar_1$, it is preferable that $R_{25}$ is a divalent linking group and is bonded to a ring member atom of the aromatic ring group represented by An. Examples of such a divalent linking group include the same group described as the divalent linking group represented by $L_2$ in General Formula (3) described above, and an alkylene group is preferable.

In General Formula (7), $R_{28}$ to $R_{30}$ each independently represent a hydrogen atom, an alkyl group (may be linear or branched; for example, having 1 to 6 carbon atoms), a cycloalkyl group (which may be monocyclic or polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

In General Formula (7), Ls represents a single bond or a divalent linking group.

Examples of the divalent linking group represented by Ls in General Formula (7) include the same group described as the divalent linking group represented by $L_2$ in General Formula (3) described above.

$R_{31}$ and $R_{32}$ each independently represent a hydrogen atom, an alkyl group, a cycloalkyl group, an aryl group, an aralkyl group, or an alkenyl group.

$R_{33}$ represents an alkyl group, a cycloalkyl group, an aryl group, an aralkyl group, or an alkenyl group.

Examples of the alkyl group, the cycloalkyl group, the aryl group, the aralkyl group, and the alkenyl group represented by $R_{31}$ to $R_{33}$ in General Formula (7) include the same groups described as the alkyl group, the cycloalkyl group, the aryl group, the aralkyl group, and the alkenyl group represented by $Rx_1$ to $Rx_3$ in Formula (Y1) and Formula (Y2) described above.

$R_{32}$ and $R_{33}$ may be bonded to each other to form a ring.

In a case where $R_{32}$ and $R_{33}$ in General Formula (7) are bonded to each other to form a ring, it is preferable that $R_{32}$ and $R_{33}$ jointly form one divalent linking group. Examples of such a divalent linking group include the same group described as the divalent linking group represented by $L_2$ in General Formula (3) described above, and an alkylene group is preferable.

The repeating unit having an acid-decomposable group is exemplified below.

In the following formulae, $Xa_1$ represents any of H, $CH_3$, $CF_3$, or CHzOH, Rxa and Rxb each independently represent a linear or branched alkyl group having 1 to 5 carbon atoms (a methyl group, an ethyl group, an n-propyl group, an isopropyl group, an n-butyl group, an isobutyl group, a t-butyl group, or the like).

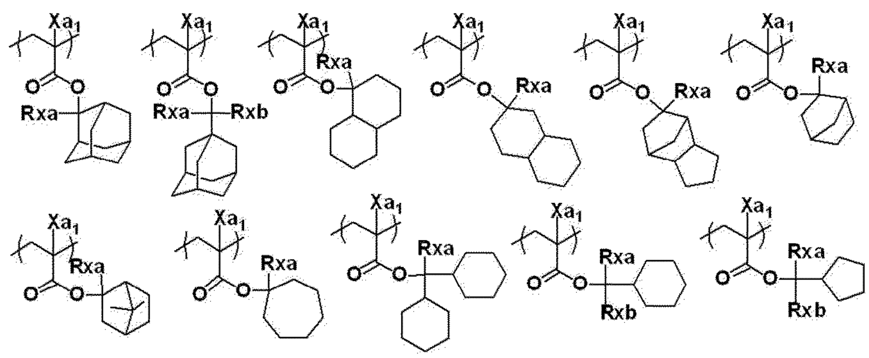

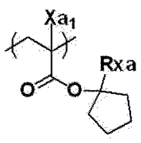
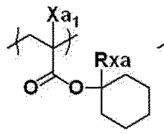
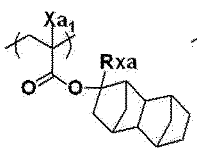
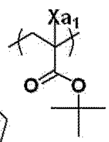
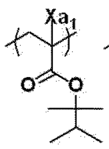
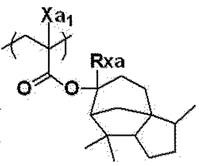

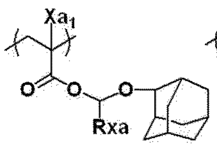
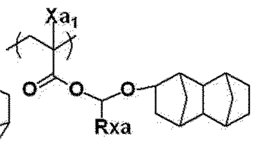
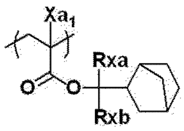
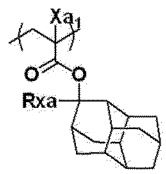

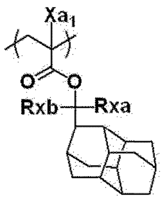
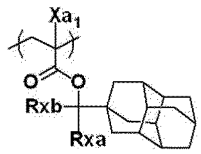
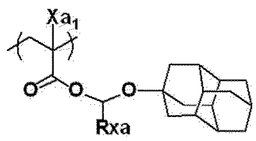
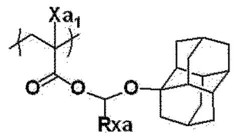

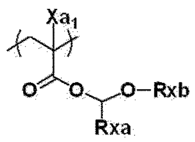
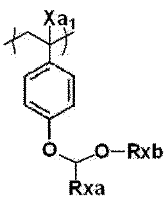
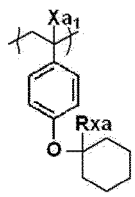
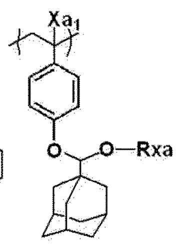

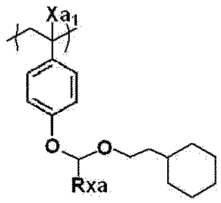
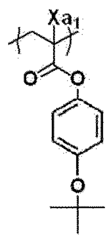

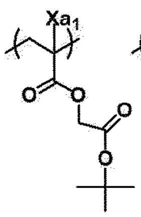
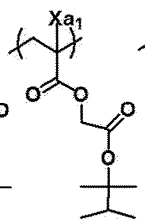
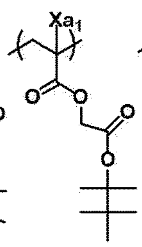
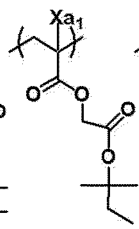
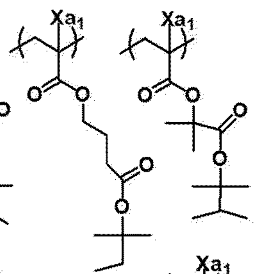

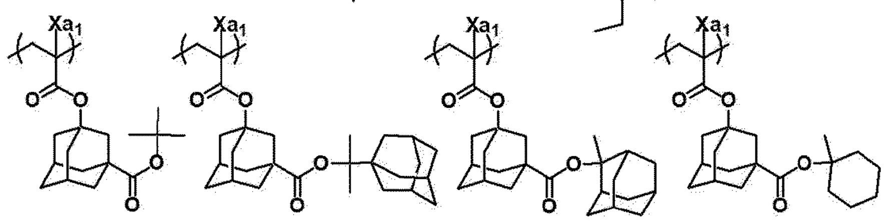

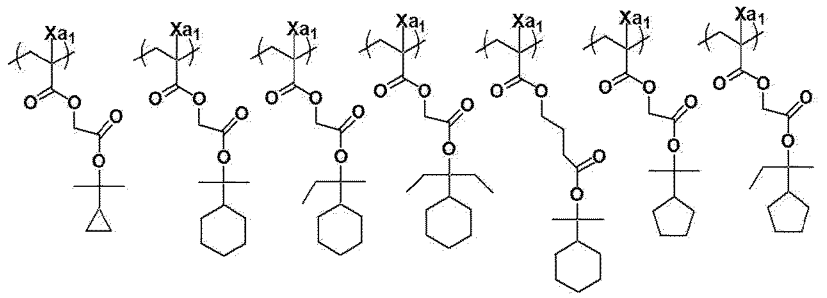

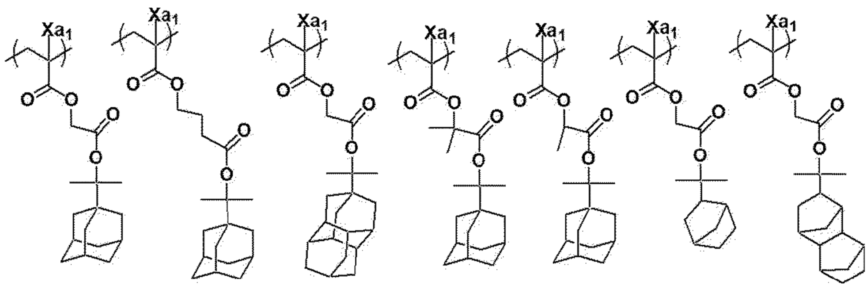

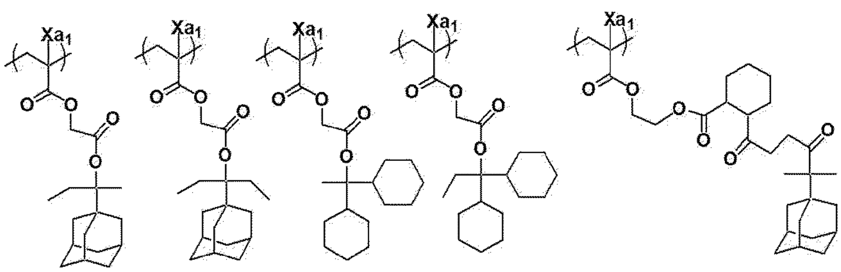

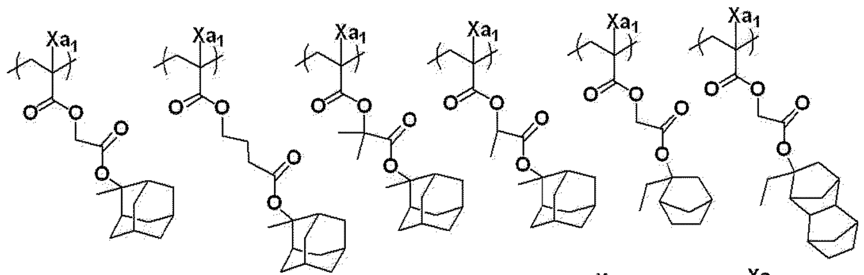

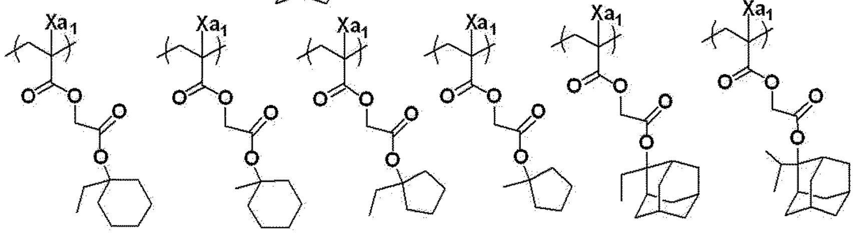

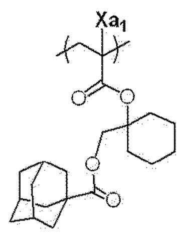

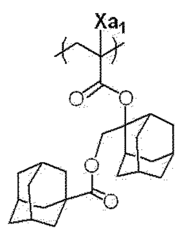

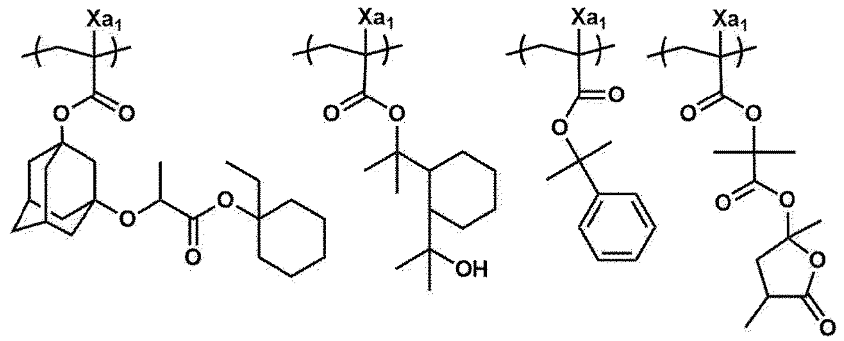

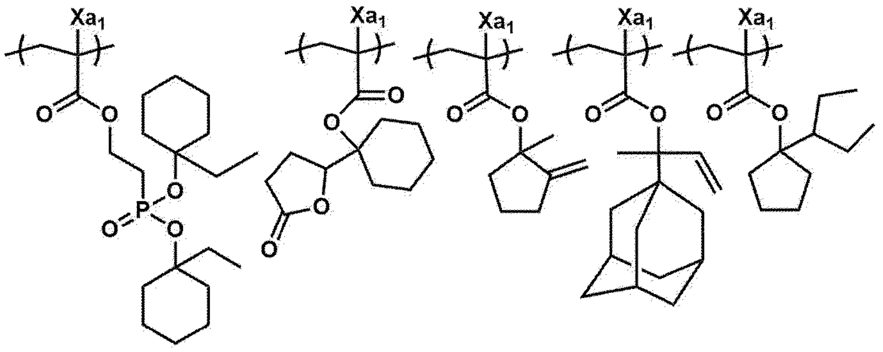

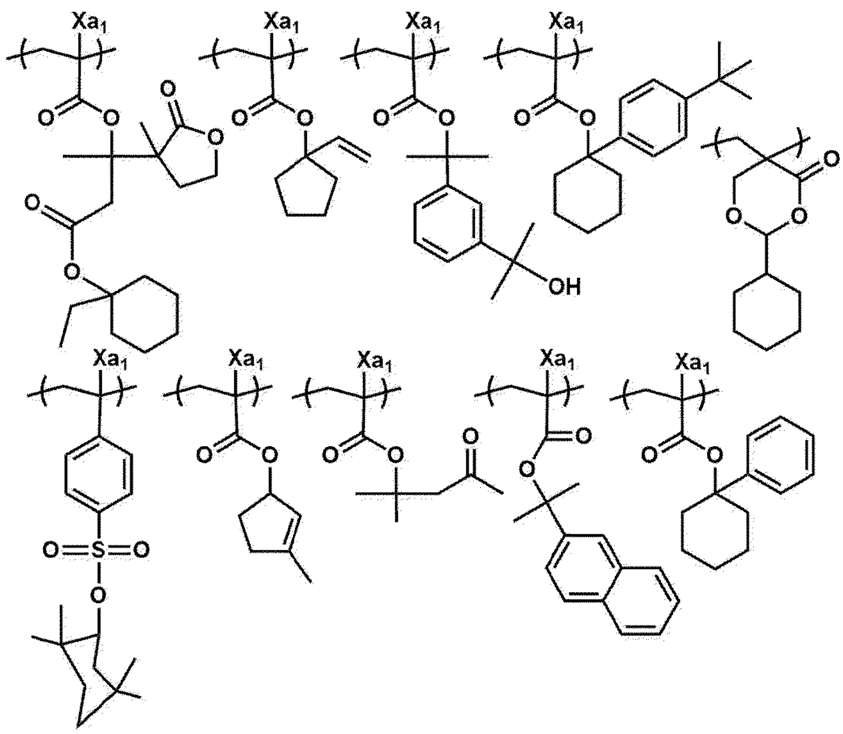

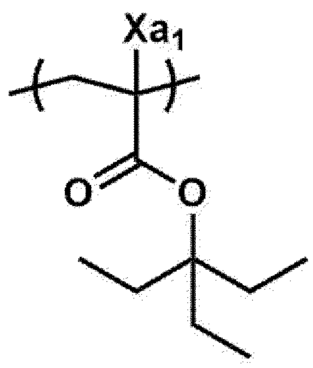

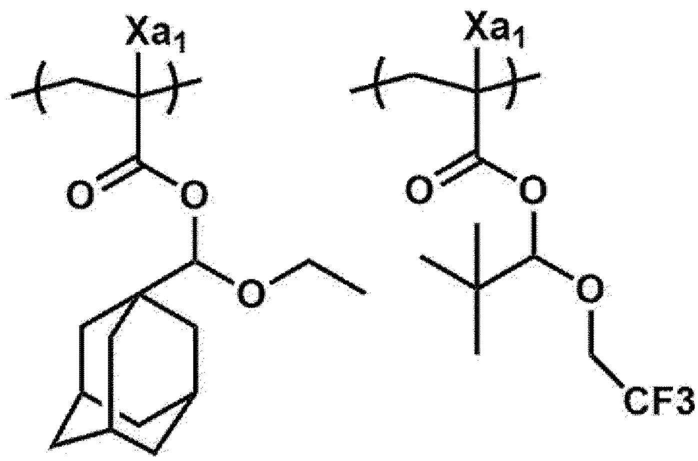

The repeating unit having an acid-decomposable group may be used alone or in combination of two or more kinds thereof.

A content of the repeating unit having an acid-decomposable group is preferably 5% to 80% by mole, more preferably 10% to 70% by mole, and still more preferably 20% to 60% by mole with respect to all repeating units of the resin (A).

<Repeating Unit having Acid Group>

The resin (A) may have a repeating unit having an acid group.

The repeating unit having an acid group is preferably a repeating unit different from the above-described repeating units.

As the acid group, an acid group having a pKa of 13 or less is preferable. As described above, the acid dissociation constant of the above-described acid group is preferably 13 or less, more preferably 3 to 13, and still more preferably 5 to 10.

In a case where the resin A has an acid group having a pKa of 13 or less, a content of the acid group in the resin A is not particularly limited, but is usually 0.2 to 6.0 mmol/g. Among these, 0.8 to 6.0 mmol/g is preferable, 1.2 to 5.0 mmol/g is more preferable, and 1.6 to 4.0 mmol/g is still more preferable. In a case where the content of the acid group is within the above-described range, the development proceeds satisfactorily, the formed pattern shape is excellent, and the resolution is also excellent.

As the acid group, for example, a carboxyl group, a hydroxyl group, an aromatic hydroxyl group (a phenolic hydroxyl group), a fluorinated alcohol group (preferably, a hexafluoroisopropanol group), a sulfonic acid group, a sulfonamide group, or an isopropanol group is preferable.

In addition, in the above-described hexafluoroisopropanol group, one or more (preferably one or two) fluorine atoms may be substituted with a group (an alkoxycarbonyl group and the like) other than a fluorine atom. $-C(CF_3)(OH)-CF_2-$ formed as above is also preferable as the acid group. In addition, one or more fluorine atoms may be substituted with a group other than a fluorine atom to form a ring including $-C(CF_3)(OH)-CF_2-$.

The repeating unit having an acid group may have a fluorine atom or an iodine atom.

The repeating unit having an acid group is preferably a repeating unit represented by General Formula (B).

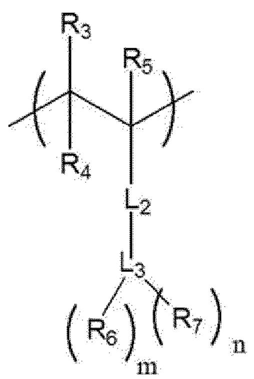

(B)

$R_3$ represents a hydrogen atom or an organic group which may have a fluorine atom or an iodine atom.

As the organic group which may have a fluorine atom or an iodine atom, a group represented by $-L_4-R_8$ is preferable. $L_4$ represents a single bond or an ester group. Examples of Rs include an alkyl group which may have a fluorine atom or an iodine atom, a cycloalkyl group which may have a fluorine atom or an iodine atom, an aryl group which may have a fluorine atom or an iodine atom, and a group formed by a combination thereof.

$R_4$ and $R_5$ each independently represent a hydrogen atom, a fluorine atom, an iodine atom, or an alkyl group which may have a fluorine atom or an iodine atom.

$L_2$ represents a single bond, an ester group, or a divalent group formed by combining -CO-, -O-, and an alkylene group (preferably having 1 to 6 carbon atoms; which may be linear or branched; in addition, $-CH_2-$ may be substituted with a halogen atom).

$L_3$ represents an (n+m+1)-valent aromatic hydrocarbon ring group or an (n+m+1)-valent alicyclic hydrocarbon ring group. Examples of the aromatic hydrocarbon ring group include a benzene ring group and a naphthalene ring group. The alicyclic hydrocarbon ring group may be monocyclic or polycyclic, and examples thereof include a cycloalkyl ring group, a norbornene ring group, and an adamantane ring group.

$R_6$ represents a hydroxyl group or a fluorinated alcohol group. The fluorinated alcohol group is preferably a group represented by Formula (3L).

$$*-L_{6X}-R_{6X} \qquad (3L)$$

$L_{6X}$ represents a single bond or a divalent linking group. The divalent linking group is not particularly limited, and examples thereof include -CO-, -O-, -SO-, $-SO_2-$, $-NR^A-$, an alkylene group (preferably having 1 to 6 carbon atoms; may be linear or branched), and a divalent linking group formed by a combination of a plurality of these groups. Examples of $R^A$ include a hydrogen atom and an alkyl group having 1 to 6 carbon atoms. In addition, the above-described alkylene group may have a substituent. Examples of the substituent include a halogen atom (preferably, a fluorine atom) and a hydroxyl group. $R_{6X}$ represents a hexafluoroisopropanol group.

In a case where $R_6$ is a hydroxyl group, $L_3$ is also preferably the (n+m+1)-valent aromatic hydrocarbon ring group.

$R_7$ represents a halogen atom.

m represents an integer of 1 or more. m is preferably an integer of 1 to 3 and preferably an integer of 1 or 2.
n represents 0 or an integer of 1 or more. n is preferably an integer of 1 to 4.
(n+m+1) is preferably an integer of 1 to 5.

The repeating unit having an acid group is also preferably a repeating unit represented by General Formula (A2), and the resin (A) preferably has the repeating unit represented by General Formula (A2).

The repeating unit represented by General Formula (A2) is a repeating unit having an aromatic hydroxyl group as the acid group.

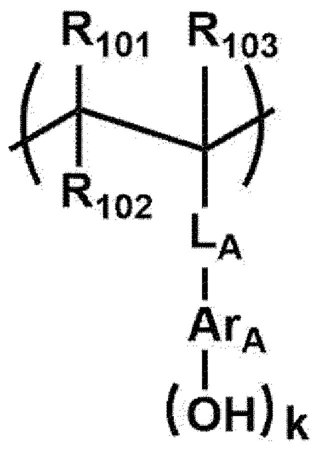

(A2)

In General Formula (A2), $R_{101}$, $R_{102}$, and $R_{103}$ each independently represent a hydrogen atom, an alkyl group (may be linear or branched; for example, having 1 to 6 carbon atoms), a cycloalkyl group (which may be monocyclic or

polycyclic, and the number of ring member atoms is, for example, 3 to 15), a halogen atom, a cyano group, or an alkoxycarbonyl group (for example, having 2 to 7 carbon atoms; an alkyl group moiety may be linear or branched).

In General Formula (A2), $L_A$ represents a single bond or a divalent linking group.

Examples of the divalent linking group represented by $L_A$ in General Formula (A2) include the same group described as the divalent linking group represented by $L_2$ in General Formula (3) described above.

$Ar_A$ represents an aromatic ring group (benzene ring group or the like).

The above-described aromatic ring group may be monocyclic or polycyclic, and may or may not have one or more (for example, one to three) heteroatoms as ring member atoms. The number of ring member atoms in the above-described aromatic ring group is preferably 5 to 15.

In General Formula (A2), k represents an integer of 1 to 5.

However, $R_{102}$ may be bonded to $Ar_A$, and in this case, $R_{102}$ represents a single bond or an alkylene group (which may be linear or branched; the number of carbon atoms is, for example, 1 to 6).

In this case, the aromatic ring group represented by $Ar_A$ is bonded to a carbon atom constituting the main chain (carbon atom to which $R_{101}$ is bonded) through the above-described single bond or the above-described alkylene group.

The repeating unit having an acid group is exemplified below.

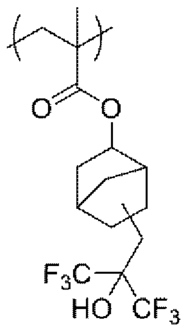
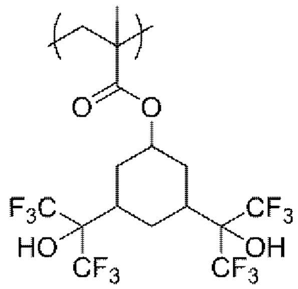
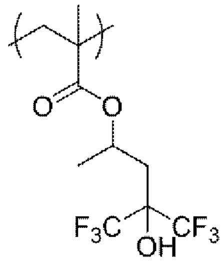
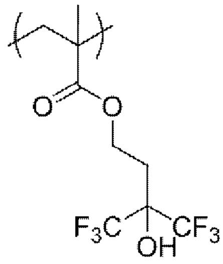
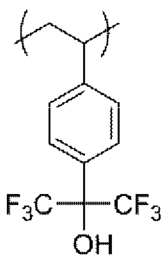
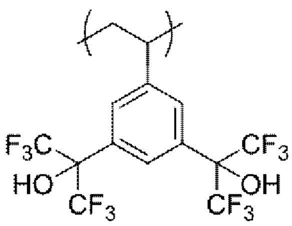
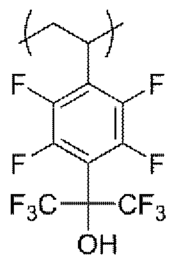
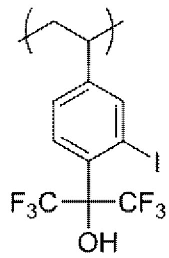
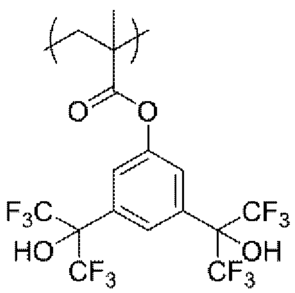
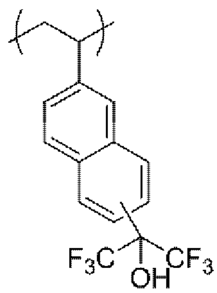

In the following examples, a represents 1 or 2 in the formulae.

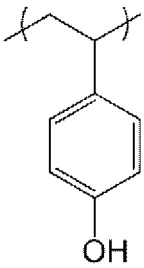 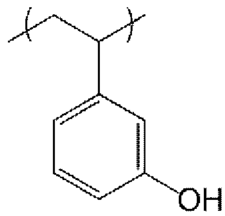 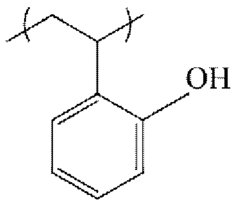

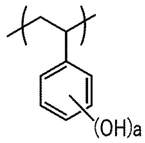
(B-1)

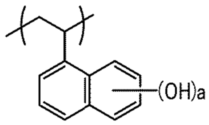
(B-2)

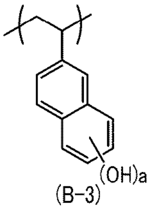
(B-3)

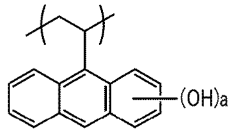
(B-4)

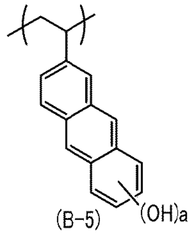
(B-5)

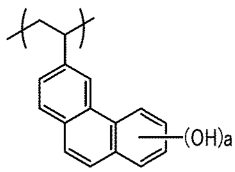
(B-6)

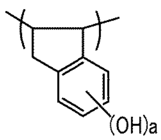
(B-7)

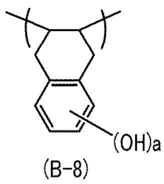
(B-8)

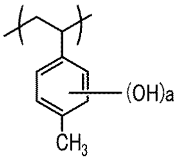
(B-9)

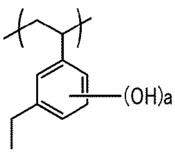
(B-10)

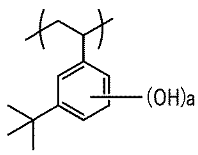
(B-11)

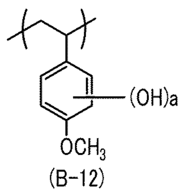
(B-12)

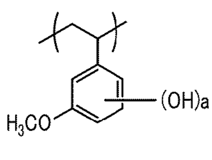
(B-13)

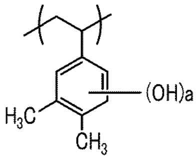
(B-14)

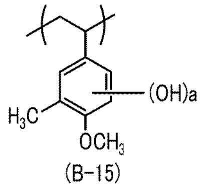
(B-15)

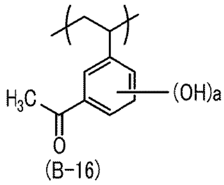
(B-16)

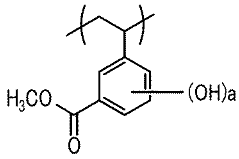
(B-17)

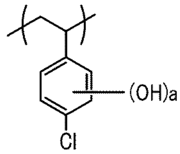
(B-18)

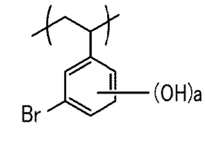
(B-19)

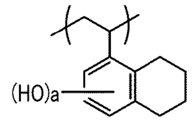
(B-20)

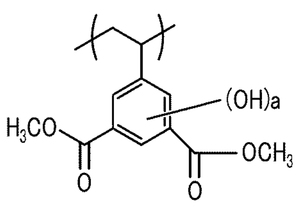
(B-21)

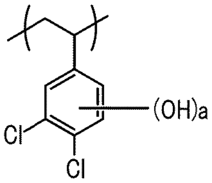
(B-22)

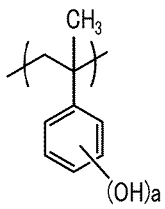
(B-23)

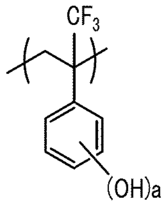
(B-24)

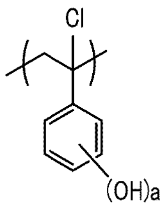
(B-25)

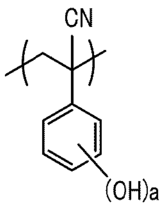
(B-26)

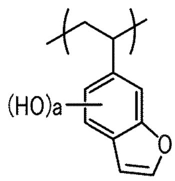
(B-27)

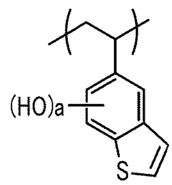
(B-28)

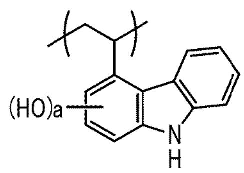
(B-29)

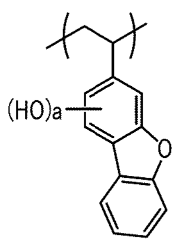
(B-30)

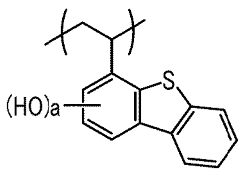
(B-31)

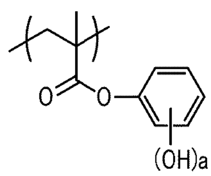
(B-32)

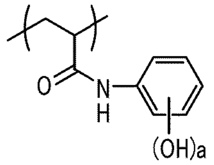
(B-33)

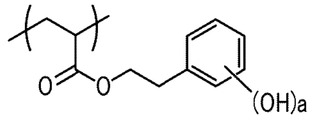
(B-34)

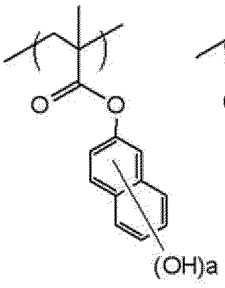
(B-35)

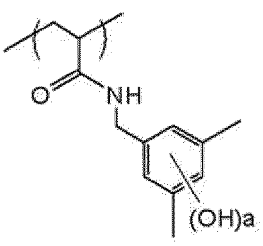
(B-36)

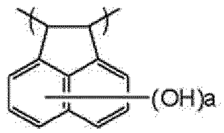
(B-37)

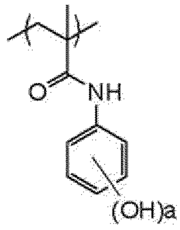
(B-38)

Among the above-described repeating units, repeating units specifically shown below are preferable. In the formulae, R represents a hydrogen atom or a methyl group, and a represents 2 or 3.

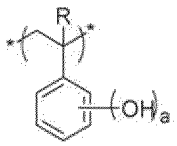
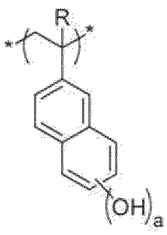
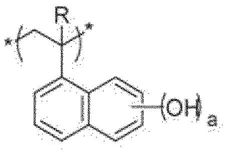
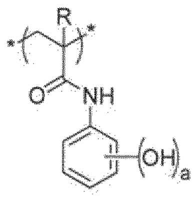

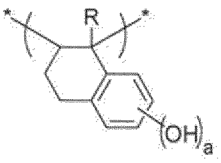
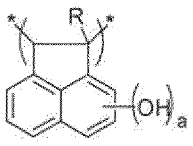
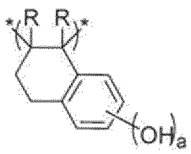
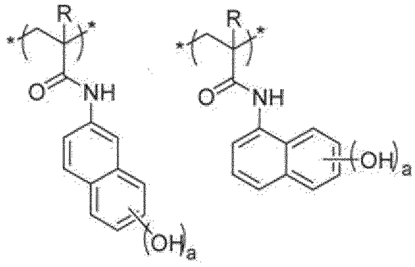

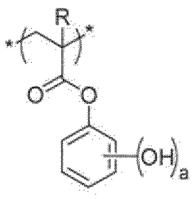
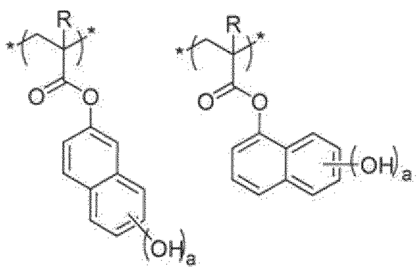
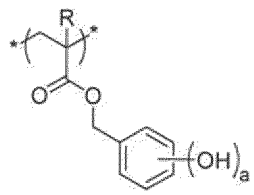
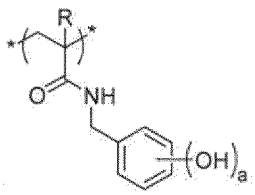

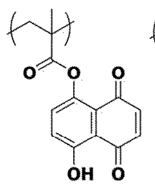
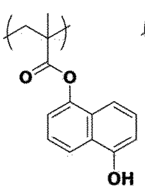
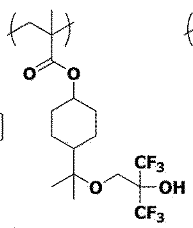
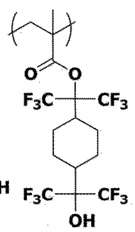
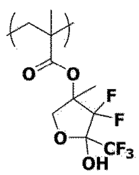
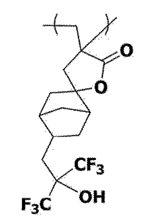

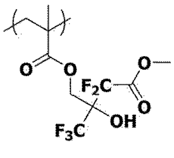
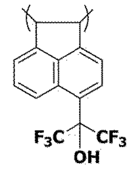
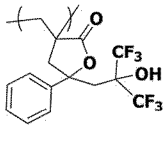
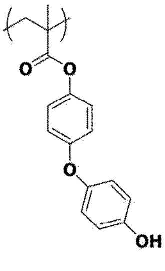
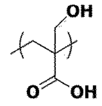
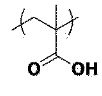

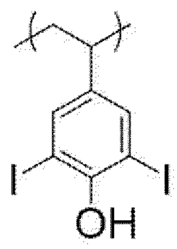
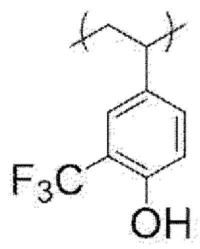
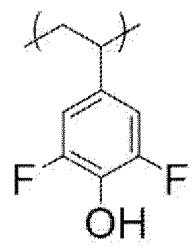
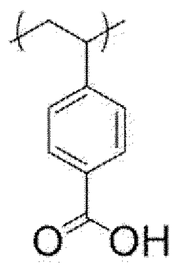
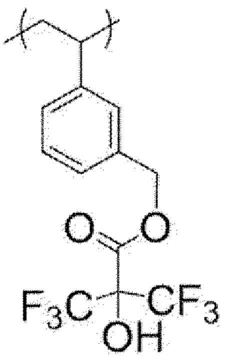
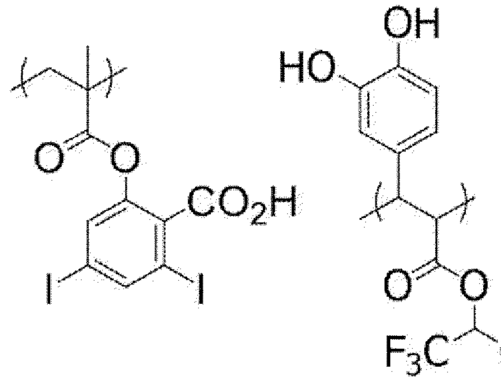

The repeating unit having an acid group may be used alone or in combination of two or more kinds thereof.

A content of the repeating unit having an acid group is preferably 1% to 80% by mole, more preferably 5% to 60% by mole, and still more preferably 10% to 50% by mole with respect to all repeating units of the resin (A).

<Repeating Unit having Lactone Group>

The resin (A) also preferably has a repeating unit having a lactone group.

The repeating unit having a lactone group is preferably a repeating unit different from the above-described repeating units.

In addition, the repeating unit having a lactone group may also serve as the above-described repeating unit (for example, the repeating unit having an acid-decomposable group).

It is sufficient that the lactone group has a lactone structure. The lactone structure is preferably a 5- to 7-membered ring lactone structure. Among these, those in which another ring structure is fused to the 5- to 7-membered ring lactone structure to form a bicyclo structure or a spiro structure are more preferable.

It is preferable that the resin (A) has a repeating unit having a lactone group, which is obtained by abstracting one or more (for example, one or two) hydrogen atoms from a lactone structure represented by any of Formulae (LC1-1) to (LC1-21).

In addition, the lactone group may be bonded directly to the main chain. For example, a ring member atom of the lactone group may constitute the main chain of the resin (A).

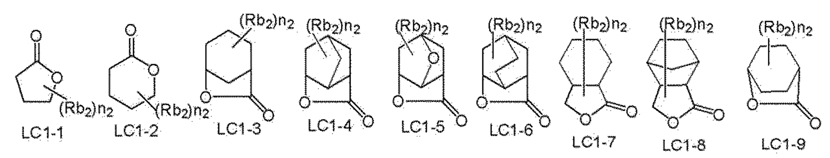
LC1-1 LC1-2 LC1-3 LC1-4 LC1-5 LC1-6 LC1-7 LC1-8 LC1-9

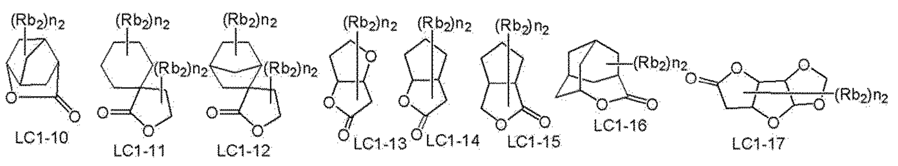
LC1-10 LC1-11 LC1-12 LC1-13 LC1-14 LC1-15 LC1-16 LC1-17

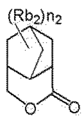 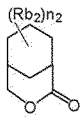 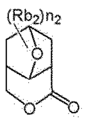 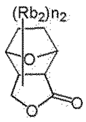

LC1-18 LC1-19 LC1-20 LC1-21

The above-described lactone structures may have a substituent ($Rb_2$). Examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, a cyano group, a group including an acid-decomposable group (acid-decomposable group itself may be used), a group including the specific functional group (specific functional group itself may be used), and a group consisting of a combination of these groups. n2 represents an integer of 0 to 4. In a case where n2 is 2 or more, a plurality of $Rb_2$'s may be different from each other, and the plurality of $Rb_2$'s may be bonded to each other to form a ring.

One or more (for example, one or two) methylene groups not adjacent to -COO- or -O- in the ring member atoms of the above-described lactone structure may be replaced with a heteroatom such as -O- and -S-.

Examples of the repeating unit having a lactone group include a repeating unit represented by General Formula (AI).

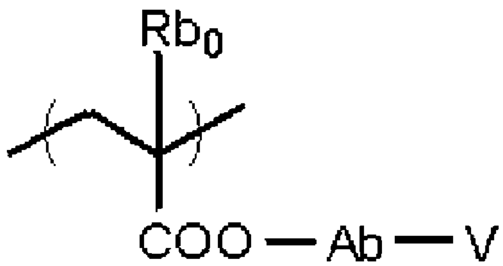

(AI)

In General Formula (AI), $Rb_0$ represents a hydrogen atom, a halogen atom, or an alkyl group having 1 to 4 carbon atoms.

Preferred examples of the substituent which may be contained in the alkyl group of $Rb_0$ include a hydroxyl group and a halogen atom.

Examples of the halogen atom of $Rb_0$ include a fluorine atom, a chlorine atom, a bromine atom, and an iodine atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent group formed by a combination thereof. Among these, a single bond or a linking group represented by $-Ab_1-CO_2-$ is preferable. Abi is a linear or branched alkylene group, or a monocyclic or polycyclic cycloalkylene group, and is preferably a methylene group, an ethylene group, a cyclohexylene group, an adamantylene group, or a norbornylene group.

V represents a group formed by extracting one hydrogen atom from ring member atoms of the lactone structure represented by any of Formulae (LC1-1) to (LC1-21).

The repeating unit having a lactone group may be, for example, a repeating unit represented by General Formula (AII) or (AIII).

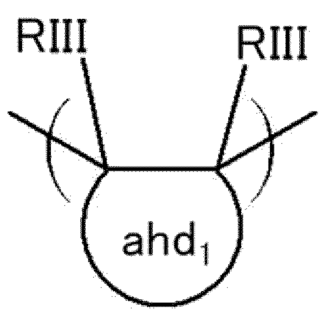

(AII)

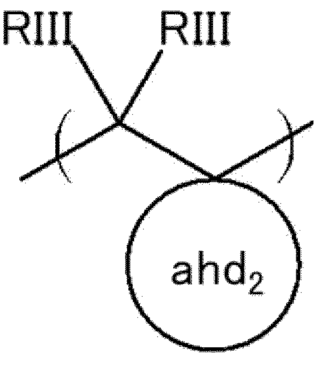

(AIII)

In General Formulae (AII) and (AIII), RIII's each independently represent a hydrogen atom or a substituent.

RIII is preferably a hydrogen atom.

In General Formula (AII), ahdi represents a group obtained by abstracting one hydrogen atom from each of adjacent ring member atoms of the lactone structure represented by any of Formulae (LC1-1) to (LC1-21).

In General Formula (AIII), $ahd_2$ represents a group obtained by abstracting two hydrogen atoms from ring member atoms of the lactone structure represented by any of Formulae (LC1-1) to (LC1-21).

The repeating unit having a lactone group is exemplified below. In the formulae, Rx represents $CH_3$, $CH_2OH$, or $CF_3$.

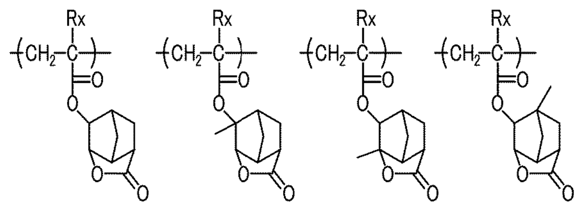

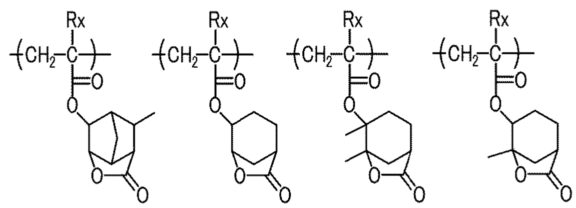

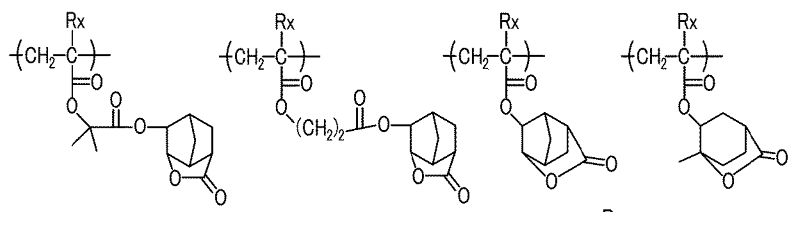

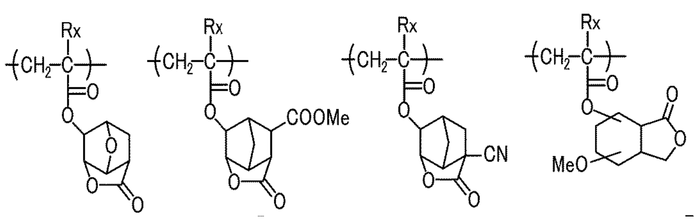

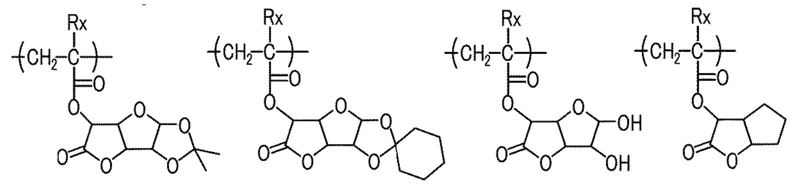

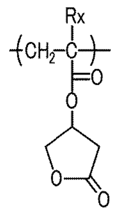 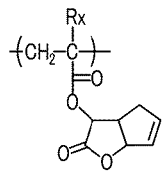 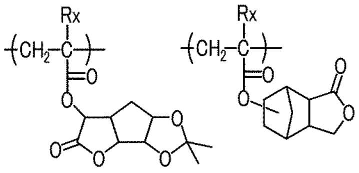 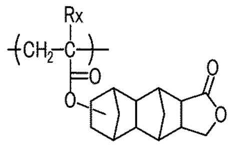

(in the formulae, Rx is H, $CH_3$, $CH_2OH$, or $CF_3$)

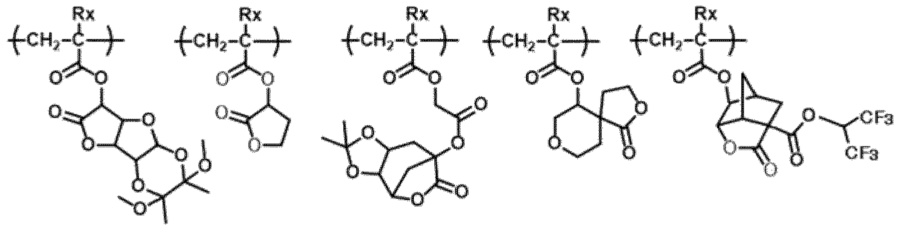

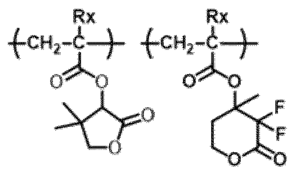 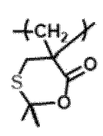 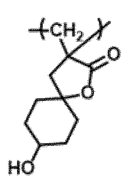 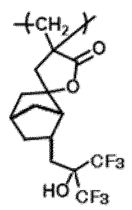

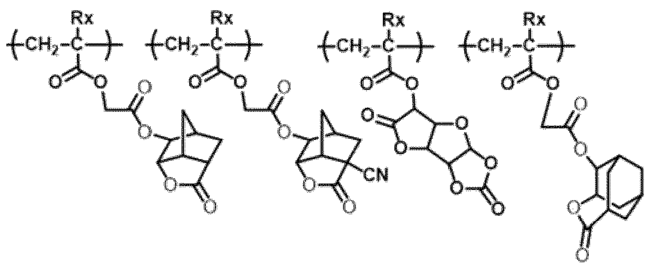 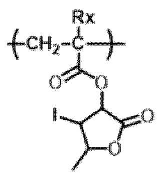

In a case where an optical isomer is present in the repeating unit having a lactone group, any of optical isomers may be used. In addition, one optical isomer may be used alone or a mixture of a plurality of the optical isomers may be used. In a case where one kind of optical isomers is mainly used, an optical purity (ee) thereof is preferably 90 or more, and more preferably 95 or more.

The repeating unit having a lactone group may be used alone or in combination of two or more kinds thereof.

A content of the repeating unit having a lactone group is preferably 1% to 70% by mole, more preferably 3% to 60% by mole, and still more preferably 5% to 50% by mole with respect to all repeating units of the resin (A).

<Repeating Unit having Sultone Group or Carbonate Group>

The resin (A) also preferably has a repeating unit having a sultone group or a carbonate group.

The repeating unit having a sultone group or a carbonate group is preferably a repeating unit different from the above-described repeating units.

It is sufficient that the sultone group has a sultone structure. The sultone structure is preferably a 5- to 7-membered ring sultone structure. Among these, those in which another ring structure is fused to the 5- to 7-membered ring sultone structure to form a bicyclo structure or a spiro structure are more preferable.

In addition, the sultone group may be bonded directly to the main chain. For example, a ring member atom of the sultone group may constitute the main chain of the resin (A).

It is preferable that the resin (A) has a repeating unit having a sultone group, which is obtained by abstracting one or more (for example, one or two) hydrogen atoms from ring member atoms of a sultone structure represented by any of Formulae (SL1-1) to (SL1-3).

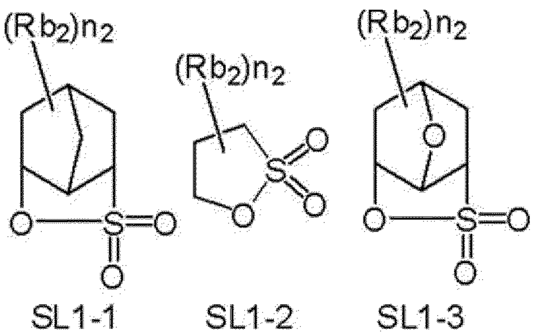

SL1-1 SL1-2 SL1-3

The above-described sultone structures may have a substituent ($Rb_2$). The substituent ($Rb_2$) in Formulae (SL1-1) to (SL1-3) can be described in the same manner as the substituent ($Rb_2$) in the lactone structure represented by Formulae (LC1-1) to (LC1-21) described above.

One or more (for example, one or two) methylene groups not adjacent to -COO- or -O- in the ring member atoms of the above-described sultone structure may be replaced with a heteroatom such as -O- and -S-.

Examples of the repeating unit having a sultone group include a repeating unit in which V in the repeating unit represented by General Formula (AI) described above is replaced with a group obtained by abstracting one hydrogen atom from ring member atoms of the sultone structure represented by any of Formulae (SL1-1) to (SL1-3); a repeating unit in which ahdi in the repeating unit represented by General Formula (AII) described above is replaced with a group obtained by abstracting one hydrogen atom from each of adjacent ring member atoms of the sultone structure represented by any of Formulae (SL1-1) to (SL1-3); and a repeating unit in which $ahd_2$ in the repeating unit represented by General Formula (AIII) described above is replaced with a group obtained by abstracting two hydrogen atoms from ring member atoms of the sultone structure represented by any of Formulae (SL1-1) to (SL1-3).

As the carbonate group, a cyclic carbonate ester group is preferable.

As the repeating unit having a cyclic carbonate ester group, a repeating unit represented by Formula (A-1) is preferable.

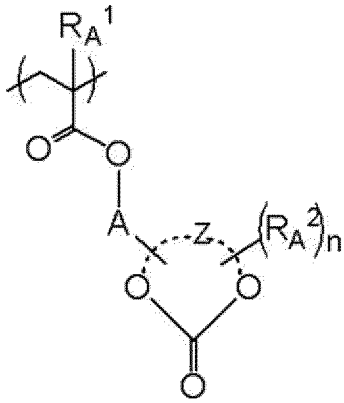

(A-1)

In Formula (A-1), $R_A^1$ represents a hydrogen atom, a halogen atom, or a monovalent organic group (preferably a methyl group).

n represents an integer of 0 or more.

$R_A^2$ represents a substituent. In a case where n is 2 or more, a plurality of $R_A^2$'s may be the same or different from each other.

A represents a single bond or a divalent linking group. As the above-described divalent linking group, an alkylene group, a divalent linking group having a monocyclic or polycyclic alicyclic hydrocarbon structure, an ether group, an

ester group, a carbonyl group, a carboxyl group, or a divalent group formed by a combination thereof is preferable.

Z represents an atomic group which forms a monocycle or polycycle with a group represented by -O-CO-O- in the formula.

The repeating unit having a sultone group or a carbonate group is exemplified below.

(in the formulae, Rx is H, $CH_3$, $CH_2OH$, or $CF_3$)

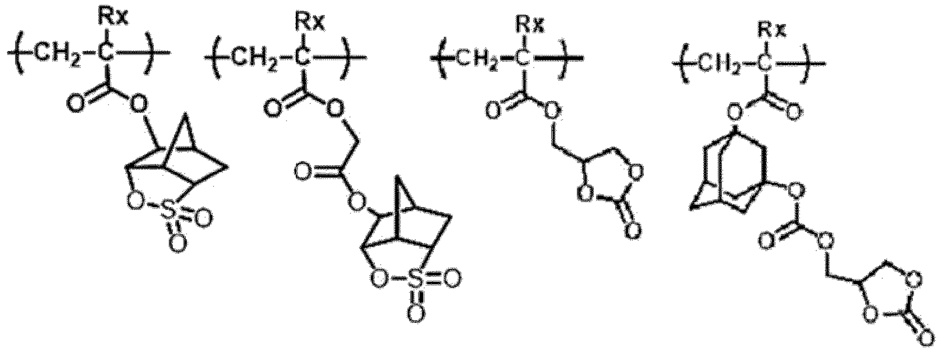

A content of the repeating unit having a sultone group or a carbonate group is preferably 1% by mole or more, and more preferably 10% by mole or more with respect to all the repeating units in the resin (A). In addition, the upper limit value thereof is preferably 85% by mole or less, more preferably 80% by mole or less, still more preferably 70% by mole or less, and particularly preferably 60% by mole or less.

<Repeating Unit having Fluorine Atom or Iodine Atom>

The resin (A) may have a repeating unit having a fluorine atom or an iodine atom.

The repeating unit having a fluorine atom or an iodine atom is preferably a repeating unit different from the above-described repeating units.

As the repeating unit having a fluorine atom or an iodine atom, a repeating unit represented by Formula (C) is preferable.

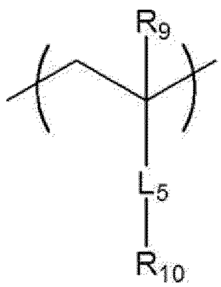

(C)

$L_5$ represents a single bond or an ester group.

$R_9$ represents a hydrogen atom or an alkyl group which may have a fluorine atom or an iodine atom.

$R_{10}$ represents a hydrogen atom, an alkyl group which may have a fluorine atom or an iodine atom, a cycloalkyl group which may have a fluorine atom or an iodine atom, an aryl group which may have a fluorine atom or an iodine atom, or a group formed by a combination thereof.

The repeating unit having a fluorine atom or an iodine atom is exemplified below.

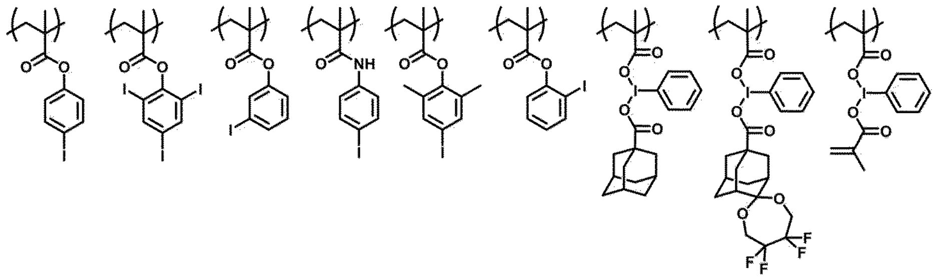

A content of the repeating unit having a fluorine atom or an iodine atom is preferably 0% by mole or more, more preferably 5% by mole or more, and still more preferably 10% by mole or more with respect to all repeating units in the resin (A). In addition, the upper limit value thereof is preferably 50% by mole or less, more preferably 45% by mole or less, and still more preferably 40% by mole or less.

<Repeating Unit represented by Formula (V-1) or Formula (V-2)>

The resin (A) may have a repeating unit represented by Formula (V-1) or Formula (V-2).
The repeating unit represented by Formula (V-1) and Formula (V-2) is preferably a repeating unit different from the above-described repeating units.

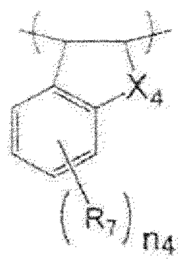

(V-1)

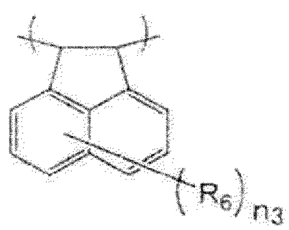

(V-2)

In the formulae,

$R_6$ and $R_7$ each independently represent a hydrogen atom, a hydroxyl group, an alkyl group, an alkoxy group, an acyloxy group, a cyano group, a nitro group, an amino group, a halogen atom, an ester group (-OCOR or -COOR; R is an alkyl group or fluorinated alkyl group having 1 to 6 carbon atoms), or a carboxyl group. As the alkyl group, a linear, branched, or cyclic alkyl group having 1 to 10 carbon atoms is preferable.
$n_3$ represents an integer of 0 to 6.
$n_4$ represents an integer of 0 to 4.
$X^4$ is a methylene group, an oxygen atom, or a sulfur atom.

The repeating unit represented by Formula (V-1) or (V-2) is exemplified below.
Examples of the repeating unit represented by Formula (V-1) or (V-2) include repeating units described in paragraph [0100] of WO2018/193954A.
A content of the repeating unit represented by Formula (V-1) or Formula (V-2) is preferably 1% to 65% by mole, and more preferably 5 to 45 mol with respect to all repeating units in the resin (A).

<Repeating Unit for Reducing Mobility of Main Chain>

The resin (A) may have a repeating unit for reducing mobility of the main chain, as a repeating unit different from the repeating unit a1.
From the viewpoint that excessive diffusion of a generated acid or pattern collapse during development can be suppressed, the resin (A) preferably has a high glass transition temperature (Tg). The Tg is preferably higher than 90°C, more preferably higher than 100°C, still more preferably higher than 110°C, and particularly preferably higher than 125°C. Since an excessively high Tg causes a decrease in dissolution rate in a developer, the Tg is preferably 400°C or lower and more preferably 350°C or lower.

In the present specification, the glass transition temperature (Tg) of a polymer such as the resin (A) is calculated by the following method. First, each Tg of homopolymers consisting of only the respective repeating units included in the polymer is calculated by the Bicerano method. Hereinafter, the Tg calculated is referred to as a "Tg of the repeating unit". Next, the mass proportion (%) of each repeating unit to all repeating units in the polymer is calculated. Next, the Tg at each mass proportion is calculated using a Fox's equation (described in Materials Letters 62 (2008) 3152, and the like), and these are summed to obtain the Tg (°C) of the polymer.

The Bicerano method is described in Prediction of polymer properties, Marcel Dekker Inc., New York (1993), and the like. In addition, the calculation of Tg by the Bicerano method can be carried out using MDL Polymer (MDL Information Systems, Inc.), which is software for estimating physical properties of a polymer.

In order to raise the Tg of the resin (A) (preferably to raise the Tg to higher than 90°C), it is preferable to reduce the mobility of the main chain of the resin (A). Examples of a method for lowering the mobility of the main chain of the resin (A) include the following (a) to (e) methods.

(a) introduction of a bulky substituent into the main chain
(b) introduction of a plurality of substituents into the main chain
(c) introduction of a substituent causing an interaction between the resins (A) into the vicinity of the main chain
(d) formation of the main chain in a cyclic structure
(e) linking of a cyclic structure to the main chain

The resin (A) preferably has a repeating unit in which the homopolymer exhibits a Tg of 130°C or higher.

The type of the repeating unit in which the homopolymer exhibits a Tg of 130°C or higher is not particularly limited, and may be any of repeating units in which the homopolymer exhibits a Tg of 130°C or higher, as calculated by a Bicerano method. It corresponds to a repeating unit having a Tg of a homopolymer exhibiting 130°C or higher, depending on the type of a functional group in the repeating units represented by Formulae (A) to (E), which will be described later.

(Repeating Unit Represented by Formula (A))

As an example of a specific unit for accomplishing (a) above, a method of introducing a repeating unit represented by Formula (A) into the resin (A) may be mentioned.

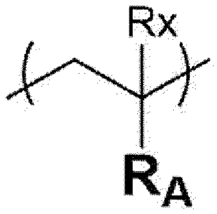

(A)

In Formula (A), $R_A$ represents a group having a polycyclic structure. $R_x$ represents a hydrogen atom, a methyl group, or an ethyl group. The group having a polycyclic structure is a group having a plurality of ring structures, and the plurality of ring structures may or may not be fused.

Specific examples of the repeating unit represented by Formula (A) include repeating units described in paragraphs [0107] to [0119] of WO2018/193954A.

A content of the repeating unit represented by Formula (A) is preferably 1% to 65% by mole, and more preferably 5 to 45 mol with respect to all repeating units in the resin (A).

(Repeating Unit Represented by Formula (B))

As an example of a specific unit for accomplishing (b) above, a method of introducing a repeating unit represented by Formula (B) into the resin (A) may be mentioned.

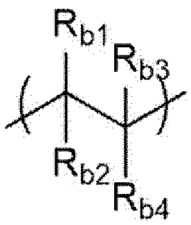

(B)

In Formula (B), $R_{b1}$ to $R_{b4}$ each independently represent a hydrogen atom or an organic group, and at least two or more of $R_{b1}$, ..., or $R_{b4}$ represent an organic group.

In addition, in a case where at least one of the organic groups is a group in which a ring structure is directly linked to the main chain in the repeating unit, the types of the other organic groups are not particularly limited.

In addition, in a case where none of the organic groups is a group in which a ring structure is directly linked to the main chain in the repeating unit, at least two or more of the organic groups are substituents having three or more constituent atoms excluding hydrogen atoms.

Specific examples of the repeating unit represented by Formula (B) include repeating units described in paragraphs [0113] to [0115] of WO2018/193954A.

A content of the repeating unit represented by Formula (B) is preferably 1% to 65% by mole, and more preferably 5 to 45 mol with respect to all repeating units in the resin (A).

(Repeating Unit Represented by Formula (C))

As an example of a specific unit for accomplishing (c) above, a method of introducing a repeating unit represented by Formula (C) into the resin (A) may be mentioned.

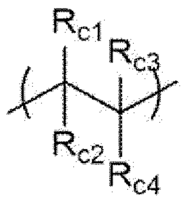

(C)

In Formula (C), $R_{c1}$ to $R_{c4}$ each independently represent a hydrogen atom or an organic group, and at least one of $R_{c1}$, ..., or $R_{c4}$ is a group having a hydrogen-bonding hydrogen atom with the number of atoms of 3 or less from the main chain carbon. Among these, it is preferable that the group has hydrogen-bonding hydrogen atoms with the number of atoms of 2 or less (on a side closer to the vicinity of the main chain) to cause an interaction between the main chains of the resin (A).

Specific examples of the repeating unit represented by Formula (C) include repeating units described in paragraphs [0119] to [0121] of WO2018/193954A.

A content of the repeating unit represented by Formula (C) is preferably 1% to 65% by mole, and more preferably 5 to 45 mol with respect to all repeating units in the resin (A).

(Repeating Unit Represented by Formula (D))

As an example of a specific unit for accomplishing (d) above, a method of introducing a repeating unit represented by Formula (D) into the resin (A) may be mentioned.

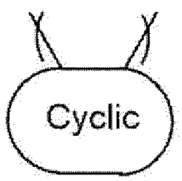

(D)

In Formula (D), "Cyclic" is a group which forms a main chain as a cyclic structure. The number of ring-constituting atoms is not particularly limited.

Specific examples of the repeating unit represented by Formula (D) include repeating units described in paragraphs [0126] and [0127] of WO2018/193954A.

A content of the repeating unit represented by Formula (D) is preferably 1% to 65% by mole, and more preferably 5 to 45 mol with respect to all repeating units in the resin (A).

(Repeating Unit Represented by Formula (E))

As an example of a specific unit for accomplishing (e) above, a method of introducing a repeating unit represented by Formula (E) into the resin (A) may be mentioned.

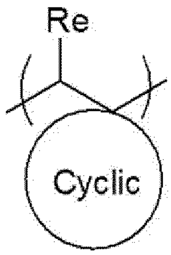

(E)

In Formula (E), Re's each independently represent a hydrogen atom or an organic group. Examples of the organic group include an alkyl group, a cycloalkyl group, an aryl group, an aralkyl group, and an alkenyl group, which may have a substituent.

"Cyclic" is a cyclic group including a carbon atom of a main chain. The number of atoms included in the cyclic group is not particularly limited.

Specific examples of the repeating unit represented by Formula (E) include repeating units described in paragraphs [0131] to [0133] of WO2018/193954A.

A content of the repeating unit represented by Formula (E) is preferably 1% to 65% by mole, and more preferably 5 to 45 mol with respect to all repeating units in the resin (A).

<Repeating Unit having Hydroxyl Group or Cyano Group>

The resin (A) may have a repeating unit having a hydroxyl group or a cyano group. As a result, adhesiveness to the substrate and affinity for a developer are improved.

The repeating unit having a hydroxyl group or a cyano group is preferably a repeating unit different from the above-described repeating units (particularly, the repeating unit having an acid group).

The repeating unit having a hydroxyl group or a cyano group is preferably a repeating unit having an alicyclic hydrocarbon structure substituted with a hydroxyl group or a cyano group.

It is preferable that the repeating unit having a hydroxyl group or a cyano group does not have the acid-decomposable group. Examples of the repeating unit having a hydroxyl group or a cyano group include repeating units described in paragraphs [0153] to [0158] of WO2020/004306A.

A content of the repeating unit having a hydroxyl group or a cyano group is preferably 1% to 65% by mole, and more preferably 5 to 45 mol with respect to all repeating units in the resin (A).

<Repeating Unit having Alicyclic Hydrocarbon Structure and Not Exhibiting Acid Decomposability>

The resin (A) may have a repeating unit having an alicyclic hydrocarbon structure and not exhibiting acid decomposability.

The repeating unit having an alicyclic hydrocarbon structure and not exhibiting acid decomposability is preferably a repeating unit different from the above-described repeating units.

As a result, it is possible to reduce elution of low-molecular-weight components from the resist film into the immersion liquid during liquid immersion exposure. Examples of such a repeating unit include a repeating unit derived from 1-adamantyl (meth)acrylate, diadamantyl (meth)acrylate, tricyclodecanyl (meth)acrylate, or cyclohexyl (meth)acrylate.

A content of the repeating unit having an alicyclic hydrocarbon structure and not exhibiting acid decomposability is preferably 1% to 65% by mole, and more preferably 5 to 45 mol with respect to all repeating units in the resin (A).

<Repeating Unit Represented by Formula (III) having Neither Hydroxyl Group Nor Cyano Group>

The resin (A) may have a repeating unit represented by Formula (III), which has neither a hydroxyl group nor a cyano group.

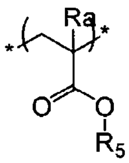
(III)

In Formula (III), $R_5$ represents a hydrocarbon group having at least one cyclic structure and having neither a hydroxyl group nor a cyano group.

Ra represents a hydrogen atom, an alkyl group, or a -CHz-O-Raz group. In the formula, $Ra_2$ represents an alkyl group or an acyl group.

The cyclic structure included in $R_5$ includes a monocyclic hydrocarbon group and a polycyclic hydrocarbon group. Examples of the monocyclic hydrocarbon group include a cycloalkyl group having 3 to 12 carbon atoms (more preferably having 3 to 7 carbon atoms) and a cycloalkenyl group having 3 to 12 carbon atoms.

Examples of detailed definitions of each group in Formula (III) and specific examples of the repeating unit include those described in paragraphs [0169] to [0173] of WO2020/004306A.

A content of the repeating unit represented by Formula (III), which has neither a hydroxyl group nor a cyano group, is preferably 1% to 65% by mole, and more preferably 5 to 45 mol with respect to all repeating units in the resin (A).

<Other Repeating Units>

Furthermore, the resin (A) may have a repeating unit other than the above-described repeating units.

For example, the resin (A) may have a repeating unit selected from the group consisting of a repeating unit having an oxathiane ring group, a repeating unit having an oxazolone ring group, a repeating unit having a dioxane ring group, a repeating unit having a hydantoin ring group, and a repeating unit having a sulfolane ring group.

A content of other repeating units is preferably 1% to 65% by mole, and more preferably 5 to 45 mol with respect to all repeating units in the resin (A).

Such repeating units are exemplified below.

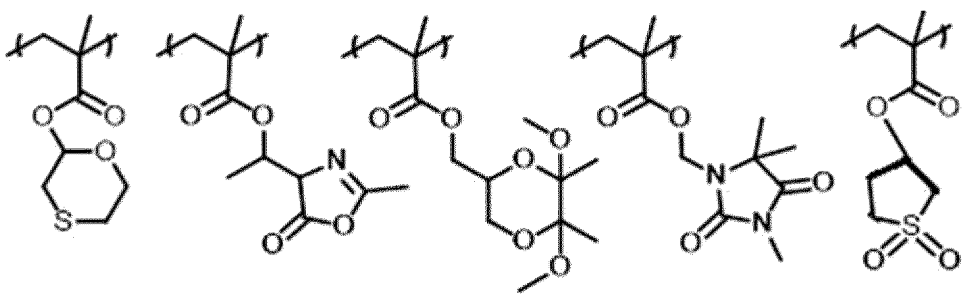

For the purpose of controlling dry etching resistance, suitability for a standard developer, substrate adhesiveness, resist profile, resolving power, heat resistance, sensitivity, and the like, the resin (A) may have various repeating structural units in addition to the repeating structural units described above.

The resin (A) can be synthesized in accordance with an ordinary method (for example, a radical polymerization).

A weight-average molecular weight of the resin (A) as a value expressed in terms of polystyrene by a GPC method is preferably 1,000 to 200,000, more preferably 3,000 to 20,000, and still more preferably 5,000 to 15,000. By setting the weight-average molecular weight of the resin (A) within the above-described range, deterioration of heat resistance and dry etching resistance can be further suppressed. In addition, deterioration of developability and deterioration of film-forming properties due to high viscosity can also be further suppressed.

A dispersity (molecular weight distribution) of the resin (A) is usually 1.0 to 5.0, and preferably 1.0 to 3.0, more preferably 1.2 to 3.0, and still more preferably 1.2 to 2.0. As the dispersity is smaller, resolution and resist shape are more excellent, and a side wall of a resist pattern is smoother and roughness is also more excellent.

The resin (A) may be used alone or in combination of two or more kinds thereof.

In the resist composition, a content of the resin (A) is preferably 10% to 99.9% by mass, more preferably 60% to 99.5% by mass, and still more preferably 80% to 99% by mass with respect to the total solid content of the composition.
In the resist composition, a molar amount of the repeating unit (a) is preferably 0.50 to 5.00 mmol/g, more preferably 0.70 to 3.00 mmol/g, and still more preferably 1.00 to 2.50 mmol/g with respect to the total solid content of the resist composition.
The above-described molar amount of the repeating unit (a) can be appropriately adjusted by appropriately setting the content of the resin (A) with respect to the total solid content of the resist composition and the content of the repeating unit (a) with respect to all repeating units of the resin (A).
The solid content is intended to be components which form the resist film, and does not include a solvent. In addition, even in a case where a component is liquid, the component is included in the solid content as long as the component forms the resist film.
In a case where the resist composition does not contain a compound which generates an acid by irradiation with actinic ray or radiation, the molar amount of the repeating unit (a) with respect to the total solid content of the resist composition is 0.50 mmol/g or more, preferably 0.70 mmol/g or more and more preferably 1.00 mmol/g or more. The upper limit of the above-described molar amount is, for example, 5.00 mmol/g or less, preferably 3.00 mmol/g or less and more preferably 2.50 mmol/g or less.
In a case where the resist composition contains the compound which generates an acid by irradiation with actinic ray or radiation, the total molar amount of the repeating unit (a) and the compound (compound which generates an acid by irradiation with actinic ray or radiation) with respect to the total solid content of the resist composition is 0.50 mmol/g or more, preferably 0.70 mmol/g or more and more preferably 1.00 mmol/g or more. The upper limit of the above-described total molar amount is, for example, 5.00 mmol/g or less, preferably 3.00 mmol/g or less and more preferably 2.50 mmol/g or less.
In the resist composition, the molar amount of the repeating unit (a) with respect to the total molar amount of the repeating unit (a) and the compound which generates an acid by irradiation with actinic ray or radiation is preferably 5% to 100% by mole, more preferably 15% to 99% by mole, and still more preferably 25% to 90% by mole.
The compound which generates an acid by irradiation with actinic ray or radiation will be described later.

[Basic Compound]

The resist composition according to the embodiment of the present invention contains a basic compound.
The pKa of a conjugate acid of the above-described basic compound is 13.00 or less, preferably 7.00 or less. In addition, the lower limit of the pKa of the above-described conjugate acid is preferably 3.00 or more and more preferably 4.00 or more.
The basic compound can also act as a quencher which suppresses a reaction of the resin (A) in the non-exposed portion due to excessively generated acids by trapping the acids generated from the photoacid generator and the like upon exposure.
The basic compound is preferably a compound including a nitrogen atom.
In addition, the basic compound is preferably a compound having an aromatic ring group or a non-ionic compound, more preferably a non-ionic compound having an aromatic ring group, and still more preferably a non-ionic amine compound having an aromatic ring group.
The non-ionic compound means, for example, a compound which does not correspond to an onium salt compound and an intramolecular salt (betaine compound).
The basic compound is preferably a compound having a structure represented by General Formulae (A) to (E).

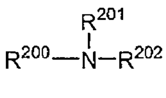
(A)

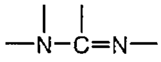
(B)

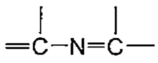
(C)

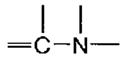
(D)

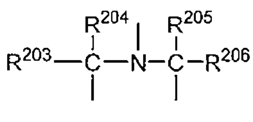
(E)

In General Formula (A), $R^{200}$, $R^{201}$, and $R^{202}$ each independently represent a hydrogen atom, an alkyl group (preferably having 1 to 20 carbon atoms), a cycloalkyl group (preferably having 3 to 20 carbon atoms), or an aryl group (having 6 to 20 carbon atoms). $R^{201}$ and $R^{202}$ may be bonded to each other to form a ring.
In General Formula (E), $R^{201}$, $R^{204}$, $R^{205}$, and $R^{206}$ each independently represent an alkyl group having 1 to 20 carbon atoms.
The alkyl groups in General Formulae (A) and (E) may have a substituent or may be unsubstituted.
With regard to the above-described alkyl group, an alkyl group having a substituent is preferably an aminoalkyl

group having 1 to 20 carbon atoms, a hydroxyalkyl group having 1 to 20 carbon atoms, or a cyanoalkyl group having 1 to 20 carbon atoms.

The alkyl groups in General Formulae (A) and (E) are more preferably unsubstituted.

The basic compound is preferably thiazole, benzothiazole, imidazole, benzimidazole, oxazole, benzoxazole, guanidine, aminopyrrolidine, pyrazole, pyrazoline, piperazine, morpholine, aminomorpholine, aminoalkylmorpholine, piperidine, aniline, or a compound having these structures; and more preferably a compound having a thiazole structure, a benzothiazole structure, an imidazole structure, a benzimidazole structure, an oxazole structure, a benzoxazole structure, a diazabicyclo structure, a morpholine structure, an onium hydroxide structure, an onium carboxylate structure, a trialkylamine structure, an aniline structure, or a pyridine structure, an alkylamine derivative having a hydroxyl group and/or an ether bond, or an aniline derivative having a hydroxyl group and/or an ether bond.

In addition, examples of the basic compound include a basic compound (DB) in which basicity decreases or disappears by irradiation with actinic ray or radiation, an ionic compound (DC) which generates a weak acid, a low-molecular-weight compound (DD) which has a nitrogen atom and has a group eliminated by action of acid, and an onium salt compound (DE) which has a nitrogen atom in a cationic moiety.

Moreover, known basic compounds can be used as the basic compound. For example, as the acid diffusion control agent, known compounds described in paragraphs [0627] to [0664] of US2016/0070167A1, paragraphs [0095] to [0187] of US2015/0004544A1, paragraphs [0403] to [0423] of US2016/0237190A1, and paragraphs [0259] to [0328] of US2016/0274458A1 can also be suitably used as the basic compound as long as the compounds correspond to a compound which can be used as the basic compound in the resist composition according to the embodiment of the present invention.

The basic compound (DB) (hereinafter, also referred to as a "compound (DB)") in which basicity decreases or disappears by irradiation with actinic ray or radiation is a compound which has a proton-accepting functional group and is decomposed by the irradiation with actinic ray or radiation, so that proton-accepting properties decrease or disappear, or are changed to acid property.

The proton-accepting functional group refers to a functional group having a group or electron capable of electrostatically interacting with a proton, and for example, means a functional group with a macrocyclic structure, such as a cyclic polyether, or a functional group having a nitrogen atom having an unshared electron pair not contributing to $\pi$-conjugation. For example, the nitrogen atom having the unshared electron pair, which does not contribute to the $\pi$-conjugation, is a nitrogen atom having a partial structure represented by the following formula.

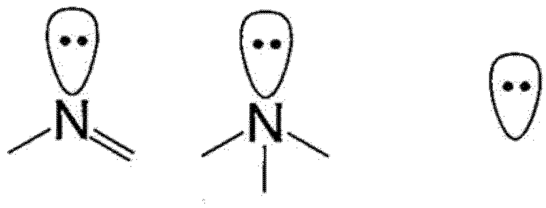

unshared electron pair

Preferred examples of the partial structure of the proton-accepting functional group include a crown ether structure, an azacrown ether structure, primary to tertiary amine structures, a pyridine structure, an imidazole structure, and a pyrazine structure.

The compound (DB) is decomposed by irradiation with actinic ray or radiation to generate a compound exhibiting deterioration in proton-accepting properties, no proton-accepting properties, or a change from the proton-accepting properties to acidic properties. Here, the decrease or disappearance of proton-accepting properties, or the change from proton-accepting properties to acid property is a change in proton-accepting properties due to the proton being added to the proton-accepting functional group, and specifically means that, in a case where a proton adduct is generated from the compound (DB) having the proton-accepting functional group and the proton, the equilibrium constant in chemical equilibrium thereof decreases.

The proton-accepting properties can be confirmed by performing a pH measurement.

As an acid dissociation constant pKa of a compound generated by decomposition of the compound (DB) by the irradiation with actinic ray or radiation, it is preferable to satisfy pKa < -1, it is more preferable to satisfy -13 < pKa < -1, and it is still more preferable to satisfy -13 < pKa < -3.

The ionic compound (DC) (also simply referred to as "ionic compound (DC)") which generates a weak acid is preferably a compound in which the acid generated from the repeating unit (a) and/or the photoacid generator described later by irradiation with actinic ray or radiation collides with the ionic compound (DC) having an unreacted weak acid anion to release the weak acid by salt exchange and generate an onium salt having a strong acid anion. In this process, since the strong acid is exchanged for the weak acid having a lower catalytic ability, the acid is apparently deactivated

and the acid diffusion can be controlled.

As the ionic compound (DC), a compound represented by General Formulae (d1-1) to (d1-3) is preferable.

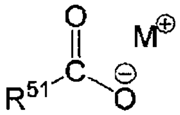

(d1-1)

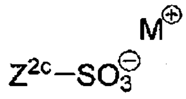

(d1-2)

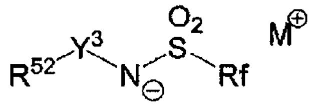

(d1-3)

In Formula (d1-1), $R^{51}$ represents a hydrocarbon group which may have a substituent (for example, a hydroxyl group and/or a fluorine atom). Examples of the above-described hydrocarbon group include an alkyl group (which may be linear or branched; preferably having 6 to 15 carbon atoms) and an aryl group (which may be monocyclic or polycyclic; preferably having 6 to 15 carbon atoms).

In Formula (d1-2), $Z^{2c}$ represents a hydrocarbon group having 1 to 30 carbon atoms, which may have a substituent. However, in the above-described hydrocarbon group, it is preferable that an $\alpha$-carbon and/or $\beta$-carbon with respect to a sulfur atom in $-SO_3^-$ is not bonded to a fluorine atom.

The above-described divalent hydrocarbon group in $Z^{2c}$ may be linear or branched, may have a cyclic structure. In addition, carbon atoms in the above-described hydrocarbon group (preferably, carbon atoms forming a cyclic structure in a case where the above-described hydrocarbon group has a cyclic structure) may be a carbonyl carbon (-CO-). Examples of the hydrocarbon group include a group having a norbornyl group which may have a substituent. Carbon atoms forming the above-described norbornyl group may be replaced with a carbonyl carbon.

It is also preferable that the above-described hydrocarbon group in $Z^{2c}$ is an aryl group. The above-described aryl group may be monocyclic or polycyclic, and the number of carbon atoms therein is preferably 6 to 15. It is also preferable that the above-described aryl group has a group having a nitrogen atom as a substituent.

In Formula (d1-3), $R^{52}$ represents an organic group. The above-described organic group is preferably an alkyl group, and more preferably an alkyl group having 1 to 10 carbon atoms. The above-described alkyl group may be linear or branched, and may have a cyclic structure. As a substituent which may be included in the above-described alkyl group, a fluorine atom is preferable. The above-described alkyl group may be a perfluoroalkyl group.

$Y^3$ represents a single bond, -CO-, an alkylene group, or an arylene group. The above-described alkylene group may be linear or branched, and may have a cyclic structure. The number of carbon atoms in the above-described alkylene group is preferably 1 to 7. The number of carbon atoms in the above-described arylene group is preferably 6 to 15.

Rf represents a hydrocarbon group. The number of carbon atoms in the above-described hydrocarbon group is preferably 1 to 30. The above-described hydrocarbon group may be linear or branched, and may have a cyclic structure. In addition, carbon atoms in the above-described hydrocarbon group (preferably, carbon atoms forming a cyclic structure in a case where the above-described hydrocarbon group has a cyclic structure) may be a carbonyl carbon (-CO-). Examples of the hydrocarbon group include a group having a norbornyl group which may have a substituent. Carbon atoms forming the above-described norbornyl group may be a carbonyl carbon. As the above-described hydrocarbon group, an alkyl group such as a methyl group is also preferable.

Examples of the substituent which may be included in the above-described hydrocarbon group include a fluorine atom.

In each formula, $M^+$'s each independently represent an ammonium cation, a sulfonium cation, or an iodonium cation.

Preferred examples of the sulfonium cation or iodonium cation represented by $M^+$ include a sulfonium cation exemplified in General Formula (ZaI) described later and an iodonium cation exemplified in General Formula (ZaII) described later.

The ionic compound (DC) may be a compound (hereinafter, also referred to as "compound (DCA)") having a cationic moiety and an anionic moiety in the same molecule, in which the cationic moiety and the anionic moiety are linked by a covalent bond.

As the compound (DCA), a compound represented by any of General Formulae (C-1) to (C-3) is preferable.

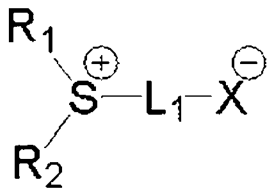
(C-1)

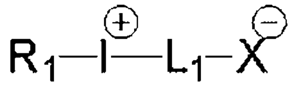
(C-2)

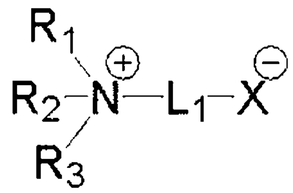
(C-3)

In General Formulae (C-1) to (C-3),

$R_1$, $R_2$, and $R_3$ each independently represent a substituent having 1 or more carbon atoms,
$L_1$ represents a divalent linking group or a single bond, which links the cationic moiety and the anionic moiety,
$-X^-$ represents an anionic moiety selected from $-COO^-$, $-SO_3^-$, $-SO_2^-$, or $-N^--R_4$, $R_4$ represents a monovalent substituent having at least one of a carbonyl group (-C(=O)-), a sulfonyl group ($-S(=O)_2-$), or a sulfinyl group (-S(=O)-) at a linking site with an adjacent N atom, and
$R_1$, $R_2$, $R_3$, $R_4$, and $L_1$ may be bonded to each other to form a ring structure. In addition, in General Formula (C-3), two of $R_1$ to $R_3$ together represent one divalent substituent, which may be bonded to an N atom by a double bond.

Examples of the substituent having 1 or more carbon atoms in $R_1$ to $R_3$ include an alkyl group, a cycloalkyl group, an aryl group, an alkyloxycarbonyl group, a cycloalkyloxycarbonyl group, an aryloxycarbonyl group, an alkylaminocarbonyl group, a cycloalkylaminocarbonyl group, and an arylaminocarbonyl group, and an alkyl group, a cycloalkyl group, or an aryl group is preferable.

Examples of $L_1$ as the divalent linking group include an alkylene group (which may be linear or branched), a cycloalkylene group, an arylene group, a carbonyl group, an ether bond, an ester bond, an amide bond, a urethane bond, a urea bond, and a group formed by combining two or more thereof. $L_1$ is preferably an alkylene group, an arylene group, an ether bond, an ester bond, or a group formed by combining two or more thereof.

As the low-molecular-weight compound (DD) (hereinafter, also referred to as "compound (DD)") which has a nitrogen atom and has a group eliminated by action of acid, an amine derivative having the group eliminated by action of acid is preferable.

The group which is eliminated by action of acid is preferably an acetal group, a carbonate group, a carbamate group, a tertiary ester group, a tertiary hydroxyl group, or a hemiaminal ether group, and more preferably a carbamate group or a hemiaminal ether group.

A molecular weight of the compound (DD) is preferably 100 to 1,000, more preferably 100 to 700, and still more preferably 100 to 500.

The compound (DD) may have a carbamate group having a protective group on a nitrogen atom. Examples of the protective group constituting the carbamate group include a group represented by General Formula (d-1).

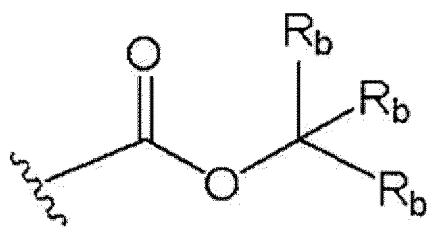
(d-1)

In General Formula (d-1),
Rb's each independently represent a hydrogen atom, an alkyl group (preferably having 1 to 10 carbon atoms), a cycloalkyl group (preferably having 3 to 30 carbon atoms), an aryl group (preferably having 6 to 30 carbon atoms), an aralkyl group (preferably having 1 to 10 carbon atoms), or an alkoxyalkyl group (preferably having 1 to 10 carbon atoms). Two Rb's may be bonded to each other to form a ring.

The alkyl group, the cycloalkyl group, the aryl group, and the aralkyl group represented by Rb may be each independently substituted with a functional group such as a hydroxyl group, a cyano group, an amino group, a pyrrolidino group, a piperidino group, a morpholino group, and an oxo group, an alkoxy group, or a halogen atom. The same applies to the alkoxyalkyl group represented by Rb.

Rb is preferably a linear or branched alkyl group, a cycloalkyl group, or an aryl group, and more preferably a

linear or branched alkyl group or a cycloalkyl group.

Examples of the ring formed by bonding two Rb's to each other include an alicyclic hydrocarbon, an aromatic hydrocarbon, a heterocyclic hydrocarbon, and a derivative thereof.

Examples of a specific structure of the group represented by General Formula (d-1) include a structure described in paragraph [0466] of US2012/0135348A1, but the structure thereof is not limited thereto.

The compound (DD) is preferably a structure represented by General Formula (6).

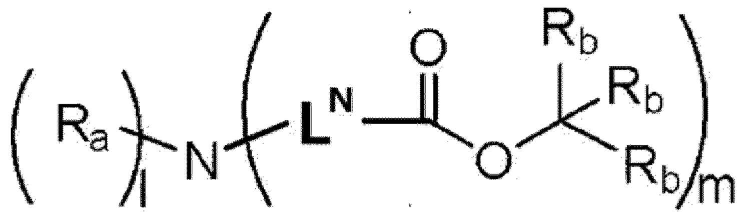

(6)

In General Formula (6),

l represents an integer of 0 to 2, m represents an integer of 1 to 3, and l + m satisfies 3.

Ra represents a hydrogen atom, an alkyl group, a cycloalkyl group, an aryl group, or an aralkyl group. In a case where l is 2, two Ra's may be the same or different from each other, and two Ra's may be linked to each other to form a hetero ring with the nitrogen atom in the formula. The hetero ring may include a heteroatom other than the nitrogen atom in the formula.

$L^N$ represents a single bond or a divalent linking group. The above-described divalent linking group is preferably an alkylene group (which may be linear or branched, and the number of carbon atoms is, for example, 1 to 6).

Rb has the same meaning as Rb in General Formula (d-1) described above, and the preferred examples are also the same.

In General Formula (6), the alkyl group, the cycloalkyl group, the aryl group, and the aralkyl group as Ra may be each independently substituted with a group same as the above-described group which may be substituted on the alkyl group, the cycloalkyl group, the aryl group, and the aralkyl group as Rb.

Specific examples of the alkyl group, the cycloalkyl group, the aryl group, and the aralkyl group (these groups may be substituted with the above-described group) of Ra include a group same as in the specific examples described above for Rb.

Specific examples of the compound (DD) which is particularly preferable in the present invention include a compound described in paragraph [0475] of US2012/0135348A1, but the compound (DD) is not limited thereto.

The onium salt compound (DE) (hereinafter, also referred to as "compound (DE)") which has a nitrogen atom in a cationic moiety is preferably a compound having, in the cationic moiety, a basic site containing a nitrogen atom. The basic site is preferably an amino group, and more preferably a nitrogen-containing aromatic ring group (pyridine ring or the like) or an aliphatic amino group.

The above-described nitrogen-containing aromatic ring group is an aromatic ring group having one or more (for example, one to three) nitrogen atoms as ring member atoms. The above-described nitrogen-containing aromatic ring group may be monocyclic or polycyclic, the number of ring member atoms is, for example, 5 to 15, and it may or may not have a heteroatom other than the nitrogen atom. Examples of the above-described nitrogen-containing aromatic ring group include a pyridine ring group.

It is still more preferable that all of atoms adjacent to the nitrogen atom in the basic site are hydrogen atoms or carbon atoms. In addition, from the viewpoint of improving basicity, it is preferable that an electron-withdrawing functional group (a carbonyl group, a sulfonyl group, a cyano group, a halogen atom, or the like) is not directly connected to the nitrogen atom.

Preferred specific examples of the compound (DE) include a compound described in paragraph [0203] of US2015/0309408A1, but the compound (DE) is not limited thereto.

As the basic compound, compounds described in paragraphs [0204] to [0206] of WO2018/193954A can also be used as long as the compounds correspond to the basic compound in the resist composition according to the embodiment of the present invention.

The basic compound may be used alone or in combination of two or more kinds thereof.

A content of the basic compound is preferably 0.001% to 20% by mass, more preferably 0.01% to 15% by mass, and still more preferably 0.05% to 7% by mass with respect to the total solid content of the resist composition.

[Compound which Generates Acid by Irradiation with Actinic Ray or Radiation (Photoacid Generator)]

The resist composition according to the embodiment of the present invention may contain a compound which

generates an acid by irradiation with actinic ray or radiation, which is a component different from the above-described component.

The acid generated from the compound which generates an acid by irradiation with actinic ray or radiation is an acid generated separately from the acid generated from the repeating unit (a) in the resin (A) described above.

Hereinafter, the compound which generates an acid by irradiation with actinic ray or radiation is also referred to as a photoacid generator.

In addition, a repeating unit generating an acid by irradiation with actinic ray or radiation, which is different from the repeating unit (a) and is in a resin (may be the resin (A)) contained in the resist composition, may also be used as the photoacid generator.

The photoacid generator in the present specification is a compound different from the above-described basic compound.

Specifically, even in a compound having a property of generating an acid by irradiation with actinic ray or radiation, as long as a pKa of a conjugate acid thereof is in the range of 3.00 to 13.00, the compound is classified as the above-described basic compound, and is not included in the photoacid generator.

The photoacid generator is preferably a low-molecular-weight compound, and a molecular weight thereof is preferably 3,000 or less, more preferably 2,000 or less, and still more preferably 1,000 or less. The lower limit of the above-described molecular weight is, for example, 100 or more.

The photoacid generator is not particularly limited, but a compound which generates an organic acid by irradiation with actinic ray or radiation (preferably, electron beam or extreme ultraviolet ray) or by heating is preferable.

As the above-described organic acid, for example, at least any one of sulfonic acid, bis(alkylsulfonyl)imide, or tris(alkylsulfonyl)methide is preferable.

The photoacid generator may be an ionic compound or a non-ionic compound.

<Photoacid Generator which is Ionic Compound>

The photoacid generator which is an ionic compound may be a photoacid generator which is an onium salt or a photoacid generator which is an intramolecular salt (betaine compound).

(Photoacid Generator which is Onium Salt)

The photoacid generator which is an onium salt usually has a cationic moiety and an anionic moiety.

Examples of the photoacid generator which is an onium salt include a compound represented by "$M^{p+}{}_m X^{q-}{}_n$".

In the "$M^{p+}{}_m X^{q-}{}_n$", p, q, m, and n each independently represent an integer of 1 or more (preferably 1 to 8).

$M^{p+}$ represents an organic cation having a charge of p. The organic cation may include the cationic moiety as a part, or may be the cationic moiety itself. It is preferable that the organic cation is the cationic moiety itself.

$X^{q-}$ represents an organic anion having a charge of q. The organic anion may include the anionic moiety as a part, or may be the anionic moiety itself. It is preferable that the organic anion includes the anionic moiety as a part.

In a case where a plurality of $M^{p+}$'s or $X^{q-}$'s are present, $M^{p+}$'s or $X^{q-}$'s may be the same or different from each other.

A value obtained by multiplying an average value of p's in the plurality of $M^{p+}$'s by m and a value obtained by multiplying an average value of q's in the plurality of $X^{q-}$'s by n are the same.

Among these, p is preferably 1.

For example, it is preferable that p, q, m, and n are all 1.

In addition, it is also preferable that p is 1, q is 2 to 8, m is the same value as q, and n is 1.

· Organic Cation

The cationic moiety is a structural moiety including a positively charged atom or atomic group, and for example, an organic cation having a charge of 1 is preferable.

The organic cations are each independently preferably an organic cation (cation (ZaI)) represented by Formula (ZaI) or an organic cation (cation (ZaII)) represented by Formula (ZaII).

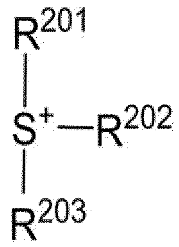

(ZaI)

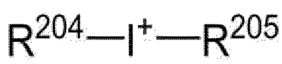

(ZaII)

In Formula (ZaI),
$R^{201}$, $R^{202}$, and $R^{203}$ each independently represent an organic group.

The number of carbon atoms in the organic group of $R^{201}$, $R^{202}$, and $R^{203}$ is usually 1 to 30, and preferably 1 to 20. In addition, two of $R^{201}$ to $R^{203}$ may be bonded to each other to form a ring structure, and the ring structure may include an oxygen atom, a sulfur atom, an ester group, an amide group, or a carbonyl group in the ring. Examples of the group formed by the bonding of two of $R_{201}$ to $R_{203}$ include an alkylene group (for example, a butylene group and a pentylene group) and $-CH_2-CH_2-O-CH_2-CH_2-$.

Examples of suitable aspects of the organic cation in Formula (ZaI) include a cation (ZaI-1), a cation (ZaI-2), an organic cation (cation (ZaI-3b)) represented by Formula (ZaI-3b), and an organic cation (cation (ZaI-4b)) represented by Formula (ZaI-4b), each of which will be described below.

First, the cation (ZaI-1) will be described.

The cation (ZaI-1) is an arylsulfonium cation in which at least one of $R^{201}$, $R^{202}$, or $R^{203}$ of Formula (ZaI) described above is an aryl group.

In the arylsulfonium cation, all of $R_{201}$ to $R_{203}$ may be aryl groups, or some of $R_{201}$ to $R_{203}$ may be an aryl group and the rest may be an alkyl group or a cycloalkyl group.

In addition, one of $R_{201}$ to $R_{203}$ may be an aryl group, the remaining two of $R^{201}$ to $R^{203}$ may be bonded to each other to form a ring structure, and an oxygen atom, a sulfur atom, an ester group, an amide group, or a carbonyl group may be included in the ring.

Examples of the group formed by bonding two of $R^{201}$ to $R^{203}$ include an alkylene group AL, -aromatic ring group-alkylene group AL-aromatic ring group-, -aromatic ring group-aromatic ring group-, and -aromatic ring group-O-aromatic ring group-. The above-described alkylene group AL is an alkylene group which may be linear or branched. In addition, one or more methylene groups constituting the alkylene group AL may be substituted with an oxygen atom, a sulfur atom, an ester group, an amide group, and/or a carbonyl group. Examples of the alkylene group AL include a butylene group, a pentylene group, and $-CH_2-CH_2-O-CH_2-CH_2-$).

Examples of the arylsulfonium cation include a triarylsulfonium cation, a diarylalkylsulfonium cation, an aryldialkylsulfonium cation, a diarylcycloalkylsulfonium cation, and an aryldicycloalkylsulfonium cation.

Two aryl groups in the above-described triarylsulfonium cation, the above-described diarylalkylsulfonium cation, or the above-described diarylcycloalkylsulfonium cation may be bonded to each other through a single bond or a divalent linking group (-O-, -S-, an alkylene group, a group consisting of a combination of these groups, or the like).

The aryl group included in the arylsulfonium cation is preferably a phenyl group or a naphthyl group, and more preferably a phenyl group. The aryl group may be an aryl group which has a heterocyclic structure having an oxygen atom, a nitrogen atom, a sulfur atom, or the like. Examples of the heterocyclic structure include a pyrrole residue, a furan residue, a thiophene residue, an indole residue, a benzofuran residue, and a benzothiophene residue. In a case where the arylsulfonium cation has two or more aryl groups, the two or more aryl groups may be the same or different from each other.

The alkyl group or the cycloalkyl group included in the arylsulfonium cation as necessary is preferably a linear alkyl group having 1 to 15 carbon atoms, a branched alkyl group having 3 to 15 carbon atoms, or a cycloalkyl group having 3 to 15 carbon atoms, and for example, a methyl group, an ethyl group, a propyl group, an n-butyl group, a sec-butyl group, a t-butyl group, a cyclopropyl group, a cyclobutyl group, a cyclohexyl group, or the like is more preferable.

The substituents which may be contained in the aryl group, alkyl group, and cycloalkyl group of $R^{201}$ to $R^{203}$ are each independently preferably an alkyl group (for example, having 1 to 15 carbon atoms), a cycloalkyl group (for example, having 3 to 15 carbon atoms), an aryl group (for example, having 6 to 14 carbon atoms), an alkoxy group (for example, having 1 to 15 carbon atoms), a cycloalkyl alkoxy group (for example, having 1 to 15 carbon atoms), a cycloalkyl sulfonyl group (for example, having 1 to 15 carbon atoms), a halogen atom (for example, fluorine and iodine), a hydroxyl group, a carboxyl group, a group having an ester group, a group having a sulfinyl group, a group having a sulfonyl group, an alkylthio group, a phenylthio group, or the like.

The substituent may further have a substituent if possible, and for example, it is also preferable that the above-described alkyl group has a halogen atom as the substituent to form an alkyl halide group such as a trifluoromethyl group.

In addition, it is also preferable to form an acid-decomposable group by any combination of the above-described substituents.

The acid-decomposable group is intended to a group which is decomposed by action of acid to form a polar group, and preferably has a structure in which a polar group is protected by an acid-leaving group which is eliminated by action of acid. The above-described polar group and acid-leaving group are as described above.

Next, the cation (ZaI-2) will be described.

The cation (ZaI-2) is a cation in which $R^{201}$ to $R^{203}$ in Formula (ZaI) are each independently a cation representing an organic group having no aromatic ring. Here, the aromatic ring also encompasses an aromatic ring including a heteroatom.

The number of carbon atoms in the organic group as $R^{201}$ to $R^{203}$, which has no aromatic ring, is generally 1 to 30, and preferably 1 to 20.

$R^{201}$ to $R^{203}$ are each independently preferably an alkyl group, a cycloalkyl group, an allyl group, or a vinyl group, more preferably a linear or branched 2-oxoalkyl group, a 2-oxocycloalkyl group, or an alkoxycarbonylmethyl group, and still more preferably a linear or branched 2-oxoalkyl group.

Examples of the alkyl group and cycloalkyl group of $R^{201}$ to $R^{203}$ include a linear alkyl group having 1 to 10 carbon atoms or a branched alkyl group having 3 to 10 carbon atoms (for example, a methyl group, an ethyl group, a propyl group, a butyl group, and a pentyl group), and a cycloalkyl group having 3 to 10 carbon atoms (for example, a cyclopentyl group, a cyclohexyl group, and a norbornyl group).

$R^{201}$ to $R^{203}$ may further be substituted with a halogen atom, an alkoxy group (for example, having 1 to 5 carbon atoms), a hydroxyl group, a cyano group, or a nitro group.

In addition, it is also preferable that the substituents of $R^{201}$ to $R^{203}$ each independently form an acid-decomposable group by any combination of the substituents.

Next, the cation (ZaI-3b) will be described.

The cation (ZaI-3b) is a cation represented by Formula (ZaI-3b).

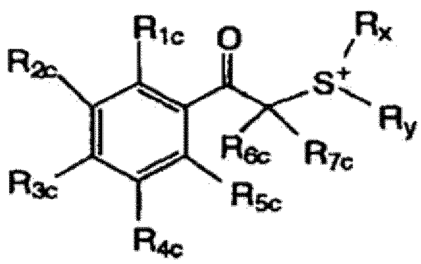

(ZaI-3b)

In General Formula (ZaI-3b),

$R_{1c}$ to $R_{5c}$ each independently represent a hydrogen atom, an alkyl group, a cycloalkyl group, an aryl group, an alkoxy group, an aryloxy group, an alkoxycarbonyl group, an alkylcarbonyloxy group, a cycloalkylcarbonyloxy group, a halogen atom, a hydroxyl group, a nitro group, an alkylthio group, or an arylthio group.

$R_{6c}$ and $R_{7c}$ each independently represent a hydrogen atom, an alkyl group (a t-butyl group and the like), a cycloalkyl group, a halogen atom, a cyano group, or an aryl group.

$R_x$ and $R_y$ each independently represent an alkyl group, a cycloalkyl group, a 2-oxoalkyl group, a 2-oxocycloalkyl group, an alkoxycarbonylalkyl group, an allyl group, or a vinyl group.

In addition, it is also preferable that the substituents of $R_{1c}$ to $R_{7c}$, $R_x$, and $R_y$ each independently form an acid-decomposable group by any combination of the substituents.

Any two or more of $R_{1c}$, ... , or $R_{5c}$, $R_{5c}$ and $R_{6c}$, $R_{6c}$ and $R_{7c}$, $R_{5c}$ and $R_x$, and $R_x$ and $R_y$ may each be bonded to each other to form a ring, and the rings may each independently include an oxygen atom, a sulfur atom, a ketone group, an ester bond, or an amide bond.

Examples of the above-described ring include an aromatic or non-aromatic hydrocarbon ring, an aromatic or non-aromatic heterocyclic ring, and a polycyclic fused ring formed by a combination of two or more of these rings. Examples of the ring include a 3- to 10-membered ring, and the ring is preferably a 4- to 8-membered ring and more preferably a 5- or 6-membered ring.

Examples of the group formed by the bonding of any two or more of $R_{1c}$, ... , or $R_{5c}$, $R_{6c}$ and $R_{7c}$, and $R_x$ and $R_y$ include an alkylene group such as a butylene group and a pentylene group. A methylene group in this alkylene group may be substituted with a heteroatom such as an oxygen atom.

As the group formed by the bonding of $R_{5c}$ and $R_{6c}$, and $R_{5c}$ and $R_x$, a single bond or an alkylene group is

preferable. Examples of the alkylene group include a methylene group and an ethylene group.

The ring formed by bonding $R_{1c}$ to $R_{5c}$, $R_{6c}$, $R_{7c}$, $R_x$, $R_y$, any two or more of $R_{1c}$, ... , or $R_{5c}$, $R_{5c}$ and $R_{6c}$, $R_{6c}$ and $R_{7c}$, $R_{5c}$ and $R_x$, and $R_x$ and $R_y$ to each other may have a substituent.

Next, the cation (ZaI-4b) will be described.

The cation (ZaI-4b) is a cation represented by Formula (ZaI-4b).

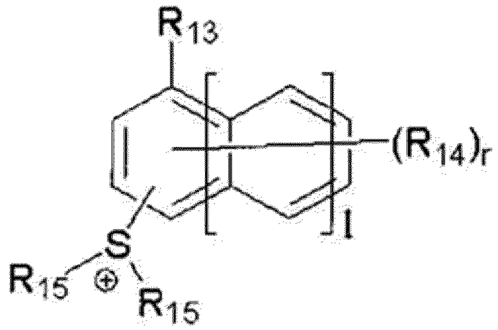

(ZaI-4b)

In Formula (ZaI-4b),

l represents an integer of 0 to 2.
r represents an integer of 0 to 8.

$R_{13}$ represents a hydrogen atom, a halogen atom (for example, a fluorine atom, an iodine atom, or the like), a hydroxyl group, an alkyl group, an alkyl halide group, an alkoxy group, a carboxyl group, an alkoxycarbonyl group, or a group having a cycloalkyl group (which may be the cycloalkyl group itself or a group including the cycloalkyl group in a part thereof). These groups may have a substituent.

$R_{14}$ represents a hydroxyl group, a halogen atom (for example, a fluorine atom, an iodine atom, or the like), an alkyl group, an alkyl halide group, an alkoxy group, an alkoxycarbonyl group, an alkylcarbonyl group, an alkylsulfonyl group, a cycloalkyl sulfonyl group, or a group having a cycloalkyl group (which may be the cycloalkyl group itself or a group including the cycloalkyl group in a part thereof). These groups may have a substituent. In a case where $R_{14}$'s are present in a plural number, $R_{14}$'s each independently represent the above-described group such as a hydroxyl group.

$R_{15}$'s each independently represent an alkyl group, a cycloalkyl group, or a naphthyl group. Two $R_{15}$'s may be bonded to each other to form a ring. In a case where two $R_{15}$'s are bonded to each other to form a ring, a ring skeleton may include a heteroatom such as an oxygen atom and a nitrogen atom.

In one aspect, it is preferable that two $R_{15}$'s are alkylene groups and are bonded to each other to form a ring structure. The above-described alkyl group, the above-described cycloalkyl group, the above-descried naphthyl group, and the ring formed by bonding two $R_{15}$'s to each other may have a substituent.

In Formula (ZaI-4b), the alkyl group of $R_{13}$, $R_{14}$, and $R_{15}$ is linear or branched. The number of carbon atoms in the alkyl group is preferably 1 to 10. The alkyl group is more preferably a methyl group, an ethyl group, an n-butyl group, a t-butyl group, or the like.

In addition, it is also preferable that the substituents of $R_{13}$ to $R_{15}$, $R_x$, and $R_y$ each independently form an acid-decomposable group by any combination of the substituents.

Next, Formula (ZaII) will be described.

In Formula (ZaII), $R^{204}$ and $R^{205}$ each independently represent an aryl group, an alkyl group, or a cycloalkyl group.

The aryl group of $R^{204}$ and $R^{205}$ is preferably a phenyl group or a naphthyl group, and more preferably a phenyl group. The aryl group of $R^{204}$ and $R^{205}$ may be an aryl group which has a heterocyclic ring having an oxygen atom, a nitrogen atom, a sulfur atom, or the like. Examples of a skeleton of the aryl group having a heterocyclic ring include pyrrole, furan, thiophene, indole, benzofuran, and benzothiophene.

The alkyl group and cycloalkyl group of $R^{204}$ and $R^{205}$ are preferably a linear alkyl group having 1 to 10 carbon atoms or a branched alkyl group having 3 to 10 carbon atoms (for example, a methyl group, an ethyl group, a propyl group, a butyl group, and a pentyl group), or a cycloalkyl group having 3 to 10 carbon atoms (for example, a cyclopentyl group, a cyclohexyl group, and a norbornyl group).

The aryl group, the alkyl group, and the cycloalkyl group of $R^{204}$ and $R^{205}$ may each independently have a substituent. Examples of the substituent which may be included in each of the aryl group, the alkyl group, and the cycloalkyl group of $R^{204}$ and $R^{205}$ include an alkyl group (for example, having 1 to 15 carbon atoms), a cycloalkyl group (for example, having 3 to 15 carbon atoms), an aryl group (for example, having 6 to 15 carbon atoms), an alkoxy group

(for example, having 1 to 15 carbon atoms), a halogen atom, a hydroxyl group, and a phenylthio group. In addition, it is also preferable that the substituents of $R^{204}$ and $R^{205}$ each independently form an acid-decomposable group by any combination of the substituents.

· Organic Anion

Examples of the organic anion include a phenolic hydroxyl anion, a sulfonate anion (an aliphatic sulfonate anion, an aromatic sulfonate anion, a camphor sulfonate anion, and the like), a carboxylate anion (an aliphatic carboxylate anion, an aromatic carboxylate anion, an aralkyl carboxylate anion, a formate anion, a bicarbonate anion, and the like), a carbonylsulfonylimide anion, a bis(sulfonyl)imide anion (a bis(alkylsulfonyl)imide anion and the like), a bis(carbonyl)imide anion, and a tris(alkylsulfonyl)methide anion.

An aliphatic moiety in the aliphatic sulfonate anion and the aliphatic carboxylate anion may be an alkyl group or a cycloalkyl group, and a linear or branched alkyl group having 1 to 30 carbon atoms or a cycloalkyl group having 3 to 30 carbon atoms is preferable.

The above-described alkyl group may be, for example, a fluoroalkyl group (which may or may not have a substituent other than a fluorine atom, and may be a perfluoroalkyl group).

The above-described cycloalkyl group may be monocyclic or polycyclic, and one or more (preferably, one or two) $-CH_2-$'s constituting a ring structure may be replaced with a heteroatom (-O-, -S-, or the like), $-SO_2-$, $-SO_3-$, an ester group, or a carbonyl group.

An aryl group in the aromatic sulfonate anion and the aromatic carboxylate anion is preferably an aryl group having 6 to 14 carbon atoms, and examples thereof include a phenyl group, a tolyl group, and a naphthyl group.

The alkyl group, cycloalkyl group, and aryl group mentioned above may have a substituent. The substituent is not particularly limited, and specific examples thereof include a nitro group, a halogen atom such as a fluorine atom and a chlorine atom, a carboxy group, a hydroxyl group, an amino group, a cyano group, an alkoxy group (preferably having 1 to 15 carbon atoms), an alkyl group (preferably having 1 to 10 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), and an aryloxysulfonyl group (preferably having 6 to 20 carbon atoms).

An aralkyl group in the aralkyl carboxylate anion is preferably an aralkyl group having 7 to 14 carbon atoms, and examples thereof include a benzyl group, a phenethyl group, a naphthylmethyl group, a naphthylethyl group, and a naphthylbutyl group.

Examples of the sulfonylimide anion include a saccharin anion.

As the alkyl group in the bis(alkylsulfonyl)imide anion and the tris(alkylsulfonyl)methide anion, an alkyl group having 1 to 5 carbon atoms is preferable. Examples of a substituent of these alkyl group include a halogen atom, an alkyl group substituted with a halogen atom, an alkoxy group, an alkylthio group, an alkyloxysulfonyl group, an aryloxysulfonyl group, and a cycloalkylaryloxysulfonyl group, and a fluorine atom or an alkyl group substituted with a fluorine atom is preferable.

In addition, the alkyl groups in the bis(alkylsulfonyl)imide anion may be bonded to each other to form a ring structure.

The organic anion is also preferably an aliphatic sulfonate anion in which at least an α-position of the sulfonic acid is substituted with a fluorine atom (aliphatic sulfonate anion in which one or two fluorine atoms are substituted at the α-position, and the like); an aliphatic sulfonate anion in which an α-position of the sulfonic acid is not substituted with a fluorine atom (aliphatic sulfonate anion a fluorine atom is not substituted at the α-position and zero to three of a fluorine atom or a perfluoroalkyl group are substituted at a β-position, and the like); an aromatic sulfonate anion substituted with a fluorine atom or a group having a fluorine atom; a bis(alkylsulfonyl)imide anion in which an alkyl group is substituted with a fluorine atom; or a tris(alkylsulfonyl)methide anion in which an alkyl group is substituted with a fluorine atom.

In addition, as the organic anion, an anion represented by Formula (AN) is also preferable.

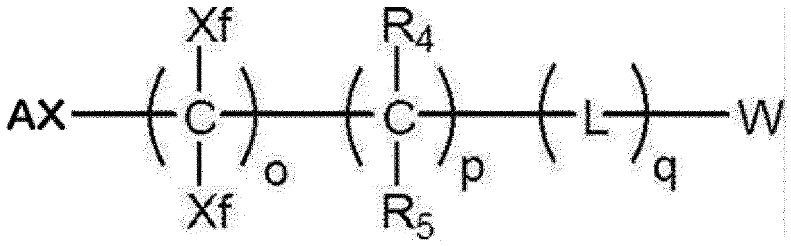

(AN)

In Formula (AN), o represents an integer of 0 to 5. p represents an integer of 0 to 10. q represents an integer of 0 to 10.

In Formula (AN), AX represents $-SO_3^-$ or $-COO^-$.

In Formula (AN), Xf represents a fluorine atom or an alkyl group substituted with at least one fluorine atom. The number of carbon atoms in the alkyl group is preferably 1 to 10 and more preferably 1 to 4. In addition, the alkyl group substituted with at least one fluorine atom is preferably a perfluoroalkyl group.

Xf is preferably a fluorine atom or a perfluoroalkyl group having 1 to 4 carbon atoms, and more preferably a fluorine atom or $CF_3$. In particular, it is still more preferable that both Xf's are fluorine atoms.

In Formula (AN), $R_4$ and $R_5$ each independently represent a hydrogen atom, a fluorine atom, an alkyl group, or an alkyl group substituted with at least one fluorine atom. In a case of a plurality of $R_4$'s and $R_5$'s, $R_4$'s and $R_5$'s may be the same or different from each other.

The alkyl group represented by $R_4$ and $R_5$ may have a substituent other than the fluorine atom, and the number of carbon atoms therein is preferably 1 to 4.

Specific examples and suitable aspects of the alkyl group substituted with at least one fluorine atom are the same as the specific examples and suitable aspects of Xf.

$R_4$ and $R_5$ are preferably a hydrogen atom.

In addition, it is also preferable that one of $R_4$ and $R_5$ bonded to the same carbon atom is a hydrogen atom and the other is a fluorine atom or an alkyl group substituted with at least one fluorine atom. Among these, it is also preferable that, in $-C(R_4)(R_5)-$ at the first and/or second closest position to AX, one of $R_4$ and $R_5$ bonded to the same carbon atom is a hydrogen atom and the other is a fluorine atom or an alkyl group substituted with at least one fluorine atom. In addition, it is also preferable that, in the $-C(R_4)(R_5)-$ at the first and/or second closest position to AX, $R_4$ and $R_5$ are each independently a hydrogen atom or an alkyl group (which may have a substituent other than the fluorine atom).

In Formula (AN), L represents a divalent linking group. In a case of a plurality of L's, L's may be the same or different from each other.

Examples of the divalent linking group include -O-CO-O-, -COO-, -OCO-, -CONH-, -NHCO-, -CO-, -O-, -S-, -SO-, $-SO_2-$, an alkylene group (preferably having 1 to 6 carbon atoms), a cycloalkylene group (preferably having 3 to 15 carbon atoms), an alkenylene group (preferably having 2 to 6 carbon atoms), and a divalent linking group formed by a combination of a plurality of these groups. Among these, -O-CO-O-, -COO-, -OCO-, -CONH-, -NHCO-, -CO-, -O-, $-SO_2-$, -O-CO-O-alkylene group-, -alkylene group-O-CO-O-, -COO-alkylene group-, -OCO-alkylene group-, -CONH-alkylene group-, or -NHCO-alkylene group- is preferable; and -O-CO-O-, -O-CO-O-alkylene group-, -alkylene group-O-CO-O-, -COO-, -OCO-, -CONH-, $-SO_2-$, -COO-alkylene group-, or -OCO-alkylene group- is more preferable.

In Formula (AN), W represents an organic group including a cyclic structure. Among these, a cyclic organic group is preferable.

Examples of the cyclic organic group include an alicyclic group, an aryl group, and a heterocyclic group.

The alicyclic group may be monocyclic or polycyclic. Examples of the monocyclic alicyclic group include a monocyclic cycloalkyl group such as a cyclopentyl group, a cyclohexyl group, and a cyclooctyl group. Examples of the polycyclic alicyclic group include a polycyclic cycloalkyl group such as a norbornyl group, a tricyclodecanyl group, a tetracyclodecanyl group, a tetracyclododecanyl group, and an adamantyl group. Among these, an alicyclic group having a bulky structure with 7 or more carbon atoms, such as a norbornyl group, a tricyclodecanyl group, a tetracyclodecanyl group, a tetracyclododecanyl group, and an adamantyl group, is preferable.

The aryl group may be monocyclic or polycyclic. Examples of the aryl group include a phenyl group, a naphthyl group, a phenanthryl group, and an anthryl group.

The heterocyclic group may be monocyclic or polycyclic. In addition, the heterocyclic group may or may not have aromaticity. Examples of a heterocycle having aromaticity include a furan ring, a thiophene ring, a benzofuran ring, a benzothiophene ring, a dibenzofuran ring, a dibenzothiophene ring, and a pyridine ring. Examples of a heterocycle not having aromaticity include a tetrahydropyran ring, a lactone ring, a sultone ring, and a decahydroisoquinoline ring. As the heterocycle in the heterocyclic group, a furan ring, a thiophene ring, a pyridine ring, or a decahydroisoquinoline ring is particularly preferable.

The above-described cyclic organic group may have a substituent. Examples of the substituent include an alkyl group (may be linear or branched; preferably having 1 to 12 carbon atoms), a cycloalkyl group (may be monocyclic, polycyclic, or spirocyclic; preferably having 3 to 20 carbon atoms), an aryl group (preferably having 6 to 14 carbon atoms), a hydroxyl group, an alkoxy group, an ester group, an amide group, a urethane group, a ureido group, a thioether group, a sulfonamide group, and a sulfonic acid ester group. A carbon constituting the cyclic organic group (carbon contributing to ring formation) may be a carbonyl carbon.

As the anion represented by Formula (AN), $AX-CF_2-CH_2-OCO-(L)q'-W$, $AX-CF_2-CHF-CH_2-OCO-(L)q'-W$, $AX-CF_2-COO-(L)q'-W$, $AX-CF_2-CF_2-CH_2-CH_2-(L)q-W$, or $AX-CF_2-CH(CF_3)-OCO-(L)q'-W$ is preferable. Here, AX, L, q, and W are the same as in Formula (AN). q' represents an integer of 0 to 10.

In addition, a portion other than an organic cation in compounds represented by Formulae (Ia-1) to (Ia-5) and

compounds represented by Formulae (IIa-1) and (IIa-2), which are described later, may be used as the organic anion.

· Compounds (I) and (II)

The photoacid generator which is an onium salt may be one or more selected from the group consisting of compounds (I) and (II) described below.

The compounds (I) and (II) are also a compound (photoacid generator) which generates an acid by irradiation with actinic ray or radiation.

·· Compound (I)

The compound (I) is a compound having one or more of the following structural moieties X and one or more of the following structural moieties Y, in which the compound generates an acid including the following first acidic moiety derived from the following structural moiety X and the following second acidic moiety derived from the following structural moiety Y by irradiation with actinic ray or radiation.

Structural moiety X: a structural moiety which consists of an anionic moiety $A_1^-$ and a cationic moiety $M_1^+$, and forms a first acidic moiety represented by $HA_1$ by irradiation with actinic ray or radiation

Structural moiety Y: a structural moiety which consists of an anionic moiety $A_2^-$ and a cationic moiety $M_2^+$, and forms a second acidic moiety represented by $HA_2$ by irradiation with actinic ray or radiation

However, the compound (I) satisfies the following condition I.

Condition I: a compound PI, which is formed by, in the compound (I), replacing the cationic moiety $M_1^+$ in the structural moiety X and the cationic moiety $M_2^+$ in the structural moiety Y with $H^+$, has an acid dissociation constant a1 derived from the acidic moiety represented by $HA_1$, formed by replacing the cationic moiety $M_1^+$ in the structural moiety X with $H^+$, and has an acid dissociation constant a2 derived from the acidic moiety represented by $HA_2$, formed by replacing the cationic moiety $M_2^+$ in the structural moiety Y with $H^+$, in which the acid dissociation constant a2 is larger than the acid dissociation constant a1,

Hereinafter, the condition I will be described in more detail.

In a case where the compound (I) is, for example, a compound that generates an acid having one first acidic moiety derived from the above-described structural moiety X and one second acidic moiety derived from the above-described structural moiety Y, the compound PI corresponds to "compound having $HA_1$ and $HA_2$".

As the acid dissociation constant a1 and the acid dissociation constant a2 of such a compound PI, more specifically, in a case of obtaining acid dissociation constants of the compound PI, a pKa in a case where the compound PI is to be "compound having $A_1^-$ and $HA_2$" is defined as the acid dissociation constant a1, and a pKa in a case where the "compound having $A_1^-$ and $HA_2$" is to be "compound having $A_1^-$ and $A_2^-$" is defined as the acid dissociation constant a2.

In addition, in a case where the compound (I) is, for example, a compound that generates an acid having two first acidic moieties derived from the above-described structural moiety X and one second acidic moiety derived from the above-described structural moiety Y, the compound PI corresponds to "compound having two HAi's and one $HA_2$".

In a case of obtaining acid dissociation constants of such a compound PI, an acid dissociation constant in a case where the compound PI is to be "compound having one $A_1^-$, one $HA_1$, and one $HA_2$" and an acid dissociation constant in a case where the "compound having one $A_1^-$, one $HA_1$, and one $HA_2$" is to be "compound having two $A_1^-$ and one $HA_2$" correspond to the above-described acid dissociation constant a1. In addition, an acid dissociation constant in a case where the "compound having two $A_1^-$ and one $HA_2$" is to be "compound having two $A_1^-$ and one $A_2^-$" corresponds to the acid dissociation constant a2. That is, in the compound PI, in a case of a plurality of acid dissociation constants derived from the acidic moiety represented by $HA_1$, which is formed by replacing the above-described cationic moiety $M_1^+$ in the above-described structural moiety X with $H^+$, a value of the acid dissociation constant a2 is larger than the largest value of the plurality of acid dissociation constants a1. In a case where the acid dissociation constant in a case where the compound PI is to be the "compound having one $A_1^-$, one $HA_1$, and one $HA_2$" is defined as aa, and the acid dissociation constant in a case where the "compound having one $A_1^-$, one $HA_1$, and one $HA_2$" is to be the "compound having two $A_1^-$ and one $HA_2$" is defined as ab, a relationship between aa and ab satisfies aa < ab.

The acid dissociation constant a1 and the acid dissociation constant a2 can be obtained by the above-described method for measuring an acid dissociation constant.

The above-described compound PI corresponds to an acid generated in a case where the compound (I) is irradiated with actinic ray or radiation.

In a case where the compound (I) has two or more of the structural moieties X, the structural moieties X may be the same or different from each other. In addition, two or more of $A_1^-$'s and two or more of $M_1^+$ may be the same or different from each other.

In addition, in the compound (I), $A_1^-$ and $A_2^-$, and $M_1^+$ and $M_2^+$ may be the same or different from each other, but it is preferable that $A_1^-$ and $A_2^-$ are different from each other.

From the viewpoint that LWR performance of the pattern to be formed is more excellent, in the above-described compound PI, a difference between the acid dissociation constant a1 (in a case of a preferably of acid dissociation constants a1, the maximum value thereof) and the acid dissociation constant a2 is preferably 0.1 or more, more preferably 0.5 or more, and still more preferably 1.0 or more. The upper limit value of the difference between the acid dissociation constant a1 (in a case of a preferably of acid dissociation constants a1, the maximum value thereof) and the acid dissociation constant a2 is not particularly limited, but is, for example, 16 or less.

In addition, from the viewpoint that LWR performance of the pattern to be formed is more excellent, the acid dissociation constant a2 in the above-described compound PI is, for example, 20 or less, preferably 15 or less. The lower limit value of the acid dissociation constant a2 is preferably -4.0 or more.

In addition, from the viewpoint that LWR performance of the pattern to be formed is more excellent, the acid dissociation constant a1 in the above-described compound PI is preferably 2.0 or less, and more preferably 0 or less. The lower limit value of the acid dissociation constant a1 is preferably -20.0 or more.

The anionic moiety $A_1^-$ and the anionic moiety $A_2^-$ are structural moieties including a negatively charged atom or atomic group, and examples thereof include structural moieties selected from the group consisting of Formulae (AA-1) to (AA-3), and Formulae (BB-1) to (BB-6). The anionic moiety $A_1^-$ is preferably an acidic moiety capable of forming an acidic moiety having a small acid dissociation constant, and among these, any one of Formulae (AA-1) to (AA-3) is more preferable. In addition, the anionic moiety $A_2^-$ is preferably an acidic moiety capable of forming an acidic moiety having a larger acid dissociation constant than the anionic moiety $A_1^-$, and it is preferably selected from any one of Formulae (BB-1) to (BB-6). In Formulae (AA-1) to (AA-3) and Formulae (BB-1) to (BB-6), * represents a bonding position.

In Formula (AA-2), $R^A$ represents a monovalent organic group. Examples of the monovalent organic group represented by $R^A$ include a cyano group, a trifluoromethyl group, and a methanesulfonyl group.

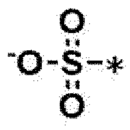

AA-1

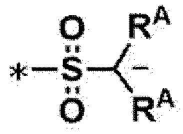

AA-2

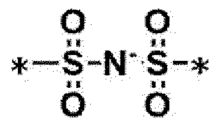

AA-3

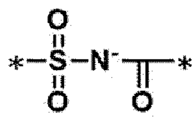

BB-1

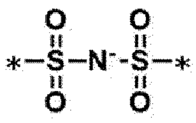

BB-2

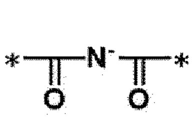

BB-3

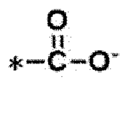

BB-4

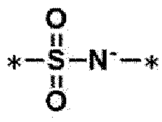

BB-5

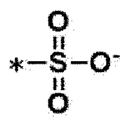

BB-6

In addition, the cationic moiety $M_1^+$ and the cationic moiety $M_2^+$ are a structural moiety including a positively charged atom or atomic group, and examples thereof include an organic cation having a charge of 1. The organic cation is not particularly limited, and examples thereof include the above-described organic cations. Among these, an organic cation (cation (ZaI)) represented by Formula (ZaI) or an organic cation (cation (ZaII)) represented by Formula (ZaII) is preferable.

A specific structure of the compound (I) is not particularly limited, and examples thereof include compounds represented by Formulae (Ia-1) to (Ia-5) described below.

Hereinafter, first, the compound represented by Formula (Ia-1) will be described. The compound represented by Formula (Ia-1) is as follows.

$$M_{11}^{+}A_{11}^{-}\text{-}L_1\text{-}A_{12}^{-}M_{12}^{+} \qquad \text{(Ia-1)}$$

The compound (Ia-1) generates an acid represented by $HA_{11}$-$L_1$-$A_{12}H$ by irradiation with actinic ray or radiation.

In Formula (Ia-1), $M_{11}^+$ and $M_{12}^+$ each independently represent an organic cation.

$A_{11}^-$ and $A_{12}^-$ each independently represent a monovalent anionic functional group.

$L_1$ represents a divalent linking group.

$M_{11}^+$ and $M_{12}^+$ may be the same or different from each other.

$A_{11}^-$ and $A_{12}^-$ may be the same or different from each other, but it is preferable to be different from each other.

However, in the compound PIa ($HA_{11}$-$L_1$-$A_{12}H$) formed by replacing organic cations represented by $M_{11}^+$ and

$M_{12}^+$ with $H^+$ in Formula (Ia-1), the acid dissociation constant a2 derived from the acidic moiety represented by $A_{12}H$ is larger than the acid dissociation constant a1 derived from the acidic moiety represented by $HA_{11}$. Suitable values of the acid dissociation constant a1 and the acid dissociation constant a2 are as described above. In addition, the acid generated from the compound PIa and the acid generated from the compound represented by Formula (Ia-1) by irradiation with actinic ray or radiation are the same.

In addition, at least one of $M_{11}^+$, $M_{12}^+$, $A_{11}^-$, $A_{12}^-$, or $L_1$ may have an acid-decomposable group as a substituent.

In Formula (Ia-1), examples of the organic cation represented by $M_1^+$ and $M_2^+$ include the above-described organic cations. Among these, an organic cation (cation (ZaI)) represented by Formula (ZaI) or an organic cation (cation (ZaII)) represented by Formula (ZaII) is preferable.

The monovalent anionic functional group represented by $A_{11}^-$ is intended to be a monovalent group including the above-described anionic moiety $A_1^-$. In addition, the monovalent anionic functional group represented by $A_{12}^-$ is intended to be a monovalent group including the above-described anionic moiety $A_2^-$.

As the monovalent anionic functional group represented by $A_{11}^-$ and $A_{12}^-$, a monovalent anionic functional group including the anionic moiety of any of Formulae (AA-1) to (AA-3) and Formulae (BB-1) to (BB-6) described above is preferable, and a monovalent anionic functional group selected from the group consisting of Formulae (AX-1) to (AX-3) and Formulae (BX-1) to (BX-7) is more preferable. Among these, as the monovalent anionic functional group represented by $A_{11}^-$, a monovalent anionic functional group represented by any of Formulae (AX-1) to (AX-3) is preferable. In addition, as the monovalent anionic functional group represented by $A_{12}^-$, a monovalent anionic functional group represented by any of Formulae (BX-1) to (BX-7) is preferable, and a monovalent anionic functional group represented by any of Formulae (BX-1) to (BX-6) is more preferable.

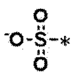
AX-1
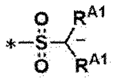
AX-2
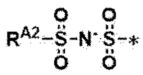
AX-3

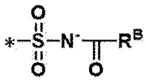
BX-1
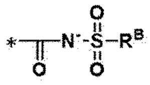
BX-2
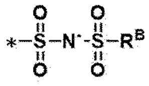
BX-3
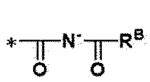
BX-4
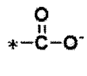
BX-5
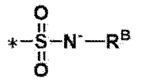
BX-6
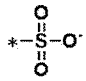
BX-7

In Formulae (AX-1) to (AX-3), $R^{A1}$ and $R^{A2}$ each independently represent a monovalent organic group. * represents a bonding position.

Examples of the monovalent organic group represented by $R^{A1}$ include a cyano group, a trifluoromethyl group, and a methanesulfonyl group.

As the monovalent organic group represented by $R^{A2}$, a linear, branched, or cyclic alkyl group, or an aryl group is preferable.

The number of carbon atoms in the above-described alkyl group is preferably 1 to 15, more preferably 1 to 10, and still more preferably 1 to 6.

The above-described alkyl group may have a substituent. As the substituent, a fluorine atom or a cyano group is preferable, and a fluorine atom is more preferable. In a case where the above-described alkyl group has a fluorine atom as the substituent, the substituent may be a perfluoroalkyl group.

The above-described aryl group is preferably a phenyl group or a naphthyl group, and more preferably a phenyl group.

The above-described aryl group may have a substituent. As the substituent, a fluorine atom, an iodine atom, a perfluoroalkyl group (for example, preferably having 1 to 10 carbon atoms and more preferably having 1 to 6 carbon atoms), or a cyano group is preferable, and a fluorine atom, an iodine atom, or a perfluoroalkyl group is more preferable.

In Formulae (BX-1) to (BX-4) and (BX-6), $R^B$ represents a monovalent organic group. * represents a bonding position.

As the monovalent organic group represented by $R^B$, a linear, branched, or cyclic alkyl group, or an aryl group is preferable.

The number of carbon atoms in the above-described alkyl group is preferably 1 to 15, more preferably 1 to 10, and still more preferably 1 to 6.

The above-described alkyl group may have a substituent. The substituent is not particularly limited, but a fluorine atom or a cyano group is preferable, and a fluorine atom is more preferable. In a case where the above-described alkyl group has a fluorine atom as the substituent, the substituent may be a perfluoroalkyl group.

In a case where the carbon atom to be the bonding position in the alkyl group (for example, in the case of Formulae (BX-1) and (BX-4), a carbon atom directly bonded to -CO-specified in the alkyl group of the formulae; in the

case of Formulae (BX-2) and (BX-3), a carbon atom directly bonded to $-SO_2-$ specified in the alkyl group of the formulae; and in the case of Formula (BX-6), a carbon atom directly bonded to $N^-$ specified in the alkyl group of the formula) has a substituent, the substituent is also preferably a fluorine atom or a substituent other than a cyano group.

In addition, the above-described alkyl group may have a carbon atom substituted with a carbonyl carbon.

The above-described aryl group is preferably a phenyl group or a naphthyl group, and more preferably a phenyl group.

The above-described aryl group may have a substituent. As the substituent, a fluorine atom, an iodine atom, a perfluoroalkyl group (for example, preferably having 1 to 10 carbon atoms and more preferably having 1 to 6 carbon atoms), a cyano group, an alkyl group (for example, preferably having 1 to 10 carbon atoms and more preferably having 1 to 6 carbon atoms), an alkoxy group (for example, preferably having 1 to 10 carbon atoms and more preferably having 1 to 6 carbon atoms), or an alkoxycarbonyl group (for example, preferably having 2 to 10 carbon atoms and more preferably having 2 to 6 carbon atoms) is preferable; and a fluorine atom, an iodine atom, a perfluoroalkyl group, an alkyl group, an alkoxy group, or an alkoxycarbonyl group is more preferable.

In Formula (Ia-1), the divalent linking group represented by $L_1$ is not particularly limited, and examples thereof include -CO-, -NR-, -CO-, -O-, -S-, -SO-, $-SO_2-$, an alkylene group (preferably having 1 to 6 carbon atoms; may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), a divalent aromatic hydrocarbon ring group (preferably a 6- to 10-membered ring, and more preferably a 6-membered ring), and a divalent linking group formed by a combination of a plurality of these groups. Examples of R include a hydrogen atom and a monovalent organic group. The monovalent organic group is not particularly limited, but is preferably, for example, an alkyl group (preferably having 1 to 6 carbon atoms).

The above-described alkylene group, the above-described cycloalkylene group, the above-described alkenylene group, and the above-described divalent aliphatic heterocyclic group, divalent aromatic heterocyclic group, and divalent aromatic hydrocarbon ring group may have a substituent. Examples of the substituent include a halogen atom (preferably, a fluorine atom).

Among these, as the divalent linking group represented by $L_1$, a divalent linking group represented by Formula (L1) is preferable.

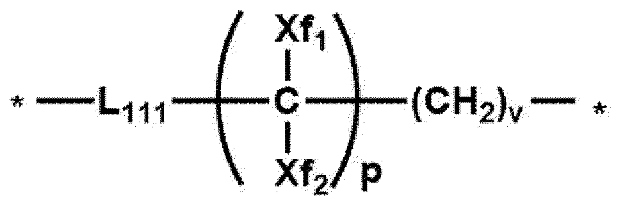

(L1)

In Formula (L1), $L_{111}$ represents a single bond or a divalent linking group.

The divalent linking group represented by $L_{111}$ is not particularly limited, and examples thereof include -CO-, -NH-, -O-, -SO-, $-SO_2-$, an alkylene group which may have a substituent (preferably having 1 to 6 carbon atoms; may be linear or branched), a cycloalkylene group which may have a substituent (preferably having 3 to 15 carbon atoms), an aryl which may have a substituent (preferably having 6 to 10 carbon atoms), and a divalent linking group formed by a combination of a plurality of these groups. The substituent is not particularly limited, and examples thereof include a halogen atom.

p represents an integer of 0 to 3, and preferably represents an integer of 1 to 3.

v represents an integer of 0 or 1.

Xfi’s each independently represent a fluorine atom or an alkyl group substituted with at least one fluorine atom. The number of carbon atoms in the alkyl group is preferably 1 to 10 and more preferably 1 to 4. In addition, the alkyl group substituted with at least one fluorine atom is preferably a perfluoroalkyl group.

$Xf_2$’s each independently represent a hydrogen atom, an alkyl group which may have a fluorine atom as a substituent, or a fluorine atom. The number of carbon atoms in the alkyl group is preferably 1 to 10 and more preferably 1 to 4. Among these, Xfz preferably represents a fluorine atom or an alkyl group substituted with at least one fluorine atom, and more preferably represents a fluorine atom or a perfluoroalkyl group.

Among these, as each of $Xf_1$ and $Xf_2$, a fluorine atom or a perfluoroalkyl group having 1 to 4 carbon atoms is preferable, and a fluorine atom or $CF_3$ is more preferable. In particular, it is still more preferable that both $Xf_1$ and $Xf_2$ are fluorine atoms.

* represents a bonding position.

In a case where Ln in Formula (Ia-1) represents the divalent linking group represented by Formula (L1), it is preferable that the bonding site (*) on the Lm side of Formula (L1) is bonded to $A_{12}^-$ of Formula (Ia-1).

Next, Formulae (Ia-2) to (Ia-4) will be described.

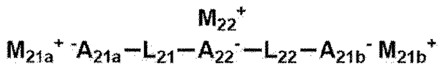

(Ia-2)

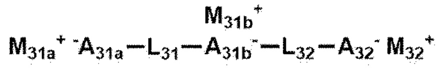

(Ia-3)

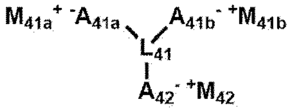

(Ia-4)

In Formula (Ia-2), $A_{21a}^-$ and $A_{21b}^-$ each independently represent a monovalent anionic functional group. Here, the monovalent anionic functional group represented by $A_{21a}^-$ and $A_{21b}^-$ is intended to be a monovalent group including the above-described anionic moiety $A_1^-$. The monovalent anionic functional group represented by $A_{21a}^-$ and $A_{21b}^-$ is not particularly limited, and examples thereof include the monovalent anionic functional group selected from the group consisting of Formulae (AX-1) to (AX-3) described above.

$A_{22}^-$ represents a divalent anionic functional group. Here, the divalent anionic functional group represented by $A_{22}^-$ is intended to be a divalent group including the above-described anionic moiety $A_2^-$. Examples of the divalent anionic functional group represented by $A_{22}^-$ include a divalent anionic functional group represented by Formulae (BX-8) to (BX-11).

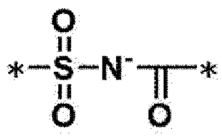

BX-8

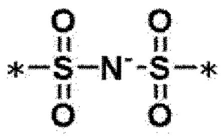

BX-9

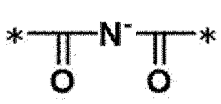

BX-10

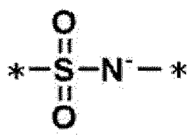

BX-11

$M_{21a}^+$, $M_{21b}^+$, and $M_{22}^+$ each independently represent an organic cation. The organic cation represented by $M_{21a}^+$, $M_{21b}^+$, and $M_{22}^+$ has the same meaning as $M_1^+$ described above, and a suitable aspect thereof is also the same.

$L_{21}$ and $L_{22}$ each independently represent a divalent organic group.

In addition, in a compound PIa-2 of Formula (Ia-2), in which the organic cation represented by $M_{21a}^+$, $M_{21b}^+$, and $M_{22}^+$ is replaced with $H^+$, an acid dissociation constant a2 derived from an acidic moiety represented by $A_{22}H$ is larger than an acid dissociation constant a1-1 derived from $A_{21a}H$ and an acid dissociation constant a1-2 derived from an acidic moiety represented by $A_{21b}H$. The acid dissociation constant a1-1 and the acid dissociation constant a1-2 correspond to the above-described acid dissociation constant a1.

$A_{21a}^-$ and $A_{21b}^-$ may be the same or different from each other. In addition, $M_{21a}^+$, $M_{21b}^+$, and $M_{22}^+$ may be the same or different from each other.

In addition, at least one of $M_{21a}^+$, $M_{21b}^+$, $M_{22}^+$, $A_{21a}^-$, $A_{21b}^-$, $L_{21}$, or $L_{22}$ may have an acid-decomposable group as a substituent.

In Formula (Ia-3), $A_{31a}^-$ and $A_{32}^-$ each independently represent a monovalent anionic functional group. The definition of the monovalent anionic functional group represented by $A_{31a}^-$ is the same as $A_{21a}^-$ and $A_{21b}^-$ in Formula (Ia-2), and a suitable aspect thereof is also the same.

The monovalent anionic functional group represented by $A_{32}^-$ is intended to be a monovalent group including the above-described anionic moiety $A_2^-$. The monovalent anionic functional group represented by $A_{32}^-$ is not particularly

limited, and examples thereof include the monovalent anionic functional group selected from the group consisting of Formulae (BX-1) to (BX-7) described above.

$A_{31b}^-$ represents a divalent anionic functional group. Here, the divalent anionic functional group represented by $A_{31b}^-$ is intended to be a divalent group including the above-described anionic moiety $A_1^-$. Examples of the divalent anionic functional group represented by $A_{31b}^-$ include a divalent anionic functional group represented by Formula (AX-4).

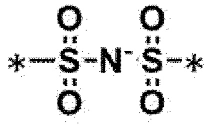

AX-4

$M_{31a}^+$, $M_{31b}^+$, and $M_{32}^+$ each independently represent a monovalent organic cation. The organic cation of $M_{31a}^+$, $M_{31b}^+$, and $M_{32}^+$ has the same meaning as $M_1^+$ described above, and a suitable aspect thereof is also the same.

$L_{31}$ and $L_{32}$ each independently represent a divalent organic group.

In addition, in a compound PIa-3 of Formula (Ia-3), in which the organic cation represented by $M_{31a}^+$, $M_{31b}^+$, and $M_{32}^+$ is replaced with $H^+$, an acid dissociation constant a2 derived from an acidic moiety represented by $A_{32}H$ is larger than an acid dissociation constant a1-3 derived from an acidic moiety represented by $A_{31a}H$ and an acid dissociation constant a1-4 derived from an acidic moiety represented by $A_{31b}H$. The acid dissociation constant a1-3 and the acid dissociation constant a1-4 correspond to the above-described acid dissociation constant a1.

$A_{31a}^-$ and $A_{32}^-$ may be the same or different from each other. In addition, $M_{31a}^+$, $M_{31b}^+$, and $M_{32}^+$ may be the same or different from each other.

In addition, at least one of $M_{31a}^+$, $M_{31b}^+$, $M_{32}^+$, $A_{31a}^-$, $A_{32}^-$, $L_{31}$, or $L_{32}$ may have an acid-decomposable group as a substituent.

In Formula (Ia-4), $A_{41a}^-$, $A_{41b}^-$, and $A_{42}^-$ each independently represent a monovalent anionic functional group. The definition of the monovalent anionic functional group represented by $A_{41a}^-$ and $A_{41b}^-$ is the same as $A_{21a}^-$ and $A_{21b}^-$ in Formula (Ia-2). In addition, the definition of the monovalent anionic functional group represented by $A_{42}^-$ is the same as $A_{32}^-$ in Formula (Ia-3), and a suitable aspect thereof is also the same.

$M_{41a}^+$, $M_{41b}^+$, and $M_{42}^+$ each independently represent an organic cation.

$L_{41}$ represents a trivalent organic group.

In addition, in a compound PIa-4 of Formula (Ia-4), in which the organic cation represented by $M_{41a}^+$, $M_{41b}^+$, and $M_{42}^+$ is replaced with $H^+$, an acid dissociation constant a2 derived from an acidic moiety represented by $A_{42}H$ is larger than an acid dissociation constant a1-5 derived from an acidic moiety represented by $A_{41a}H$ and an acid dissociation constant a1-6 derived from an acidic moiety represented by $A_{41b}H$. The acid dissociation constant a1-5 and the acid dissociation constant a1-6 correspond to the above-described acid dissociation constant a1.

$A_{41a}^-$, $A_{41b}^-$, and $A_{42}^-$ may be the same or different from each other. In addition, $M_{41a}^+$, $M_{41b}^+$, and $M_{42}^+$ may be the same or different from each other.

In addition, at least one of $M_{41a}^+$, $M_{41b}^+$, $M_{42}^+$, $A_{41a}^-$, $A_{41b}^-$, $A_{42}^-$, or $L_{41}$ may have an acid-decomposable group as a substituent.

The divalent organic group represented by $L_{21}$ and $L_{22}$ in Formula (Ia-2) and $L_{31}$ and $L_{32}$ in Formula (Ia-3) is not particularly limited, and examples thereof include -CO-, -NR-, -O-, -S-, -SO-, $-SO_2-$, an alkylene group (preferably having 1 to 6 carbon atoms; may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), a divalent aromatic hydrocarbon ring group (preferably a 6- to 10-membered ring, and more preferably a 6-membered ring), and a divalent organic group formed by a combination of a plurality of these groups. Examples of R include a hydrogen atom and a monovalent organic group. The monovalent organic group is not particularly limited, but is preferably, for example, an alkyl group (preferably having 1 to 6 carbon atoms).

The above-described alkylene group, the above-described cycloalkylene group, the above-described alkenylene group, and the above-described divalent aliphatic heterocyclic group, divalent aromatic heterocyclic group, and divalent aromatic hydrocarbon ring group may have a substituent. Examples of the substituent include a halogen atom (preferably, a fluorine atom).

As the divalent organic group represented by $L_{21}$ and $L_{22}$ in Formula (Ia-2) and $L_{31}$ and $L_{32}$ in Formula (Ia-3), for example, a divalent organic group represented by Formula (L2) is also preferable.

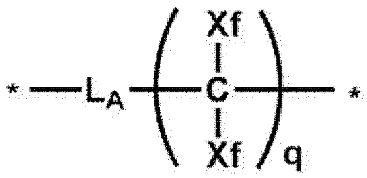

(L2)

In Formula (L2), q represents an integer of 1 to 3. * represents a bonding position.

Xf's each independently represent a fluorine atom or an alkyl group substituted with at least one fluorine atom. The number of carbon atoms in the alkyl group is preferably 1 to 10 and more preferably 1 to 4. In addition, the alkyl group substituted with at least one fluorine atom is preferably a perfluoroalkyl group.

Xf is preferably a fluorine atom or a perfluoroalkyl group having 1 to 4 carbon atoms, and more preferably a fluorine atom or $CF_3$. In particular, it is still more preferable that both Xf's are fluorine atoms.

$L_A$ represents a single bond or a divalent linking group.

The divalent linking group represented by $L_A$ is not particularly limited, and examples thereof include -CO-, -O-, -SO-, $-SO_2-$, an alkylene group (preferably having 1 to 6 carbon atoms; may be linear or branched), a cycloalkylene group (preferably having 3 to 15 carbon atoms), a divalent aromatic hydrocarbon ring group (preferably a 6- to 10-membered ring, and more preferably a 6-membered ring), and a divalent linking group formed by a combination of a plurality of these groups.

In addition, the above-described alkylene group, the above-described cycloalkylene group, and the divalent aromatic hydrocarbon ring group may have a substituent. Examples of the substituent include a halogen atom (preferably, a fluorine atom).

Examples of the divalent organic group represented by Formula (L2) include $*-CF_2-*$, $*-CF_2-CF_2-*$, $*-CF_2-CF_2-CF_2-*$, $*-Ph-O-SO_2-CF_2-*$, $*-Ph-O-SO_2-CF_2-CF_2-*$, $*-Ph-O-SO_2-CF_2-CF_2-CF_2-*$, and $*-Ph-OCO-CF_2-*$. Ph is a phenylene group which may have a substituent, and is preferably a 1,4-phenylene group. The substituent is not particularly limited, and an alkyl group (for example, preferably having 1 to 10 carbon atoms and more preferably having 1 to 6 carbon atoms) or an alkoxy group (for example, preferably having 1 to 10 carbon atoms and more preferably having 1 to 6 carbon atoms), or an alkoxycarbonyl group (for example, preferably having 2 to 10 carbon atoms and more preferably having 2 to 6 carbon atoms) is preferable.

In a case where $L_{21}$ and $L_{22}$ in Formula (Ia-2) represents the divalent organic group represented by Formula (L2), it is preferable that the bonding site (*) on the $L_A$ side of Formula (L2) is bonded to $A_{21a}^-$ and $A_{21b}^-$ of Formula (Ia-2).

In addition, in a case where $L_{31}$ and $L_{32}$ in Formula (Ia-3) represents the divalent organic group represented by Formula (L2), it is preferable that the bonding site (*) on the $L_A$ side of Formula (L2) is bonded to $A_{31a}^-$ and $A_{32}^-$ of Formula (Ia-3).

The trivalent organic group represented by $L_{41}$ in Formula (Ia-4) is not particularly limited, and examples thereof include a trivalent organic group represented by Formula (L3).

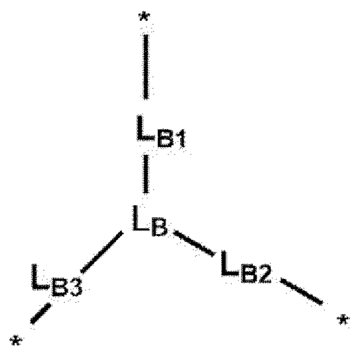

(L3)

In Formula (L3), $L_B$ represents a trivalent hydrocarbon ring group or a trivalent heterocyclic group. * represents a bonding position.

The above-described hydrocarbon ring group may be an aromatic hydrocarbon ring group or an aliphatic hydrocarbon ring group. The number of carbon atoms included in the above-described hydrocarbon ring group is preferably 6 to 18, and more preferably 6 to 14. The above-described heterocyclic group may be an aromatic heterocyclic group or an aliphatic heterocyclic group. The above-described heterocycle is preferably a 5- to 10-membered ring, more

preferably a 5- to 7-membered ring, and still more preferably a 5- or 6-membered ring, each of which has at least one N atom, O atom, S atom, or Se atom in the ring structure.

Among these, as $L_B$, a trivalent hydrocarbon ring group is preferable, and a benzene ring group or an adamantane ring group is more preferable. The benzene ring group or the adamantane ring group may have a substituent. The substituent is not particularly limited, and examples thereof include a halogen atom (preferably, a fluorine atom).

In addition, in Formula (L3), $L_{B1}$ to $L_{B3}$ each independently represent a single bond or a divalent linking group. The divalent linking group represented by $L_{B1}$ to $L_{B3}$ is not particularly limited, and examples thereof include -CO-, -NR-, -O-, -S-, -SO-, $-SO_2-$, an alkylene group (preferably having 1 to 6 carbon atoms; may be linear or branched), a cycloalkylene group (preferably having 3 to 15 carbon atoms), an alkenylene group (preferably having 2 to 6 carbon atoms), a divalent aliphatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), and a divalent aromatic heterocyclic group (preferably a 5- to 10-membered ring, more preferably a 5- to 7-membered ring, and still more preferably a 5- or 6-membered ring; each having at least one of an N atom, an O atom, an S atom, or an Se atom in the ring structure), a divalent aromatic hydrocarbon ring group (preferably a 6- to 10-membered ring, and more preferably a 6-membered ring), and a divalent linking group formed by a combination of a plurality of these groups. Examples of R include a hydrogen atom and a monovalent organic group. The monovalent organic group is not particularly limited, but is preferably, for example, an alkyl group (preferably having 1 to 6 carbon atoms).

The above-described alkylene group, the above-described cycloalkylene group, the above-described alkenylene group, and the above-described divalent aliphatic heterocyclic group, divalent aromatic heterocyclic group, and divalent aromatic hydrocarbon ring group may have a substituent. Examples of the substituent include a halogen atom (preferably, a fluorine atom).

Among the above, as the divalent linking group represented by $L_{B1}$ to $L_{B3}$, -CO-, -NR-, -O-, -S-, -SO-, $-SO_2-$, an alkylene group which may have a substituent, or a divalent linking group formed by a combination of a plurality of these groups is preferable.

Among these, as the divalent linking group represented by $L_{B1}$ to $L_{B3}$, a divalent linking group represented by Formula (L3-1) is more preferable.

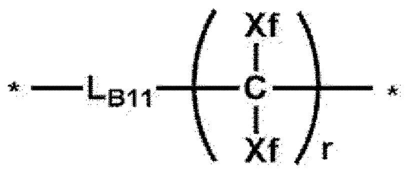 (L3-1)

In Formula (L3-1), $L_{B11}$ represents a single bond or a divalent linking group.

The divalent linking group represented by $L_{B11}$ is not particularly limited, and examples thereof include -CO-, -O-, -SO-, $-SO_2-$, an alkylene group which may have a substituent (preferably having 1 to 6 carbon atoms; may be linear or branched), and a divalent linking group formed by a combination of a plurality of these groups. The substituent is not particularly limited, and examples thereof include a halogen atom.

r represents an integer of 1 to 3.
Xf has the same meaning as Xf in Formula (L2) described above, and a suitable aspect thereof is also the same.
* represents a bonding position.

Examples of the divalent linking group represented by $L_{B1}$ to $L_{B3}$ include *-0-*, $*-O-SO_2-CF_2-*$, $*-O-SO_2-CF_2-CF_2-*$, $*-O-SO_2-CF_2-CF_2-CF_2-*$, and $*-COO-CH_2-CH_2-*$.

In a case where $L_{41}$ in Formula (Ia-4) includes the divalent organic group represented by Formula (L3-1) and the divalent organic group represented by Formula (L3-1) and $A_{42'}$ are bonded to each other, it is preferable that the bonding site (*) on the carbon atom side specified in Formula (L3-1) is bonded to $A_{42}^-$ in Formula (Ia-4).

Next, the compound represented by Formula (Ia-5) will be described.

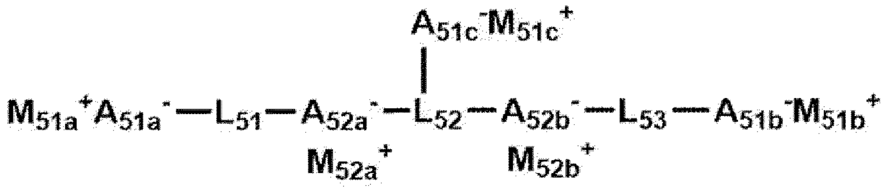

(Ia-5)

In Formula (Ia-5), $A_{51}^-$, $A_{51b}^-$, and $A_{51c}^-$ each independently represent a monovalent anionic functional group. Here, the monovalent anionic functional group represented by $A_{51a}^-$, $A_{51b}^-$, and $A_{51c}^-$ is intended to be a monovalent group including the above-described anionic moiety $A_1^-$. The monovalent anionic functional group represented by $A_{51a}^-$, $A_{51b}^-$, and $A_{51c}^-$ is not particularly limited, and examples thereof include the monovalent anionic functional group selected from the group consisting of Formulae (AX-1) to (AX-3) described above.

$A_{52a}^-$ and $A_{52b}^-$ represents a divalent anionic functional group. Here, the divalent anionic functional group represented by $A_{52a}^-$ and $A_{52b}^-$ is intended to be a divalent group including the above-described anionic moiety $A_2^-$. Examples of the divalent anionic functional group represented by $A_{22}^-$ include the divalent anionic functional group selected from the group consisting of Formulae (BX-8) to (BX-11) described above.

$M_{51a}^+$, $M_{51b}^+$, $M_{51c}^+$, $M_{52a}^+$, and $M_{52b}^+$ each independently represent an organic cation. The organic cation represented by $M_{51a}^+$, $M_{51b}^+$, $M_{51c}^+$, $M_{52a}^+$, and $M_{52b}^+$ has the same meaning as $M_1^+$ described above, and a suitable aspect thereof is also the same.

$L_{51}$ and $L_{53}$ each independently represent a divalent organic group. The divalent organic group represented by $L_{51}$ and $L_{53}$ has the same meaning as $L_{21}$ and $L_{22}$ in Formula (Ia-2) described above, and a suitable aspect thereof is also the same.

$L_{52}$ represents a trivalent organic group. The trivalent organic group represented by $L_{52}$ has the same meaning as $L_{41}$ in Formula (Ia-4) described above, and a suitable aspect thereof is also the same.

In addition, in a compound PIa-5 of Formula (Ia-5), in which the organic cation represented by $M_{51a}^+$, $M_{51b}^+$, $M_{51c}^+$, $M_{52a}^+$, and $M_{52b}^+$ is replaced with $H^+$, an acid dissociation constant a2-1 derived from an acidic moiety represented by $A_{52a}H$ and an acid dissociation constant a2-2 derived from an acidic moiety represented by $A_{52b}H$ are larger than an acid dissociation constant a1-1 derived from an acidic moiety represented by $A_{51a}H$, an acid dissociation constant a1-2 derived from an acidic moiety represented by $A_{51b}H$, and an acid dissociation constant a1-3 derived from an acidic moiety represented by $A_{51c}H$. The acid dissociation constants a1-1 to a1-3 correspond to the above-described acid dissociation constant a1, and the acid dissociation constants a2-1 and a2-2 correspond to the above-described acid dissociation constant a2.

$A_{51a}^-$, $A_{51b}^-$, and $A_{51c}^-$ may be the same or different from each other. In addition, $A_{52a}^-$ and $A_{52b}^-$ may be the same or different from each other. In addition, $M_{51a}^+$, $M_{51b}^+$, $M_{51c}^+$, $M_{52a}^+$, and $M_{52b}^+$ may be the same or different from each other.

In addition, at least one of $M_{51b}^+$, $M_{51c}^+$, $M_{52a}^+$, $M_{52b}^+$, $A_{51a}'$, $A_{51b}^-$, $A_{51c}^-$, $L_{51}$, $L_{52}$, or $L_{53}$ may have an acid-decomposable group as a substituent.

·· Compound (II)

The compound (II) is a compound having two or more of the structural moieties X and one or more of the following structural moieties Z, in which the compound generates an acid including two or more of the above-described first acidic moieties derived from the above-described structural moiety X and a structural moiety Z by irradiation with actinic ray or radiation.

Structural moiety Z: a non-ionic moiety capable of neutralizing an acid

In the compound (II), the definition of the structural moiety X and the definitions of $A_1^-$ and $M_1^+$ are the same as the definition of the structural moiety X and the definitions of $A_1^-$ and $M_1^+$ in the above-described compound (I), and suitable aspects thereof are also the same.

In a compound PII formed by replacing the above-described cationic moiety $M_1^+$ in the above-described structural moiety X with $H^+$ in the above-described compound (II), a suitable range of an acid dissociation constant a1 derived from the acidic moiety represented by $HA_1$, formed by replacing the above-described cationic moiety $M_1^+$ in the above-described structural moiety X with $H^+$, is the same as in the acid dissociation constant a1 of the above-described compound PI.

In a case where the compound (II) is, for example, a compound which generates an acid having two of the above-described first acidic moieties derived from the above-described structural moiety X and the above-described

structural moiety Z, the compound PII corresponds to "compound having two $HA_1$". In a case of obtaining acid dissociation constants of the compound PII, an acid dissociation constant in a case where the compound PII is to be "compound having one $A_1^-$ and one $HA_1$" and an acid dissociation constant in a case where the "compound having one $A_1^-$ and one $HA_1$" is to be "compound having two $A_1^-$" correspond to the acid dissociation constant a1.

The acid dissociation constant a1 can be obtained by the above-described method for measuring an acid dissociation constant.

The above-described compound PII corresponds to an acid generated in a case where the compound (II) is irradiated with actinic ray or radiation.

The above-described two or more of the structural moieties X may be the same or different from each other. In addition, two or more of $A_1$'s and two or more of $M_1^+$ may be the same or different from each other.

The non-ionic moiety capable of neutralizing an acid in the structural moiety Z is not particularly limited, and is preferably, for example, a moiety including a functional group having a group or an electron which is capable of electrostatically interacting with a proton.

Examples of the functional group having a group or electron capable of electrostatically interacting with a proton include a functional group with a macrocyclic structure, such as a cyclic polyether, or a functional group having a nitrogen atom having an unshared electron pair not contributing to $\pi$-conjugation. For example, the nitrogen atom having the unshared electron pair, which does not contribute to the $\pi$-conjugation, is a nitrogen atom having a partial structure represented by the following formula.

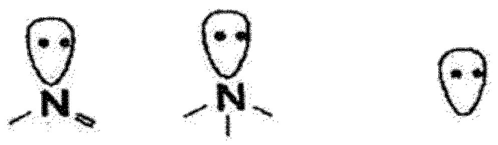

unshared electron pair

Examples of the partial structure of the functional group having a group or electron which is capable of electrostatically interacting with a proton include a crown ether structure, an azacrown ether structure, primary to tertiary amine structures, a pyridine structure, an imidazole structure, and a pyrazine structure, and among these, primary to tertiary amine structures are preferable.

The compound (II) is not particularly limited, and examples thereof include compounds represented by Formula (IIa-1) and Formula (IIa-2).

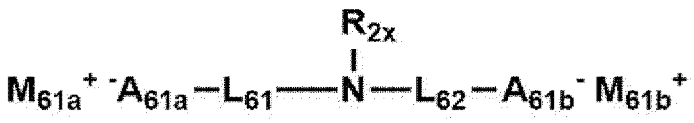

(IIa-1)

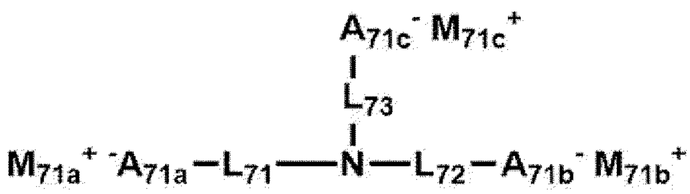

(IIa-2)

In Formula (IIa-1), $A_{61a}^-$ and $A_{61b}^-$ have the same meaning as A11- in Formula (Ia-1) described above, and suitable aspects thereof are also the same. In addition, $M_{61a}^+$ and $M_{61b}^+$ have the same meaning as $M_{11}^+$ in Formula (Ia-1) described above, and suitable aspects thereof are also the same.

In Formula (IIa-1), $L_{61}$ and $L_{62}$ have the same meaning as $L_1$ in Formula (Ia-1) described above, and suitable aspects thereof are also the same.

In Formula (IIa-1), $R_{2X}$ represents a monovalent organic group. The monovalent organic group represented by $R_{2X}$ is not particularly limited, and examples thereof include an alkyl group (which preferably has 1 to 10 carbon atoms, and may be linear or branched), a cycloalkyl group (preferably having 3 to 15 carbon atoms), and an alkenyl group

(preferably having 2 to 6 carbon atoms), in which $-CH_2-$ may be substituted with one or a combination of two or more selected from the group consisting of -CO-, -NH-, -O-, -S-, -SO-, and $-SO_2-$.

In addition, the above-described alkylene group, the above-described cycloalkylene group, and the above-described alkenylene group may have a substituent. The substituent is not particularly limited, and examples thereof include a halogen atom (preferably, a fluorine atom).

In addition, in a compound PIIa-1 of Formula (IIa-1), in which the organic cation represented by $M_{61a}^+$ and $M_{61b}^+$ is replaced with $H^+$, an acid dissociation constant a1-7 derived from an acidic moiety represented by $A_{61a}H$ and an acid dissociation constant a1-8 derived from an acidic moiety represented by $A_{61b}H$ correspond to the above-described acid dissociation constant a1.

The compound PIIa-1 formed by replacing the above-described cationic moieties $M_{61a}^+$ and $M_{61b}^+$ in the above-described structural moiety X with $H^+$ in the above-described compound (IIa-1) corresponds to $HA_{61a}$-$L_{61}$-$N(R_{2X})$-$L_{62}$-$A_{61b}H$. In addition, the acid generated from the compound PIIa-1 and the acid generated from the compound represented by Formula (IIa-1) by irradiation with actinic ray or radiation are the same.

In addition, at least one of $M_{61a}^+$, $M_{61b}^+$, $A_{61a}^-$, $A_{61b}^-$, $L_{61}$, $L_{62}$, or $R_{2X}$ may have an acid-decomposable group as a substituent.

In Formula (IIa-2), $A_{71a}^-$, $A_{71b}^-$, and $A_{7c}^-$ have the same meaning as $A_{11}^-$ in Formula (Ia-1) described above, and suitable aspects thereof are also the same. In addition, $M_{71a}^+$, $M_{71b}^+$, and $M_{71c}^+$ have the same meaning as $M_{11}^+$ in Formula (Ia-1) described above, and suitable aspects thereof are also the same.

In Formula (IIa-2), $L_{71}$, $L_{72}$, and $L_{73}$ have the same meaning as $L_1$ in Formula (Ia-1) described above, and suitable aspects thereof are also the same.

In addition, in a compound PIIa-2 of Formula (IIa-2), in which the organic cation represented by $M_{71a}^+$, $M_{71b}^+$, and $M_{71c}^+$ is replaced with $H^+$, an acid dissociation constant a1-9 derived from an acidic moiety represented by $A_{71a}H$, an acid dissociation constant a1-10 derived from an acidic moiety represented by $A_{71b}H$, and an acid dissociation constant a1-11 derived from an acidic moiety represented by $A_{71c}H$ correspond to the above-described acid dissociation constant a1.

The compound PIIa-2 formed by replacing the above-described cationic moieties $M_{71a}^+$,$M_{71b}^+$, and $M_{71c}^+$ in the above-described structural moiety X with $H^+$ in the above-described compound (IIa-1) corresponds to $HA_{71a}$-$L_{71}$-$N(L_{73}$-$A_{71c}H)$-$L_{72}$-$A_{71b}H$. In addition, the acid generated from the compound PIIa-2 and the acid generated from the compound represented by Formula (IIa-2) by irradiation with actinic ray or radiation are the same.

In addition, at least one of $M_{71a}^+$, $M_{71b}^+$, $M_{71c}^+$, $A_{71a}^-$, $A_{71b}^-$, $A_{71c}^-$, $L_{71}$, $L_{72}$, or $L_{73}$ may have an acid-decomposable group as a substituent.

In addition, the photoacid generator which is an onium salt may be a compound which has two or more of the following structural moieties X, and generates two acidic moieties derived from the following structural moiety X by irradiation with actinic ray or radiation.

Structural moiety X: a structural moiety which consists of an anionic moiety $A1^-$ and a cationic moiety $M_1^+$, and forms an acidic moiety represented by $HA_1$ by irradiation with actinic ray or radiation

The above-described two or more of the structural moieties X may be the same or different from each other. In addition, two or more of $A_1^-$'s and two or more of $M_1^+$ may be the same or different from each other.

The definition of the structural moiety X and the definitions of $A_1^-$ and $M_1^+$ are the same as the definition of the structural moiety X and the definitions of $A_1^-$ and $M_1^+$ in the above-described compound (I), and suitable aspects thereof are also the same.

The following organic cation and other moieties may be appropriately combined and used as the photoacid generator which is an onium salt.

First, the organic cation is exemplified.

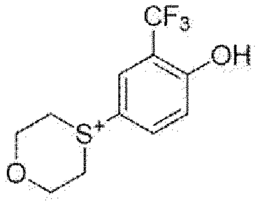
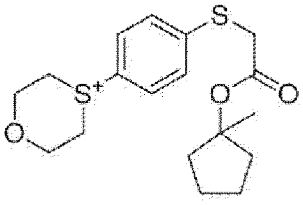
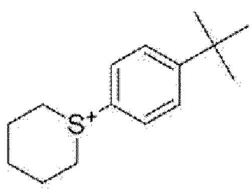
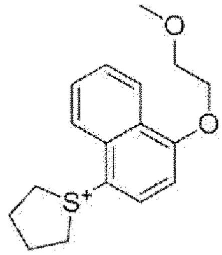

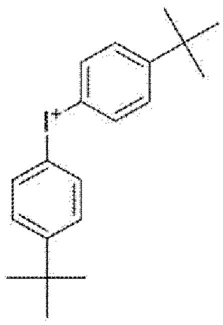
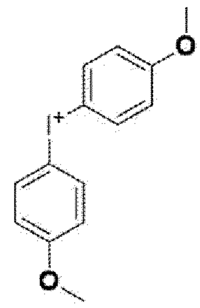
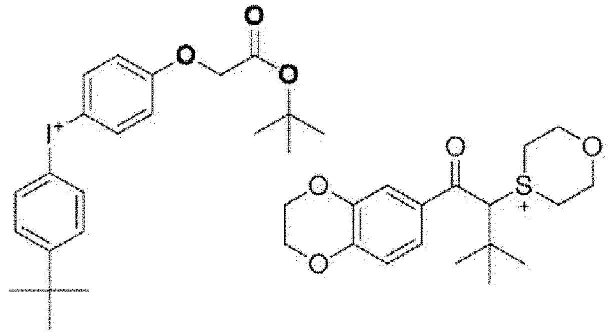

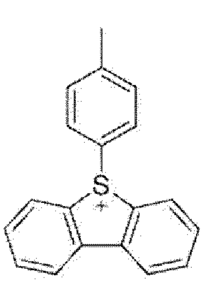
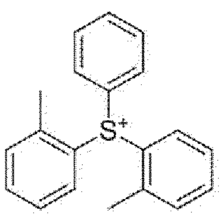
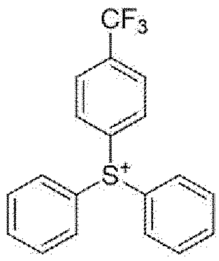
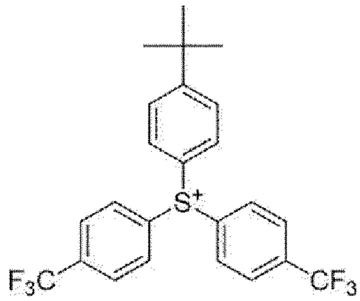

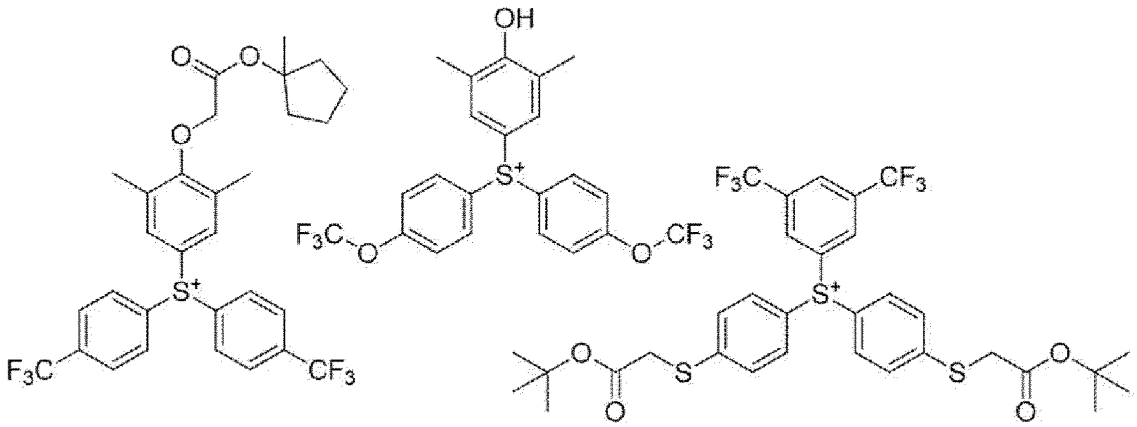

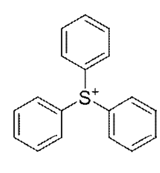
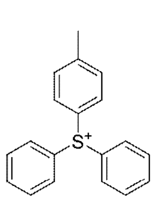
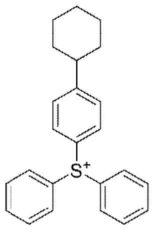
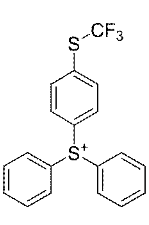
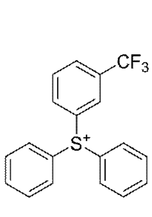
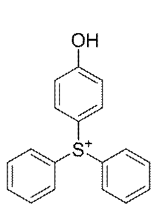

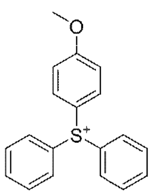
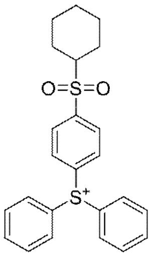
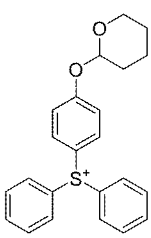
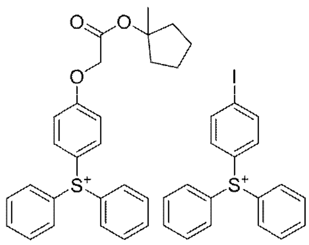
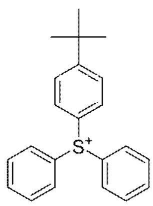

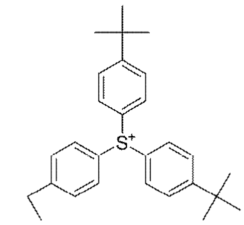
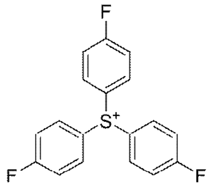
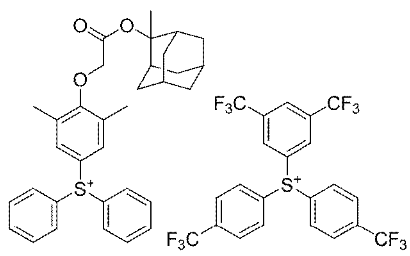

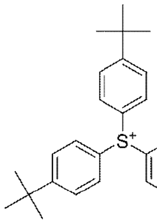
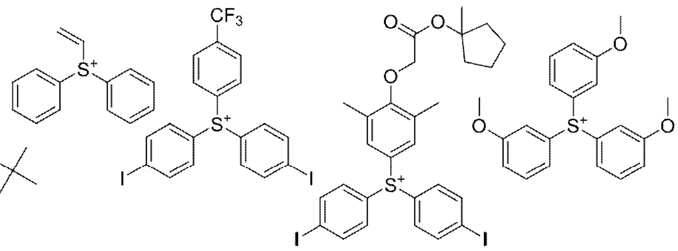

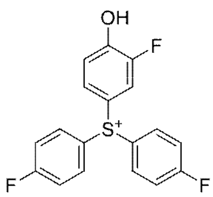
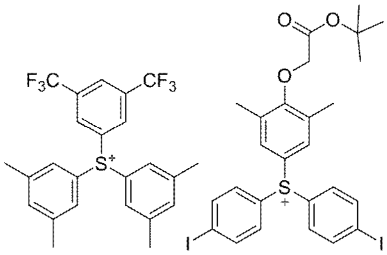
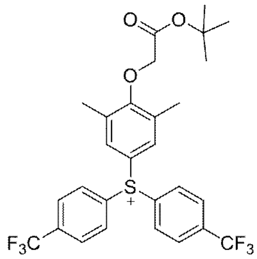

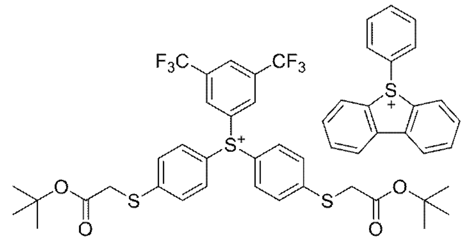
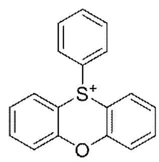
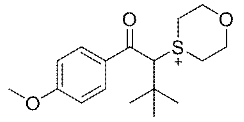

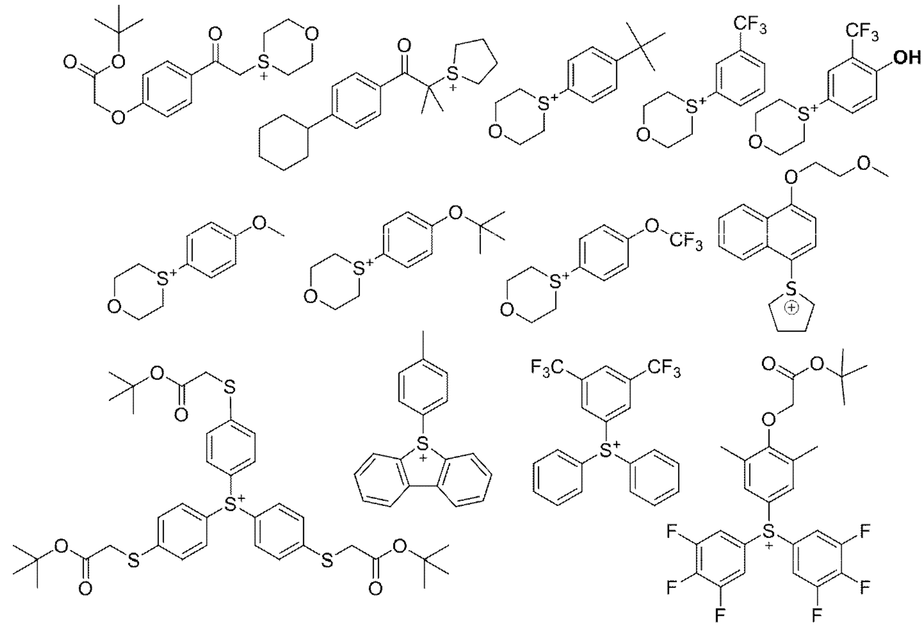

Next, a moiety (organic anion) other than the organic cation is exemplified.

In the following organic anions, a numerical value shown in the vicinity of an anionic functional group is a pKa of an acid group obtained by bonding hydrogen to each anionic functional group.

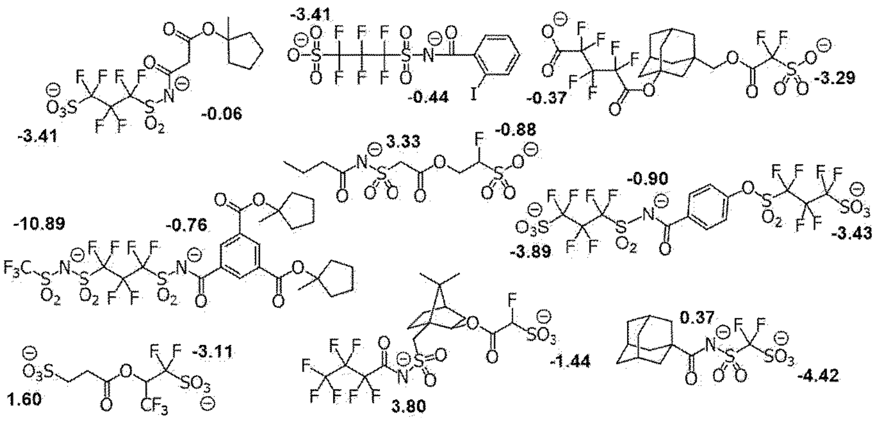

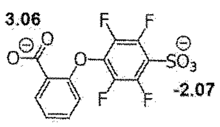

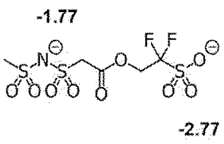

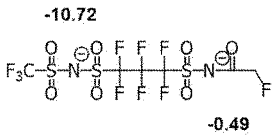

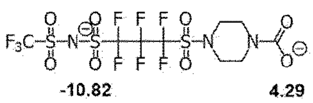

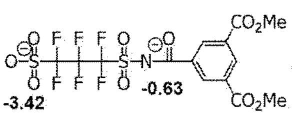

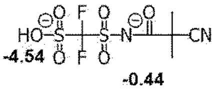

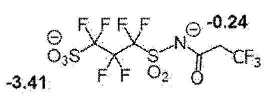

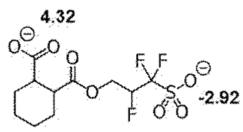

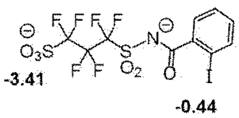

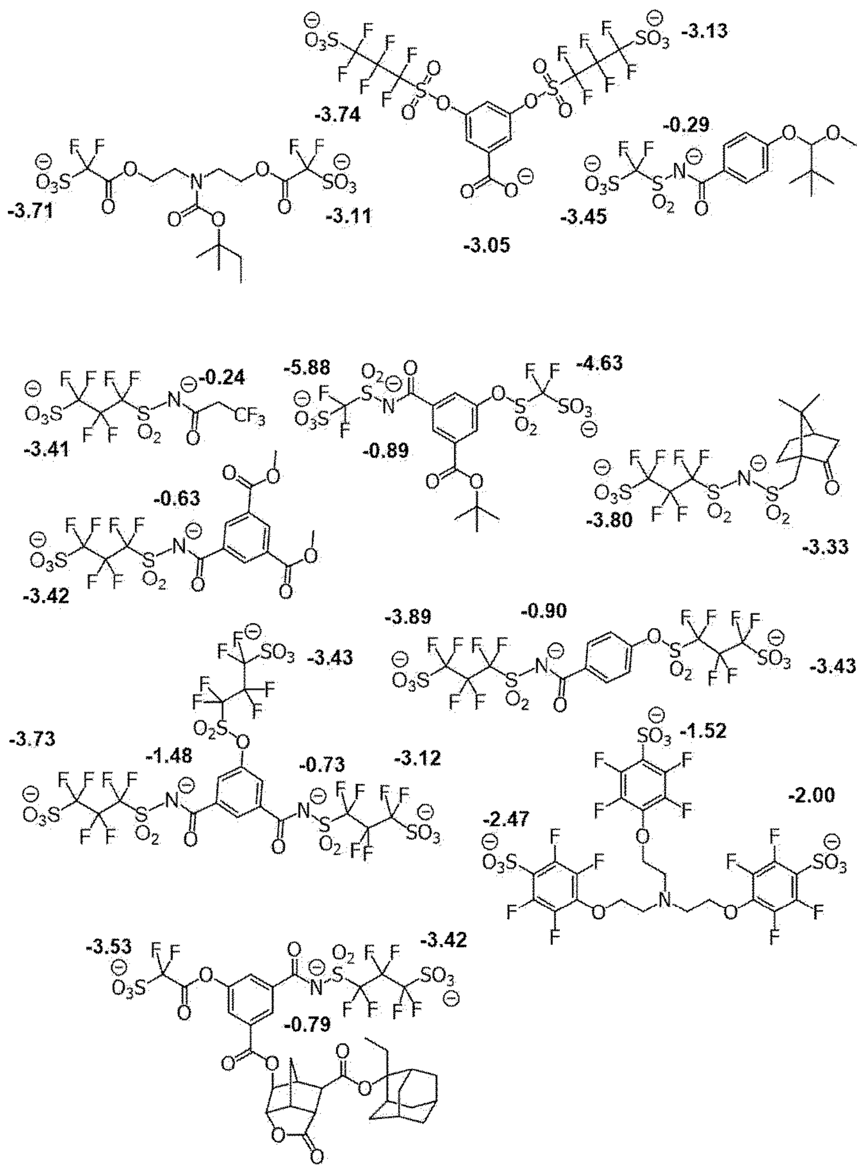

-3.13
-3.74
-0.29
-3.71
-3.11
-3.45
-3.05
-0.24
-5.88
-4.63
-3.41
-0.89
-0.63
-3.80
-3.33
-3.42
-3.89
-0.90
-3.43
-3.43
-3.73
-1.48
-0.73
-3.12
-1.52
-2.00
-2.47
-3.53
-3.42
-0.79

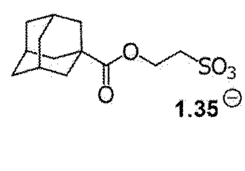

1.35

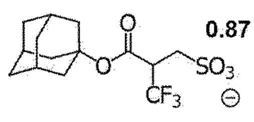

0.87

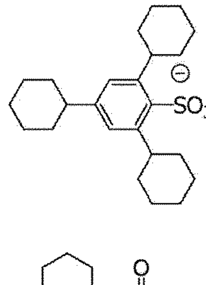

-0.22

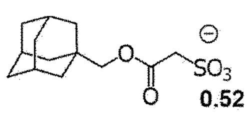

0.52

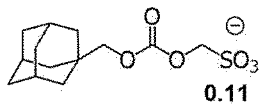

0.11

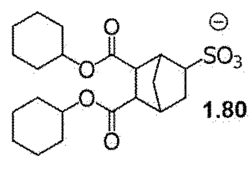

1.80

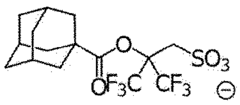

0.06

0.98

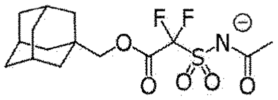

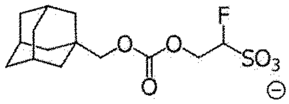

-0.81

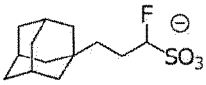

-0.03

-1.37

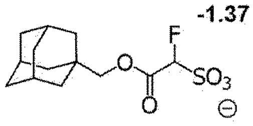

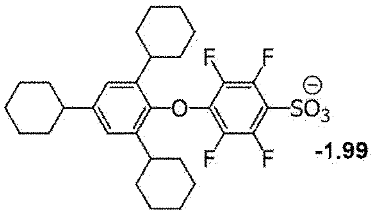

-1.99

-2.70

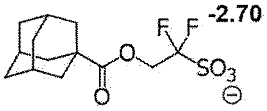

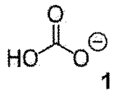

1.35

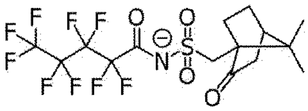

0.99

1.17

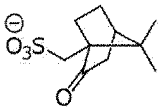

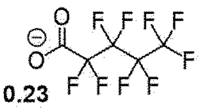

0.23

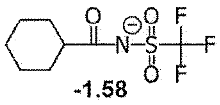

-1.58

-3.57

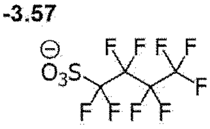

-3.29

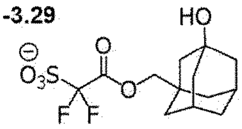

0.43

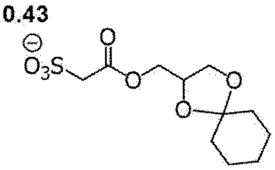

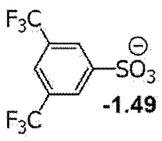

-1.49

-2.72

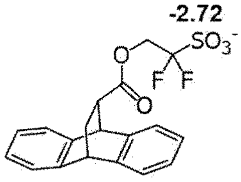

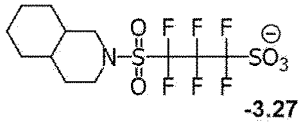

-3.27

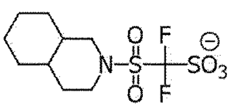

-3.45

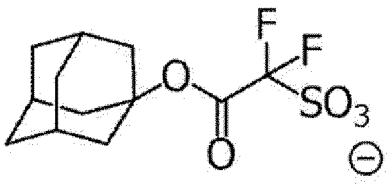

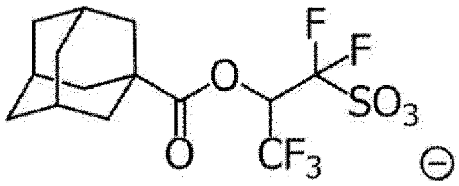

(Photoacid Generator which is Intramolecular Salt)

The photoacid generator which is an intramolecular salt preferably has a sulfonate anion or a carboxylate anion (preferably an aromatic sulfonate anion or an aromatic carboxylate anion), and it is also preferable that it further has a sulfonium cation or an iodine cation.

Examples of the photoacid generator which is an intramolecular salt include a compound (ZbI) and a compound (ZbII).

The above-described compound (ZbI) is a compound represented by a newly defined general formula in which, in General Formula (ZaI) described above, one of $R^{201}$ to $R^{203}$ is an aryl group having, as a substituent, a group including $-SO_3^-$ or $-COO^-$.

The above-described compound (ZbII) is a compound represented by a newly defined general formula in which, in General Formula (ZaII) described above, one of $R^{204}$ or $R^{205}$ is an aryl group having, as a substituent, a group including $-SO_3^-$ or $-COO^-$.

Examples of the group including $-SO_3^-$ or $-COO^-$ in the compound (ZbI) and the compound (ZbII) include a group obtained by excluding W from the organic anion represented by Formula (AN) shown in the description of organic anion (group represented by "$AX-[C(Xf)(Xf)]_o-[C(R_4)(R_5)]_p-(L)_q-$").

The photoacid generator which is an intramolecular salt is exemplified.

In the following photoacid generators, a numerical value shown in the vicinity of a moiety (an anionic functional group) where a hydrogen atom of an acid group is substituted with a cation indicates a pKa of the acid group assuming no hydrogen atom is substituted with the cation.

In other words, the pKa shown below is a pKa of an acid group in a compound (acid) assuming that an anionic functional group of the intramolecular salt is bonded to a hydrogen atom (a group in which the anionic functional group is bonded to a hydrogen atom).

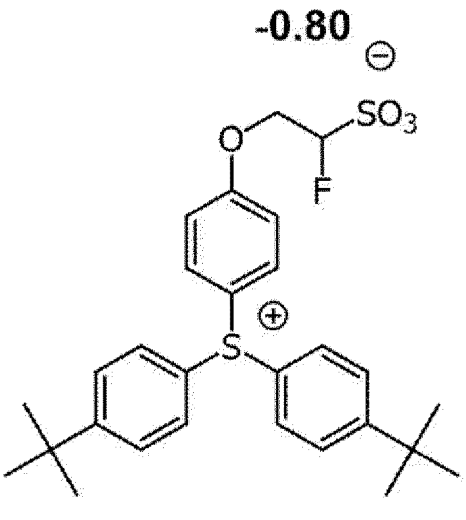


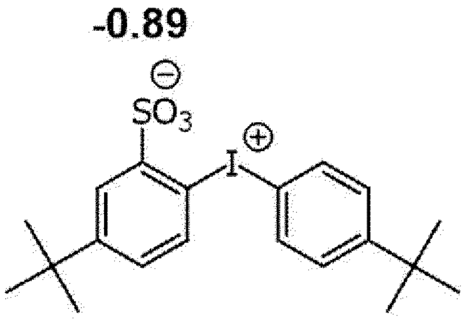


<Photoacid Generator which is Non-Ionic Compound>

Examples of the photoacid generator which is a non-ionic compound include a compound in which the group represented by any of General Formulae (a1) to (a6) is bonded to an organic group A (a compound consisting of the organic group A and the group represented by any of General Formulae (a1) to (a6), which is bonded to the organic group A at the bonding position (*)); a compound in which the group represented by "$-SO_2-SO_2-$organic group" is bonded to the organic group A; a compound in which the group represented by "$-SO_2-C(=N_2)-SO_2-$organic group" is bonded to the organic group A; a compound in which the group represented by "$-SO_2-O-SO_2-$organic group" and the group represented by "$-SO_2-O-C(=N_2)-SO_2-$organic group" are bonded to the organic group A; and a compound in which the

group represented by "-$SO_2$-O-O-organic group" is bonded to the organic group A, which are all described in relation to the repeating unit (a).

Examples of the above-described organic group A include the same organic group described as the organic group represented by $Q^1$ and $Q^2$ in General Formula (a1).

In addition, as the photoacid generator, from the viewpoint of suppressing diffusion of the acid generated by exposure to a non-exposed portion to improve resolution, a compound which generates an acid with a volume of 130 $Å^3$ or more by irradiation with electron beam or extreme ultraviolet ray is preferable, and a compound which generates an acid with a volume of 150 $Å^3$ or more by irradiation with electron beam or extreme ultraviolet ray is more preferable. In addition, from the viewpoint of sensitivity and solubility in a coating solvent, the above-described volume is preferably 2,000 $Å^3$ or less, and more preferably 1,500 $Å^3$ or less.

$$1\ Å \text{ is } 1 \times 10^{-10}\ m.$$

In the present specification, a volume value of the acid generated from the photoacid generator is a value calculated by the following method.

A structure of the generated acid is optimized by a parameterized model number 3 (PM3) method using MOPAC7 enclosed with Winmostar (software manufactured by X-Ability Co., Ltd.). A Van der Waals volume is calculated for the obtained optimized structure by the method described in Non-Patent Document 1, using the Winmostar (software manufactured by X-Ability Co., Ltd.).

Non-Patent Document 1: Improvement of molecular surface area and volume calculation program, Teruo Nagao, Bulletin of Hakodate National College of Technology, No. 27, pp. 111 to 120, 1993

With regard to the photoacid generator, reference can be made to paragraphs [0368] to [0377] of JP2014-41328A and paragraphs [0240] to [0262] of JP2013-228681A (corresponding to paragraph [0339] of US2015/004533A) as long as they correspond to the above-described basic compound, the contents of which are incorporated herein by reference.

The photoacid generator may be used alone or in combination of two or more kinds thereof.

In a case where the resist composition according to the embodiment of the present invention contains a photoacid generator, a content thereof is preferably more than 0% by mass and 20% by mass or less, more preferably 0.5% to 10% by mass, and still more preferably 1% to 15% by mass with respect to the total solid content of the resist composition.

[Surfactant]

The resist composition may contain a surfactant. In a case where the surfactant is contained, it is possible to form a pattern having more excellent adhesiveness and fewer development defects.

The surfactant is preferably a fluorine-based and/or silicon-based surfactant.

As the fluorine-based and/or silicon-based surfactant, for example, surfactants described in paragraphs [0218] and [0219] of WO2018/19395A can be used.

In a case where the resist composition contains a surfactant, a content thereof is preferably 0.0001% to 2% by mass, and more preferably 0.0005% to 1% by mass with respect to the total solid content of the composition.

The surfactant may be used alone or in combination of two or more kinds thereof. In a case where two or more kinds of the compounds are used, a total content thereof is preferably within the suitable content range.

[Solvent]

The resist composition may contain a solvent.

The solvent preferably includes at least one solvent of (M1) propylene glycol monoalkyl ether carboxylate or (M2) at least one selected from the group consisting of propylene glycol monoalkyl ether, lactic acid ester, acetic acid ester, alkoxypropionic acid ester, chain ketone, cyclic ketone, lactone, and alkylene carbonate. The solvent may further include a component other than the components (M1) and (M2).

The present inventors have found that, by using such a solvent and the above-described resin in combination, a pattern having a small number of development defects can be formed while improving coating property of the composition. A reason for this is not always clear, but the present inventors have considered that, since these solvents have a good balance of solubility, boiling point, and viscosity of the above-described resin, unevenness of a film thickness of a composition film, generation of precipitates during spin coating, and the like can be suppressed.

Details of the component (M1) and the component (M2) are described in paragraphs [0218] to [0226] of WO2020/004306A.

In a case where the solvent further contains a component other than the components (M1) and (M2), a content of the component other than the components (M1) and (M2) is preferably 5% to 30% by mass with respect to the total

amount of the solvent.

The solvent may be used alone or in combination of two or more kinds thereof.

A content of the solvent in the resist composition is preferably set such that a concentration of solid contents is 30% by mass or less, more preferably set such that a concentration of solid contents is 10% by mass or less, and still more preferably set such that a concentration of solid contents is 2% by mass or less. The lower limit value thereof is preferably set to be 0.05% by mass or more, more preferably set to be 0.1% by mass or more, and still more preferably set to be 0.5% by mass or more.

With this content, the coating property of the resist composition can be further improved.

In other words, the content of the solvent in the resist composition is preferably 70% to 99.95% by mass and more preferably 90% to 99.9% by mass with respect to the total mass of the resist composition. 98% to 99.5% by mass is more preferable.

[Other Additives]

The resist composition may further contain other resins not corresponding to the resin (A) (a hydrophobic resin and the like), an acid diffusion control agent other than the basic compound, a dissolution inhibiting compound, a dye, a plasticizer, a photosensitizer, a light absorbing agent, and/or a compound promoting a solubility in a developer (an alicyclic or aliphatic compound including a carboxylic acid group).

The resist composition may further contain a dissolution inhibiting compound. Here, the "dissolution inhibiting compound" is intended to be a compound having a molecular weight of 3000 or less, in which solubility in an organic developer decreases by decomposition due to action of acid.

The resist composition according to the embodiment of the present invention is also suitably used as a photosensitive composition for EUV exposure or a photosensitive composition for electron beam exposure.

EUV light and electron beam are greatly affected by "photon shot noise" in which the number of photons varies probabilistically is large, which causes deterioration of LER and bridge defects. In order to reduce the photon shot noise, there is a method of increasing the number of incident photons by increasing an exposure amount, but this tends to be a trade-off with the demand for higher sensitivity.

In a case where an A value obtained by Expression (1) is high, absorption efficiency of EUV and electron beams of the resist film formed from the resist composition is high, which is effective in reducing the photon shot noise. The A value represents the absorption efficiency of EUV and electron beams of the resist film in terms of a mass proportion.

$$\text{Expression (1): } A = ([H] \times 0.04 + [C] \times 1.0 + [N] \times 2.1 + [O] \times 3.6 + [F] \times 5.6 + [S] \times 1.5 + [I] \times 39.5)/([H] \times 1 + [C] \times 12 + [N] \times 14 + [O] \times 16 + [F] \times 19 + [S] \times 32 + [I] \times 127)$$

The A value is preferably 0.120 or more. An upper limit thereof is not particularly limited, but in a case where the A value is extremely high, the transmittance of EUV and electron beams of the resist film is lowered and the optical image profile in the resist film is deteriorated, which results in difficulty in obtaining a good pattern shape, and therefore, the upper limit is preferably 0.240 or less, and more preferably 0.220 or less.

In Expression (1), [H] represents a molar ratio of hydrogen atoms derived from a total solid content with respect to all atoms of the total solid content in the actinic ray-sensitive or radiation-sensitive resin composition, [C] represents a molar ratio of carbon atoms derived from the total solid content with respect to all atoms of the total solid content in the actinic ray-sensitive or radiation-sensitive resin composition, [N] represents a molar ratio of nitrogen atoms derived from the total solid content with respect to all atoms of the total solid content in the actinic ray-sensitive or radiation-sensitive resin composition, [O] represents a molar ratio of oxygen atoms derived from the total solid content with respect to all atoms of the total solid content in the actinic ray-sensitive or radiation-sensitive resin composition, [F] represents a molar ratio of fluorine atoms derived from the total solid content with respect to all atoms of the total solid content in the actinic ray-sensitive or radiation-sensitive resin composition, [S] represents a molar ratio of sulfur atoms derived from the total solid content with respect to all atoms of the total solid content in the actinic ray-sensitive or radiation-sensitive resin composition, and [I] represents a molar ratio of iodine atoms derived from the total solid content with respect to all atoms of the total solid content in the actinic ray-sensitive or radiation-sensitive resin composition.

For example, in a case where the resist composition contains the resin (A), the basic compound, and the solvent, the resin (A) and the basic compound correspond to the solid content. That is, all atoms of the total solid content correspond to a sum of all atoms derived from the resin (A) and all atoms derived from the basic compound. For example, [H] represents a molar ratio of hydrogen atoms derived from the total solid content with respect to all atoms in the total solid content, and by way of description based on the example above, [H] represents a molar ratio of a sum of hydrogen atoms derived from the resin (A) and hydrogen atoms derived from the basic compound with respect to the sum of all

atoms derived from the resin (A) and all atoms derived from the basic compound.

The A value can be calculated by computation of the structure of constituent components of the total solid content in the resist composition, and the ratio of the number of atoms contained in a case where the content is already known. In addition, even in a case where the constituent component is not known yet, it is possible to calculate a ratio of the number of constituent atoms by subjecting a resist film obtained after evaporating the solvent components of the resist composition to computation according to an analytic approach such as elemental analysis.

[Resist Film and Pattern Forming Method]

A procedure of the pattern forming method using the above-described resist composition is not particularly limited, but preferably has the following steps.

Step 1: step of forming a resist film on a substrate using the resist composition
Step 2: step of exposing the resist film
Step 3: step of developing the exposed resist film using a developer

It is more preferable that an alkali developer is used as the developer in the step 3 and the above-described pattern forming method is performed as a positive tone pattern forming method.

Hereinafter, the procedure of each of the above-described steps will be described in detail.

<Step 1: Resist Film Forming Step>

The step 1 is a step of forming a resist film on a substrate using the resist composition.

The definition of the resist composition is as described above.

Examples of a method for forming a resist film on a substrate using the resist composition include a method in which a resist composition is applied to a substrate.

In addition, it is preferable that the resist composition before the application is filtered through a filter, as desired. A pore size of the filter is preferably 0.1 μm or less, more preferably 0.05 μm or less, and still more preferably 0.03 μm or less. In addition, the filter is preferably a polytetrafluoroethylene-made filter, a polyethylene-made filter, or a nylon-made filter.

The resist composition can be applied to a substrate (for example, silicon and silicon dioxide coating) as used in the manufacture of integrated circuit elements by a suitable application method such as an application using a spinner or a coater. The coating method is preferably a spin coating using a spinner. A rotation speed upon the spin coating using a spinner is preferably 1000 to 3000 rpm.

After the application of the resist composition, the substrate may be dried to form a resist film. In addition, various underlying films (an inorganic film, an organic film, or an antireflection film) may be formed on an underlayer of the resist film.

Examples of the drying method include a method of heating and drying. The heating can be carried out using a unit included in an ordinary exposure machine and/or development machine, and may also be carried out using a hot plate or the like. A heating temperature is preferably 80°C to 150°C, more preferably 80°C to 140°C, and still more preferably 80°C to 130°C. A heating time is preferably 30 to 1000 seconds, more preferably 60 to 800 seconds, and still more preferably 60 to 600 seconds.

A film thickness of the resist film is not particularly limited, but from the viewpoint that a fine pattern having higher accuracy can be formed, is preferably 10 to 120 nm. Among these, in a case of performing EUV exposure or electron beam exposure, the film thickness of the resist film is more preferably 10 to 65 nm and still more preferably 15 to 50 nm.

A topcoat may be formed on an upper layer of the resist film using a topcoat composition.

It is preferable that the topcoat composition is not mixed with the resist film and can be uniformly applied to the upper layer of the resist film. The topcoat is not particularly limited, a topcoat known in the related art can be formed by the methods known in the related art, and for example, the topcoat can be formed based on the description in paragraphs [0072] to [0082] of JP2014-059543A.

For example, it is preferable that a topcoat including a basic compound as described in JP2013-61648A is formed on the resist film. Specific examples of the basic compound which can be included in the topcoat include a basic compound which may be included in the resist composition.

In addition, it is also preferable that the topcoat includes a compound which includes at least one group or bond selected from the group consisting of an ether bond, a thioether bond, a hydroxyl group, a thiol group, a carbonyl bond, and an ester bond.

<Step 2: Exposing Step>

The step 2 is a step of exposing the resist film.

Examples of an exposing method include a method in which the formed resist film is irradiated with actinic ray or radiation through a predetermined mask.

Examples of the actinic ray or radiation include infrared light, visible light, ultraviolet light, far ultraviolet light, extreme ultraviolet light, X-rays, and electron beams, preferably a far ultraviolet light having a wavelength of 250 nm or less, more preferably a far ultraviolet light having a wavelength of 220 nm or less, and particularly preferably a far ultraviolet light having a wavelength of 1 to 200 nm, specifically, KrF excimer laser (248 nm), ArF excimer laser (193 nm), $F_2$ excimer laser (157 nm), EUV (13 nm), X-rays, and electron beams.

Among these, actinic ray or radiation used for the exposure is preferably EUV or electron beam.

It is preferable to perform baking (heating) before performing development and after the exposure. The baking accelerates a reaction in the exposed portion, and the sensitivity and the pattern shape are improved.

A heating temperature is preferably 80°C to 150°C, more preferably 80°C to 140°C, and still more preferably 80°C to 130°C.

A heating time is preferably 10 to 1000 seconds, more preferably 10 to 180 seconds, and still more preferably 30 to 120 seconds.

The heating can be carried out using a unit included in an ordinary exposure machine and/or development machine, and may also be performed using a hot plate or the like.

This step is also referred to as post exposure bake (PEB).

<Step 3: Developing Step>

The step 3 is a step of developing the exposed resist film using a developer to form a pattern.

The developer may be either an alkali developer or a developer containing an organic solvent (hereinafter, also referred to as an organic developer), and an alkali developer is preferable.

In a case where an alkali developer is used as the developer, a positive tone pattern can be usually formed. In a case where an organic developer is used as the developer, a negative tone pattern can be usually formed.

Examples of a developing method include a method in which the substrate is immersed in a tank filled with a developer for a certain period of time (a dipping method), a method in which a development is performed by heaping a developer up onto the surface of the substrate by surface tension, and then leaving it to stand for a certain period of time (a puddle method), a method in which a developer is sprayed on the surface of the substrate (a spraying method), and a method in which a developer is continuously jetted onto the substrate rotating at a constant rate while scanning a developer jetting nozzle at a constant rate (a dynamic dispensing method).

In addition, after the step of performing the development, a step of stopping the development may be carried out while replacing the solvent with another solvent.

A developing time is not particularly limited as long as it is a period of time where the non-exposed portion of the resin is sufficiently dissolved, and is preferably 10 to 300 seconds and more preferably 20 to 120 seconds.

A temperature of the developer is preferably 0°C to 50°C and more preferably 15°C to 35°C.

As the alkali developer, it is preferable to use an aqueous alkali solution including an alkali. The type of the aqueous alkali solution is not particularly limited, and examples thereof include an aqueous alkali solution including a quaternary ammonium salt typified by tetramethylammonium hydroxide, an inorganic alkali, a primary amine, a secondary amine, a tertiary amine, an alcoholamine, a cyclic amine, or the like. Among these, the alkali developer is preferably aqueous solutions of the quaternary ammonium salts typified by tetramethylammonium hydroxide (TMAH). An appropriate amount of alcohols, a surfactant, or the like may be added to the alkali developer. An alkali concentration of the alkali developer is usually 0.1% to 20% by mass. In addition, a pH of the alkali developer is usually 10.0 to 15.0. A content of water in the alkali developer is preferably 51% to 99.95% by mass.

The organic developer is preferably a developer containing at least one organic solvent selected from the group consisting of a ketone-based solvent, an ester-based solvent, an alcohol-based solvent, an amide-based solvent, an ether-based solvent, and a hydrocarbon-based solvent.

A plurality of the above-described solvents may be mixed, or the solvent may be used in admixture with a solvent other than those described above or water. A moisture content in the entire developer is preferably less than 50% by mass, more preferably less than 20% by mass, and still more preferably less than 10% by mass, and it is particularly preferable that the entire developer contains substantially no water.

A content of the organic solvent with respect to the organic developer is preferably 50% to 100% by mass, more preferably 80% to 100% by mass, still more preferably 90 mass to 100% by mass or less, and particularly preferably 95 mass to 100% by mass or less with respect to the total amount of the developer.

<Other Steps>

It is preferable that the above-described pattern forming method includes a step of performing washing using a rinsing liquid after the step 3.

Examples of the rinsing liquid used in the rinsing step after the step of performing development using an alkali developer include pure water. An appropriate amount of a surfactant may be added to the pure water.

An appropriate amount of a surfactant may be added to the rinsing liquid.

The rinsing liquid used in the rinsing step after the developing step with an organic developer is not particularly limited as long as the rinsing liquid does not dissolve the pattern, and a solution including a common organic solvent can be used. As the rinsing liquid, a rinsing liquid containing at least one organic solvent selected from the group consisting of a hydrocarbon-based solvent, a ketone-based solvent, an ester-based solvent, an alcohol-based solvent, an amide-based solvent, and an ether-based solvent is preferably used.

A method for the rinsing step is not particularly limited, and examples thereof include a method in which the rinsing liquid is continuously jetted onto the substrate rotated at a constant rate (a spin coating method), a method in which the substrate is immersed in a tank filled with the rinsing liquid for a certain period of time (a dipping method), and a method in which the rinsing liquid is sprayed on the surface of the substrate (a spraying method).

In addition, the pattern forming method according to the embodiment of the present invention may include a heating step (postbaking) after the rinsing step. By this step, the developer and the rinsing liquid remaining between and inside the patterns are removed by baking. In addition, this step also has an effect that a resist pattern is annealed and the surface roughness of the pattern is improved. The heating step after the rinsing step is usually performed at 40°C to 250°C (preferably 90°C to 200°C) for usually 10 seconds to 3 minutes (preferably 30 seconds to 120 seconds).

In addition, an etching treatment on the substrate may be carried out using the formed pattern as a mask. That is, the substrate (or the underlayer film and the substrate) may be processed using the pattern formed in the step 3 as a mask to form a pattern on the substrate.

A method for processing the substrate (or the underlayer film and the substrate) is not particularly limited, but a method in which a pattern is formed on a substrate by subjecting the substrate (or the underlayer film and the substrate) to dry etching using the pattern formed in the step 3 as a mask is preferable. Oxygen plasma etching is preferable as the dry etching.

It is preferable that various materials (for example, the solvent, the developer, the rinsing liquid, a composition for forming the antireflection film, a composition for forming the topcoat, and the like) used in the resist composition and the pattern forming method according to the embodiment of the present invention do not include impurities such as metals. A content of the impurities included in these materials is preferably 1 ppm by mass or less, more preferably 10 ppb by mass or less, still more preferably 100 ppt by mass or less, particularly preferably 10 ppt by mass or less, and most preferably 1 ppt by mass or less. Here, examples of the metal impurities include Na, K, Ca, Fe, Cu, Mg, Al, Li, Cr, Ni, Sn, Ag, As, Au, Ba, Cd, Co, Pb, Ti, V, W, and Zn.

Examples of a method for removing the impurities such as metals from the various materials include filtration using a filter. Details of the filtration using a filter are described in paragraph [0321] of WO2020/004306A.

In addition, examples of a method for reducing the impurities such as metals included in the various materials include a method of selecting raw materials having a low content of metals as raw materials constituting the various materials, a method of subjecting raw materials constituting the various materials to filter filtration, and a method of performing distillation under the condition for suppressing the contamination as much as possible by, for example, lining the inside of a device with TEFLON (registered trademark).

In addition to the filter filtration, removal of the impurities by an adsorbing material may be performed, or a combination of filter filtration and an adsorbing material may be used. As the adsorbing material, known adsorbing materials can be used, and for example, inorganic adsorbing materials such as silica gel and zeolite and organic adsorbing materials such as activated carbon can be used. It is necessary to prevent the incorporation of impurities such as metals in the production process in order to reduce the metal impurities included in the above-described various materials. Sufficient removal of the metal impurities from a production device can be confirmed by measuring the content of metal components included in a washing solution used to wash the production device. A content of the metal components included in the washing solution after the use is preferably 100 parts per trillion (ppt) by mass or less, more preferably 10 ppt by mass or less, and still more preferably 1 ppt by mass or less.

A conductive compound may be added to an organic treatment liquid such as the rinsing liquid in order to prevent breakdown of chemical liquid pipes and various parts (a filter, an O-ring, a tube, or the like) due to electrostatic charging, and subsequently generated electrostatic discharging. The conductive compound is not particularly limited, and examples thereof include methanol. An addition amount is not particularly limited, but from the viewpoint that preferred development characteristics or rinsing characteristics are maintained, the addition amount is preferably 10% by mass or less and more preferably 5% by mass or less.

For members of the chemical liquid pipe, for example, various pipes coated with stainless steel (SUS), or a

polyethylene, polypropylene, or a fluororesin (a polytetrafluoroethylene resin, a perfluoroalkoxy resin, or the like) that has been subjected to an antistatic treatment can be used. In the same manner, for the filter or the O-ring, polyethylene, polypropylene, or a fluororesin (polytetrafluoroethylene, a perfluoroalkoxy resin, or the like) that has been subjected to an antistatic treatment can be used.

[Method for Manufacturing Electronic Device]

In addition, the present invention further relates to a method for manufacturing an electronic device, including the above-described pattern forming method (preferably the positive tone pattern forming method), and an electronic device manufactured by this manufacturing method.

The electronic device according to the embodiment of the present invention is suitably mounted on electric and electronic apparatus (for example, home appliances, office automation (OA)-related equipment, media-related equipment, optical equipment, telecommunication equipment, and the like).

Examples

Hereinbelow, the present invention will be described in more detail with reference to Examples. The materials, the amounts of materials used, the proportions, the treatment details, and the treatment procedure in Examples below may be appropriately modified as long as the modifications do not depart from the spirit of the present invention. Therefore, the scope of the present invention should not be construed as being limited to Examples shown below.

[Various Components of Actinic Ray-Sensitive or Radiation-Sensitive Resin Composition (Resist Composition)]

Components contained in a resist composition used for tests in Examples are described below.

[Resin]

With regard to resins used for preparing the resist composition, types of repeating units of the resin, molar ratio thereof, weight-average molecular weight (Mw) of the resin, and dispersity (Pd (Mw/Mn)) of the resin are shown below.

Each resin shown in the following tables was synthesized according to the synthesis method (Synthesis Example 1) of a resin A-1 described later.

(A-1) 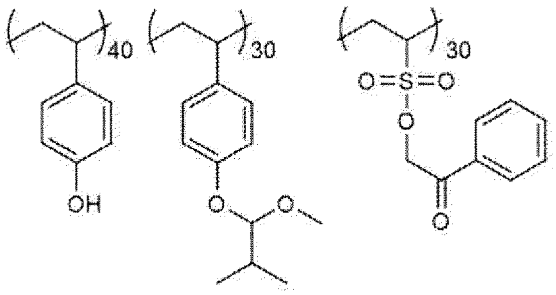 Mw 8600 Pd 1.72

(A-2) 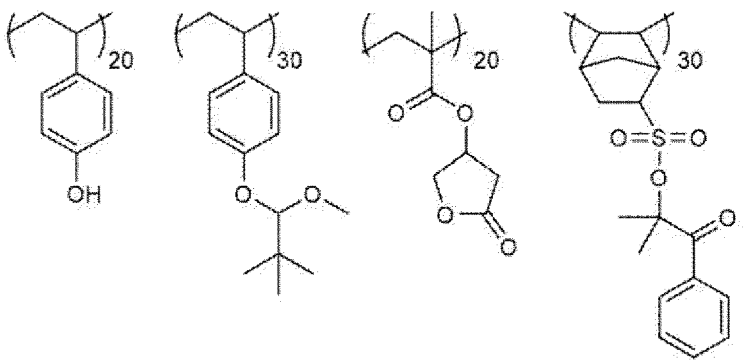 Mw 6200 Pd 1.70

(A-3)

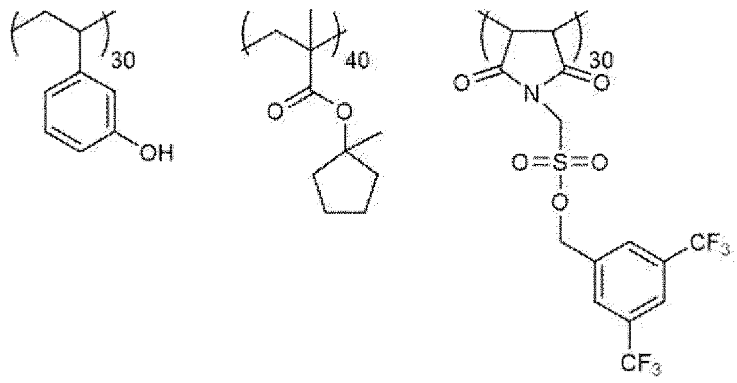

Mw 9900
Pd 1.65

(A-4)

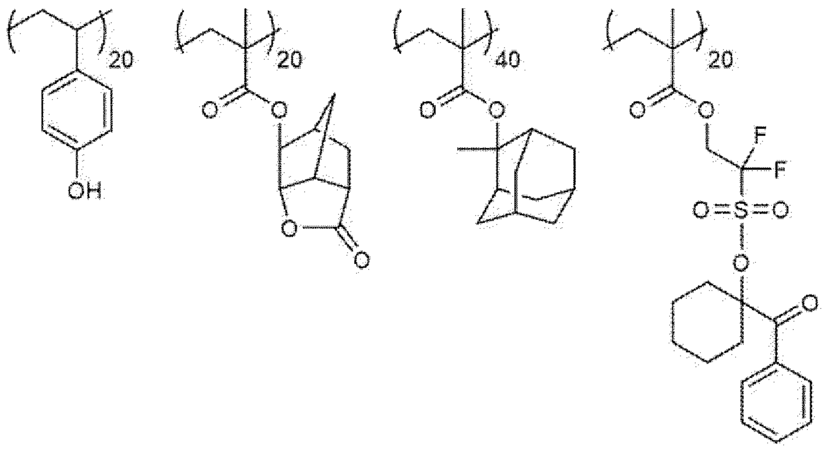

Mw 7300
Pd 1.71

(A-5)

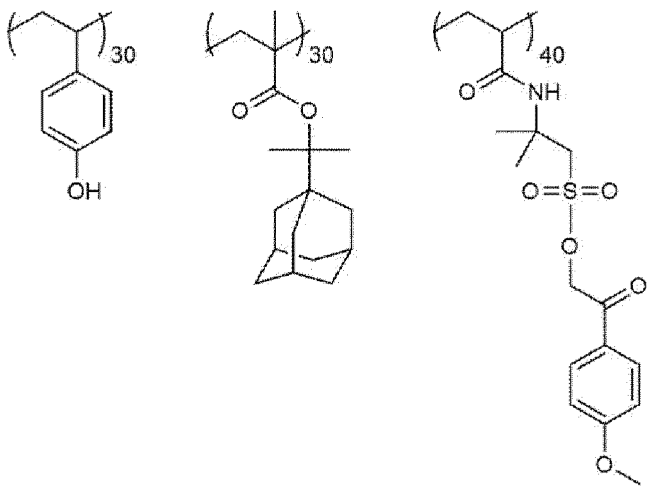

Mw 10100
Pd 1.75

(A-6) 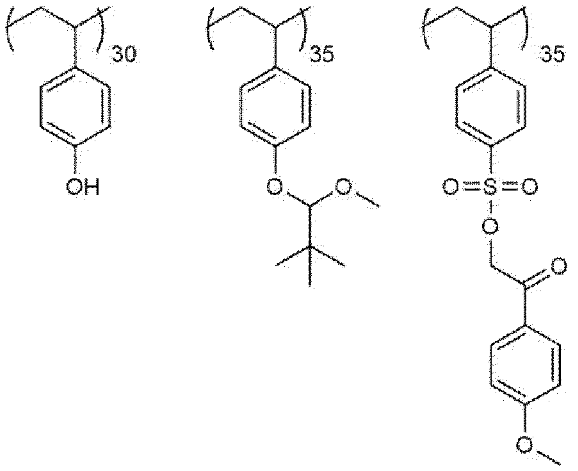 Mw 8100 Pd 1.76

(A-7) 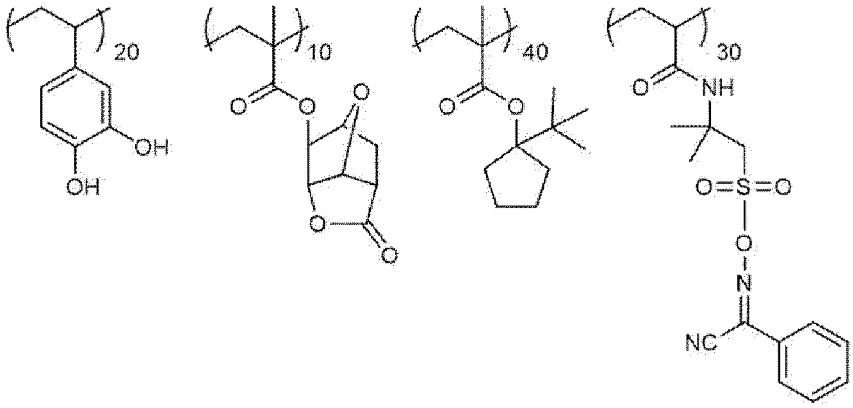 Mw 12700 Pd 1.68

(A-8) 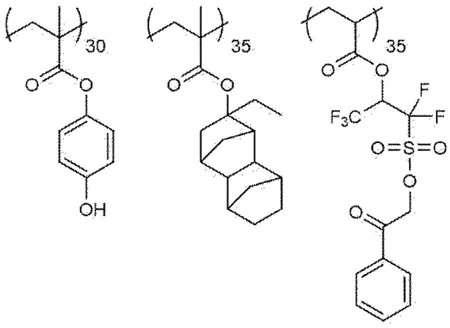 Mw 4600 Pd 1.78

(A-9) 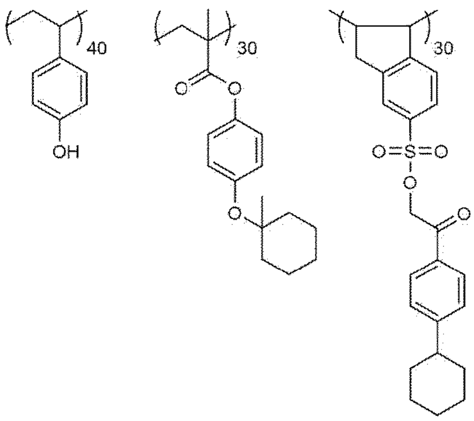 Mw 8500 Pd 1.73

(A-10)

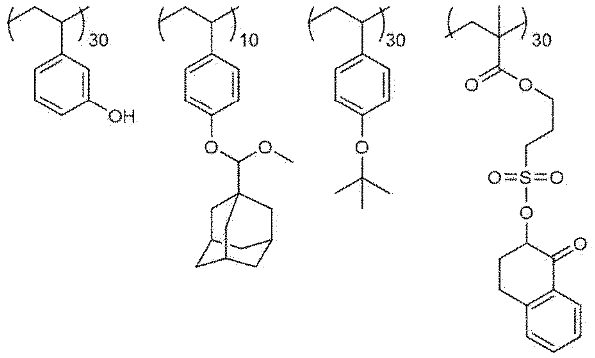

Mw 6900
Pd 1.72

(A-11)

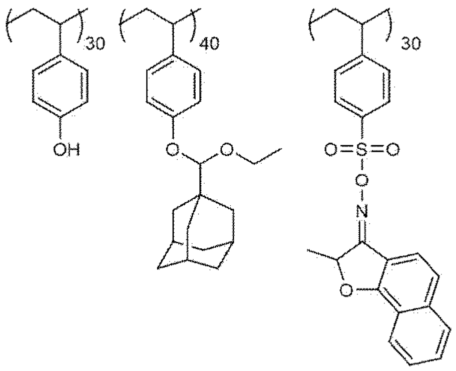

Mw 9600
Pd 1.77

(A-12)

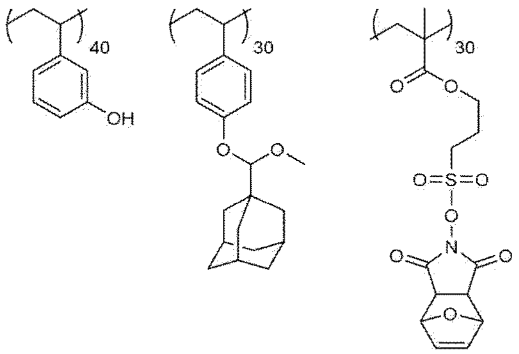

Mw 5600
Pd 1.71

(A-13)

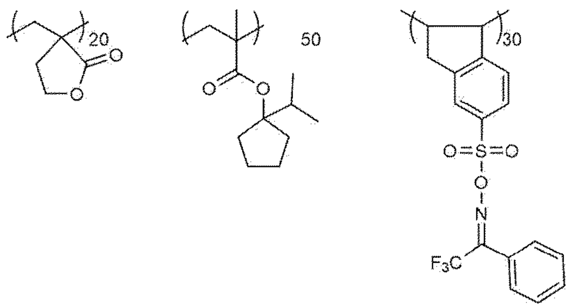

Mw 8900
Pd 1.72

(A-14)

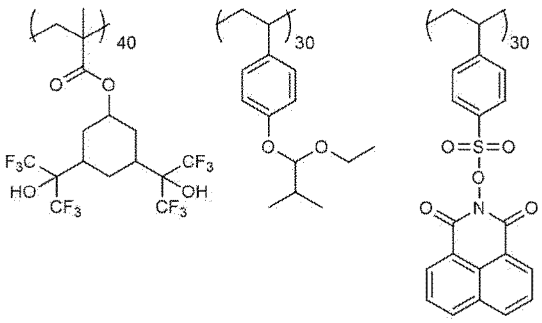

Mw 11600
Pd 1.62

(A-15)

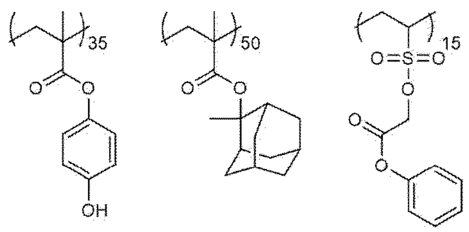

Mw 7300
Pd 1.78

(A-16)

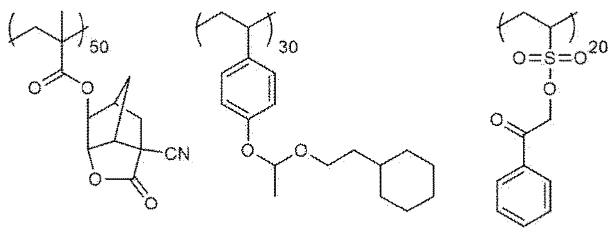

Mw 6700
Pd 1.75

(A-17)

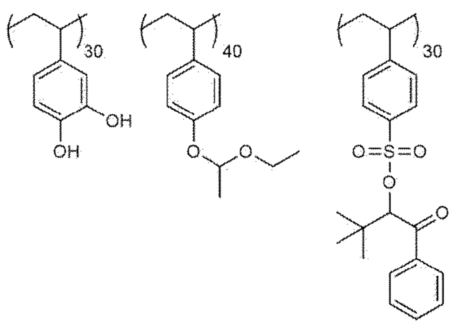

Mw 9600
Pd 1.66

(A-18)

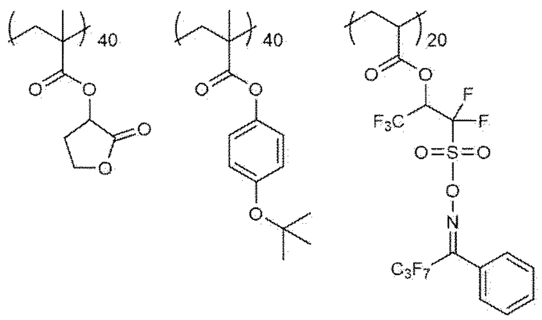

Mw 7200
Pd 1.69

(A-19)

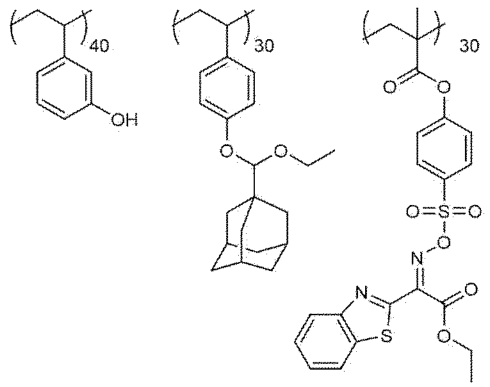

Mw 8400
Pd 1.71

(A-20)

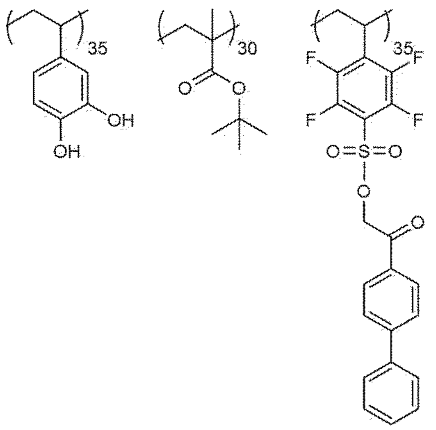

Mw 9100
Pd 1.62

(A-21)

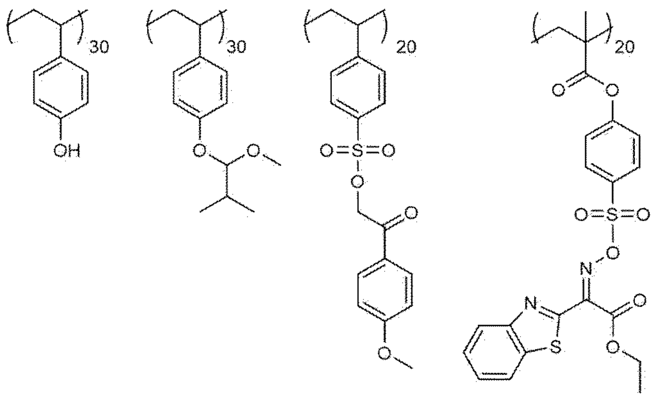

Mw 9200
Pd 1.76

(A-22)

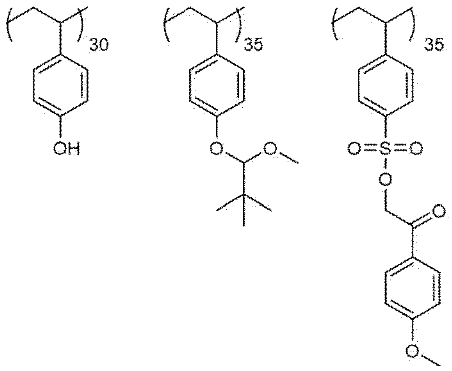

Mw 8400
Pd 1.75

(A-23)

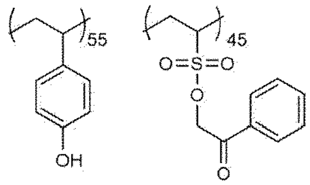

Mw 8300
Pd 1.73

(AX-1)

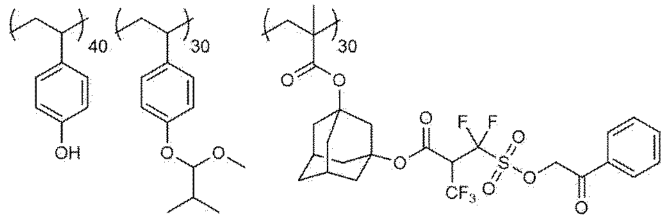

Mw 8800
Pd 1.73

(AX-2)

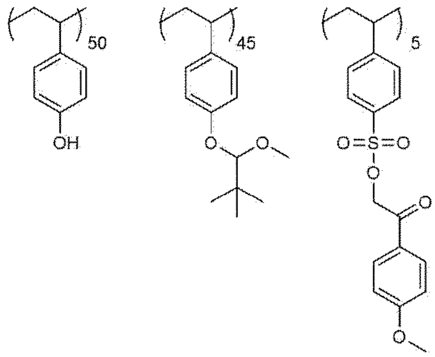

Mw 8200
Pd 1.71

(AX-3)

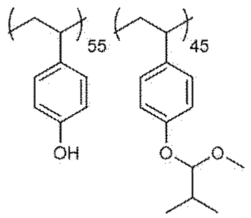

Mw 8000
Pd 1.74

(AX-4)

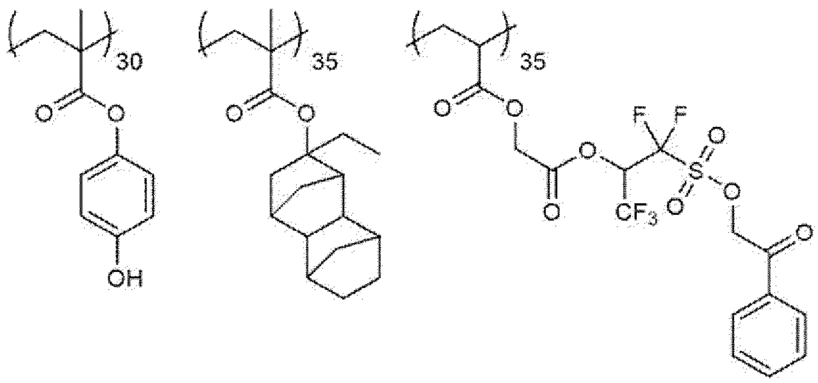

Mw 4800
Pd 1.76

Features of each of the above-described resins are shown below.

In the following, "Molecular weight after elimination" indicates a molecular weight of a repeating unit obtained by replacing, with a hydrogen atom, a leaving group of a repeating unit (repeating unit (a)) in each resin, which has a non-ionic group generating an acid in a case where the leaving group is eliminated by irradiation with actinic ray or radiation.

"Acid pKa" indicates a pKa of an acid generated by the elimination of the leaving group by irradiation with actinic

ray or radiation in the repeating unit (a) of each resin.

"Acid-decomposable unit" indicates the presence or absence of the repeating unit having an acid-decomposable group. A case of having the repeating unit having an acid-decomposable group is denoted as A, and a case of not having the repeating unit having an acid-decomposable group is denoted as B.

"Formula A2" indicates the presence or absence of the repeating unit represented by General Formula (A2). A case of having the repeating unit represented by General Formula (A2) is denoted as A, and a case of not having the repeating unit represented by General Formula (A2) is denoted as B.

In each of the above-described resins, the rightmost repeating unit corresponds to the repeating unit which has a non-ionic group generating an acid in a case where the leaving group is eliminated by irradiation with actinic ray or radiation. However, in the resin A-21, the second repeating unit from the right and the rightmost repeating unit correspond to the repeating unit which has a non-ionic group generating an acid in a case where the leaving group is eliminated by irradiation with actinic ray or radiation.

In addition, the resin AX-3 does not have the repeating unit which has a non-ionic group generating an acid in a case where the leaving group is eliminated by irradiation with actinic ray or radiation.

| | Molecular weight after elimination | Acid pKa | Acid-decomposable unit | Formula A2 |
|---|---|---|---|---|
| A-1 | 108 | 2.00 | A | A |
| A-2 | 174 | 2.16 | A | A |
| A-3 | 191 | 0.36 | A | A |
| A-4 | 230 | -2.70 | A | A |
| A-5 | 207 | 1.70 | A | A |
| A-6 | 184 | -0.48 | A | A |
| A-7 | 207 | 1.70 | A | A |
| A-8 | 284 | -3.10 | A | A |
| A-9 | 196 | -0.33 | A | A |
| A-10 | 208 | 1.55 | A | A |
| A-11 | 184 | -0.48 | A | A |
| A-12 | 208 | 1.55 | A | A |
| A-13 | 196 | -0.33 | A | B |
| A-14 | 184 | -0.48 | A | B |
| A-15 | 108 | 2.00 | A | A |
| A-16 | 108 | 2.00 | A | B |
| A-17 | 184 | -0.48 | A | A |
| A-18 | 284 | -3.10 | A | B |
| A-19 | 242 | -0.76 | A | A |
| A-20 | 256 | -2.02 | A | A |
| A-21 | 184/242 | -0.48/-0.76 | A | A |
| A-22 | 184 | -0.48 | A | A |
| A-23 | 108 | 2.00 | B | A |
| AX-1 | 476 | -2.92 | A | A |
| AX-2 | 184 | -4.80 | A | A |
| AX-3 | - | - | A | A |
| AX-4 | 342 | -3.14 | A | A |

<Synthesis Example 1: Synthesis of Resin A-1>

Cyclohexanone (70 g) was heated to 85°C under a nitrogen stream. While stirring this liquid, a mixed solution of a monomer (28.8 g) represented by Formula M-1, a monomer (37.1 g) represented by Formula M-2, a monomer (40.7 g) represented by Formula M-3, cyclohexanone (130 g), and dimethyl 2,2'-azobisisobutyrate [V-601, manufactured by FUJIFILM Wako Pure Chemical Corporation] (6.2 g) was added dropwise thereto over 3 hours to obtain a reaction solution. After completion of dropwise addition, the reaction solution was further stirred at 85°C for 3 hours. The obtained reaction solution was cooled, then reprecipitated with 5000 g of ethyl acetate/heptane (mass ratio: 1:9), and filtered, and the obtained solid was vacuum-dried to obtain the resin A-1 (81 g). However, all the above-described operations were

carried out under a yellow light.

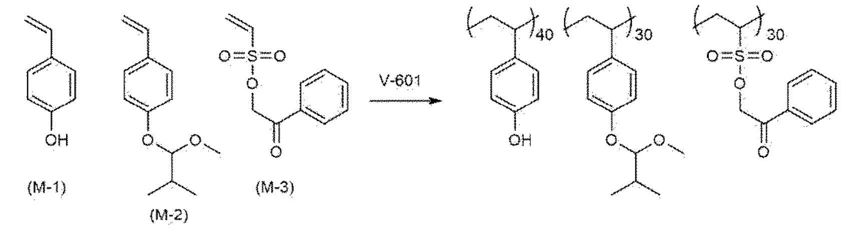

(M-1) (M-2) (M-3) (A-1)

[Basic Compound]

Structures of basic compounds used for preparing the resist composition are shown below.

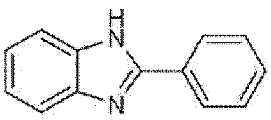
(D-1)

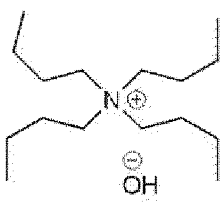
(D-2)

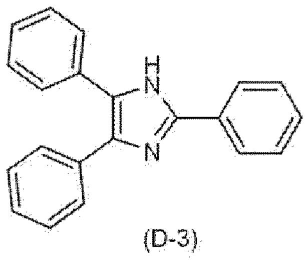
(D-3)

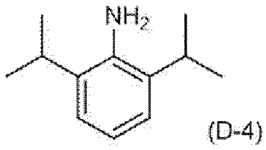
(D-4)

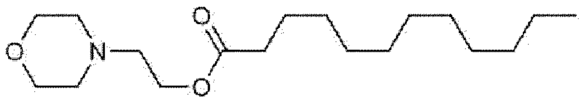
(D-5)

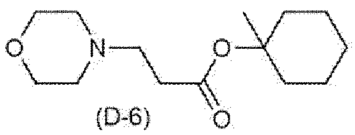
(D-6)

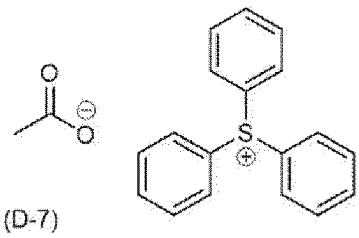
(D-7)

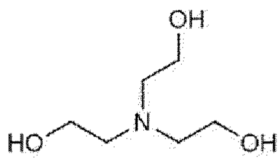
(D-8)

A pKa of a conjugate acid of each of the above-described basic compounds is shown below.

| | pKa of conjugate acid |
|---|---|
| D-1 | 5.35 |
| D-2 | 15.74 |
| D-3 | 5.43 |
| D-4 | 4.25 |
| D-5 | 6.47 |
| D-6 | 6.98 |
| D-7 | 4.79 |
| D-8 | 7.77 |

[Photoacid Generator]

Structures of photoacid generators used for preparing the resist composition are shown below.

In any of the following photoacid generators, pKa of the conjugate acid is not in a range of 3.00 to 13.00.

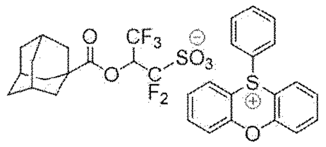

(B-1)

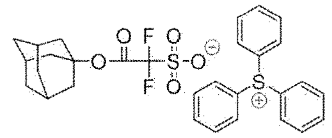

(B-2)

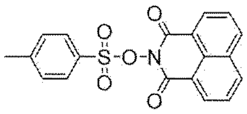

(B-3)

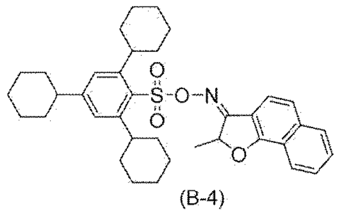

(B-4)

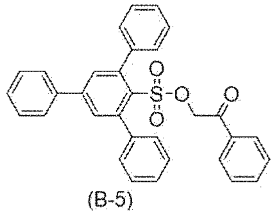

(B-5)

[Surfactant]

Structures of surfactants used for preparing the resist composition are shown below.

W-1: MEGAFACE F176 (manufactured by DIC CORPORATION; fluorine-based)
W-2: MEGAFACE R08 (manufactured by DIC CORPORATION; fluorine and silicon-based)
W-3: Polysiloxane polymer KP-341 (manufactured by Shin-Etsu Chemical Co., Ltd.; silicon-based)
W-4: TROYSOL S-366 (manufactured by Troy Corporation)
W-5: KH-20 (manufactured by AGC SEIMI CHEMICAL CO., LTD.)
W-6: PolyFox PF-6320 (manufactured by OMNOVA Solutions Inc.; fluorine-based)

[Solvent]

Solvents used for preparing the resist composition are shown below.

SL-1: Propylene glycol monomethyl ether acetate (PGMEA)
SL-2: Propylene glycol monomethyl ether propionate
SL-3: 2-Heptanone
SL-4: Ethyl lactate
SL-5: Propylene glycol monomethyl ether (PGME)
SL-6: Cyclohexanone
SL-7: γ-Butyrolactone
SL-8: Propylene carbonate

[Preparation of Resist Composition]

Each of the components (resin, photoacid generator, basic compound, and surfactant) of the type and amount shown in Table 1 later was dissolved in the solvent shown in Table 1, and the obtained solution was filtered through a polyethylene filter having a pore size of 0.02 μm to obtain a resist composition of each Example or Comparative Example.
The amount of the solvent for dissolving each of the components was adjusted so that the concentration of solid contents of the finally obtained resist composition was 3.0% by mass.
The solid content means all components excluding the solvent.

[Test]

[Production of Resist Film]

The resist composition of each Example and Comparative Example was applied onto a 6-inch silicon (Si) wafer pre-treated with hexamethyldisilazane (HMDS) using a spin coater Mark 8 manufactured by Tokyo Electron Limited, and dried on a hot plate at 130°C for 300 seconds to obtain a resist film having a film thickness of 100 nm.
Here, 1 inch is 0.0254 m.

[Electron Beam (EB) Drawing]

The wafer on which the resist film obtained by the above-described method was disposed was subjected to pattern irradiation using an electron beam drawing apparatus (manufactured by Advantest Corporation, F7000S; acceleration voltage: 50 KeV). In this case, drawing was performed so that a line and space of line/space = 1/1 was formed. After the electron beam drawing (pattern irradiation), the above-described wafer was heated on a hot plate at 100°C for 60 seconds, and further immersed in a 2.38% by mass tetramethylammonium hydroxide (TMAH) aqueous solution for 60 seconds. Next, the above-described wafer was rinsed with water for 30 seconds. Thereafter, the above-described wafer was rotated at a rotation speed of 4,000 rpm for 30 seconds, baked at 95°C for 60 seconds, and dried.

<Evaluation of LWR>

The line-and-space pattern (line/space = 1/1) with a line width of 50 nm, which was resolved by the above-described method, was observed from an upper part of the pattern using a length-measuring scanning electron microscope (SEM (S-9380II manufactured by Hitachi, Ltd.)). The line width of the pattern was observed at an arbitrary point (100 points), and 3$\sigma$ (nm) of the measurement variation was evaluated as a value of LWR. As the value is smaller, the performance is better.

The pattern to be evaluated in the evaluation of LWR is a pattern formed by using the resist composition immediately after preparation.

In addition, the irradiation amount of the electron beam for forming the pattern was set to the optimum irradiation amount for reproducing the irradiated pattern.

<Evaluation of Stability (Temporal Stability of Resist Composition)>

Temporal stability of the resist composition was evaluated from a difference between a line width of a pattern obtained using a resist composition stored at each temperature of 40°C, 50°C, and 60°C for 30 days immediately after preparation and a line width of a pattern obtained using a resist composition (reference resist) stored at 0°C for 30 days immediately after preparation.

Specifically, first, with regard to the line width of the pattern obtained using the resist composition stored at 0°C for 30 days, an exposure amount E1 for reproducing a line-and-space (line/space = 1/1) drawing pattern with a line width of 50 nm was obtained.

Next, a resist film was formed of the three types of resist compositions stored at the each temperature for 30 days, and expose was performed at the exposure amount E1. Each pattern was obtained by the same method as shown in [Electron Beam (EB) Exposure Test], except that the exposure was fixed to the exposure amount E1.

A line width of the obtained pattern was measured using a length-measuring scanning electron microscope (SEM (S-9380II of Hitachi, Ltd.)), and a fluctuation value of the pattern line width with respect to the line width (50 nm) of the pattern formed of the reference resist was obtained.

Based on the obtained data of three points (the fluctuation value of the above-described pattern line width), a semilogarithmic graph in which an X-axis was a reciprocal of a storage temperature (temperature converted from Celsius to Kelvin) and a Y-axis was a reciprocal of the fluctuation value of the line width per day (that is, a value obtained by dividing the obtained fluctuation value of the line width by 30) was plotted and fitted with a straight line. In the obtained straight line, a value of a Y coordinate at an X coordinate corresponding to the storage temperature = 25°C was read. Based on the read value of Y coordinate, a 1 mm line width-guaranteed period under room temperature condition (25°C) (in a case where the resist composition was kept stored at (25°C), calculated number of days for which the fluctuation value of pattern line width in the pattern obtained by exposure at the exposure amount E1 could be maintained within 1 nm) was obtained.

The obtained 1 mm line width-guaranteed period was classified as shown below and used as an evaluation result of stability (temporal stability of the resist composition).

A: 500 days or more
B: 300 days or more and less than 500 days
C: 100 days or more and less than 300 days
D: less than 100 days

[Extreme Ultraviolet Ray (EUV) Exposure Test]

Using an EUV exposure device (manufactured by Exitech Ltd., Micro Exposure Tool, numerical aperture (NA): 0.3, Quadrupole, outer sigma: 0.68, inner sigma: 0.36), the wafer on which the resist film obtained by the above-described

method was disposed was subjected to pattern exposure through an exposure mask (line/space = 1/1).

After the exposure, the above-described wafer was heated on a hot plate at 100°C for 90 seconds, and further immersed in a 2.38% by mass tetramethylammonium hydroxide (TMAH) aqueous solution for 60 seconds. Next, the above-described wafer was rinsed with water for 30 seconds. Thereafter, the above-described wafer was rotated at a rotation speed of 4,000 rpm for 30 seconds, baked at 95°C for 60 seconds, and dried.

<Evaluation of LWR>

The line-and-space pattern (line/space = 1/1) with a line width of 50 nm, which was resolved by the above-described method, was observed from an upper part of the pattern using a length-measuring scanning electron microscope (SEM (S-9380II manufactured by Hitachi, Ltd.)). The line width of the pattern was observed at an arbitrary point (160 points), and 3σ (nm) of the measurement variation was evaluated as a value of LWR. As the value is smaller, the performance is better.

The pattern to be evaluated in the evaluation of LWR is a pattern formed by using the resist composition immediately after preparation.

[Result]

The following table shows the formulation of the resist composition of each Example or Comparative Example, and features and evaluation results thereof.

In the table, the column of "Amount (g)" indicates an addition amount (g) of each of the solid contents (resin, photoacid generator, basic compound, and surfactant).

The column of "Mass ratio" for the solvent indicates a mixing ratio (mass ratio) of each solvent.

The column of "Molecular weight of repeating unit (a) after elimination" indicates a molecular weight of a repeating unit obtained by repeating, with a hydrogen atom, a leaving group in the repeating unit (a) of each resin used in Examples.

The column of "Acid pKa" indicates a pKa of an acid generated by the elimination of the leaving group by irradiation with actinic ray or radiation in the repeating unit (a) of each resin.

The column of "Acid-decomposable unit" indicates the presence or absence of the repeating unit having an acid-decomposable group in the resin used in each Example. A case of having the repeating unit having an acid-decomposable group is denoted as A, and a case of not having the repeating unit having an acid-decomposable group is denoted as B.

The column of "Non-ionic aromatic" indicates whether or not each basic compound corresponds to a non-ionic compound having an aromatic ring group. A case of corresponding to the non-ionic compound having an aromatic ring group is denoted as A, and a case of not corresponding to the non-ionic compound having an aromatic ring group is denoted as B.

The column of "Acid generation amount (mmol/g)" indicates the total molar amount of the repeating unit (a) and the photoacid generator with respect to the total solid content of each resist composition.

[Table 1]

| | Resin | | | | | | Photoacid generator | | Basic compound | | | Surfactant | | Solvent | | | EB exposure | | EUV exposure |
|---|---|---|---|---|---|---|---|---|---|---|---|---|---|---|---|---|---|---|---|
| | Type | Amount (g) | Molecular weight of repeating unit (a) after elimination | Acid pKa | Acid-decomposable unit | Formula A2 | Type | Amount (g) | Type | Amount (g) | Non-ionic aromatic | Type | Amount (g) | Type | Mass ratio | Acid generation amount (mmol/g) | LWR | Stability | LWR |
| Example 1 | A-1 | 10 | 108 | 2.00 | A | A | - | | D-1 | 0.2 | A | W-1 | 0.003 | SL-1/SL-2 | 60/40 | 1.65 | 4.0 | A | 40 |
| Example 2 | A-2 | 10 | 174 | 2.16 | A | A | - | | D-3 | 0.2 | A | W-4 | 0.003 | SL-1/SL-5 | 60/40 | 1.33 | 4.1 | A | 4.1 |
| Example 3 | A-3 | 9 | 191 | 0.36 | A | A | B-1 | 1 | D-4 | 0.2 | A | W-6 | 0.003 | SL4/SL-2 | 60/40 | 130 | 4.1 | A | 4.1 |
| Example 4 | A-4 | 10 | 230 | -2.70 | A | A | - | | D-6 | 0.3 | B | W-1 | 0 003 | SL-1/SL-5 | 50/50 | 0.79 | 4.5 | B | 46 |
| Example 5 | A-5 | 10 | 207 | 1.70 | A | A | - | | D-1 | 0.2 | A | W-5 | 0.003 | SL-1/SL-5 | 60/40 | 1.53 | 4.3 | B | 4.4 |
| Example 6 | A-6 | 10 | 184 | -0.48 | A | A | - | | D-3 | 0.15 | A | W-3 | 0.003 | SL-1/SL-5 | 70/30 | 1.50 | 4.0 | A | 40 |
| Example 7 | A-7 | 9 | 207 | 1.70 | A | A | B-3 | 1 | D-4 | 0.15 | A | W-4 | 0 003 | SL-1/SL-8 | 80/20 | 1.40 | 4.2 | B | 43 |
| Example 8 | A-8 | 10 | 284 | -3.10 | A | A | - | | D-6 | 0.1 | B | W-4 | 0.003 | SL-1/SL-8 | 80/20 | 1.19 | 4.3 | B | 43 |
| Example 9 | A-9 | 10 | 196 | -0.33 | A | A | - | | D-4 | 0.25 | A | W-5 | 0.003 | SL-1/SL-5 | 60/40 | 1.17 | 4.1 | A | 4.1 |
| Example 10 | A-10 | 9 | 208 | 1.55 | A | A | B-2 | 1 | D-5 | 0.3 | B | W-3 | 0.003 | SL-1/SL-5 | 60/40 | 1.34 | 4.3 | B | 4.2 |
| Example 11 | A-11 | 10 | 184 | -0.48 | A | A | - | | D-6 | 02 | B | W-3 | 0.003 | SL-1/SL-5 | 60/40 | 1.07 | 4.2 | B | 43 |
| Example 12 | A-12 | 10 | 208 | 1.55 | A | A | - | | D-8 | 02 | B | W-6 | 0.003 | SL-1/SL-5 | 70/30 | 1.18 | 4.3 | B | 43 |

(continued)

| | Resin | | | | | | Photoacid generator | | Basic compound | | | Surfactant | | Solvent | | Acid generation amount (mmol/g) | EB exposure | | EUV exposure |
|---|---|---|---|---|---|---|---|---|---|---|---|---|---|---|---|---|---|---|---|
| | Type | Amount (g) | Molecular weight of repeating unit (a) after elimination | Acid pKa | Acid-decomposable unit | Formula A2 | Type | Amount (g) | Type | Amount (g) | Non-ionic aromatic | Type | Amount (g) | Type | Mass ratio | | LWR | Stability | LWR |
| Example 13 | A-13 | 9 | 196 | -0.33 | A | B | B-4 | 1 | D-1 | 0.1 | A | W-1 | 0.003 | SL-1/SL-7 | 90/10 | 1.34 | 4.2 | B | 4.1 |
| Example 14 | A-14 | 10 | 184 | -0.48 | A | B | - | | D-5 | 0.25 | B | W-2 | 0.003 | SL-1/SL-7 | 90/10 | 0.77 | 4.7 | B | 4.7 |
| Example 15 | A-15 | 10 | 108 | 2.00 | A | A | - | | D-5 | 0.3 | B | W-6 | 0.003 | SL-1/SL-6 | 60/40 | 0.67 | 4.9 | B | 49 |
| Example 16 | A-16 | 10 | 108 | 2.00 | A | B | - | | D-3 | 0.4 | A | W-1 | 0.003 | SL-3/SL-5 | 60/40 | 0.77 | 4.6 | B | 4.6 |
| Example 17 | A-17 | 10 | 184 | -0.48 | A | A | - | | D-5 | 02 | B | W-2 | 0.003 | SL-3/SL-5 | 60/40 | 1.31 | 4.2 | B | 43 |
| Example 18 | A-18 | 9 | 284 | -3.10 | A | B | B-5 | 1 | D-6 | 0.1 | B | W-5 | 0.003 | SL-4/SL-5 | 60/40 | 0.84 | 4.6 | B | 4.8 |
| Example 19 | A-19 | 10 | 242 | -0.76 | A | A | - | | D-1 | 0.2 | A | W-2 | 0.003 | SL-4/SL-5 | 60/40 | 1.03 | 4.2 | B | 4.2 |
| Example 20 | A-20 | 10 | 256 | -2.02 | A | A | - | | D-3 | 0.15 | A | W-2 | 0.003 | SL-6 | 100 | 1.39 | 4.3 | B | 4.4 |
| Example 21 | A-21 | 10 | 184/242 | -0.48/-0.76 | A | A | - | | D-5 | 0.3 | B | W-3 | 0.003 | SL-4/SL-5 | 60/40 | 1.50 | 4.2 | B | 4.2 |
| Example 22 | A-22 | 10 | 184 | -0.48 | A | A | - | | D-5 | 0.4 | B | W-3 | 0.003 | SL-4/SL-5 | 60/40 | 0.52 | 4.9 | B | 4.9 |
| Example 23 | A-1 | 10 | 108 | 2.00 | A | A | - | | D-7 | 0,2 | B | W-1 | 0.003 | SL-1/SL-2 | 60/40 | 1.65 | 4.1 | C | 4.1 |
| Example 24 | A-1 | 10 | 108 | 2.00 | A | A | - | | D-8 | 0.2 | B | W-1 | 0.003 | SL-1/SL-2 | 60/40 | 1.65 | 4.1 | B | 4.1 |

(continued)

| | Resin | | | | | | Photoacid generator | | Basic compound | | | Surfactant | | Solvent | | | EB exposure | | EUV exposure |
|---|---|---|---|---|---|---|---|---|---|---|---|---|---|---|---|---|---|---|---|
| | Type | Amount (g) | Molecular weight of repeating unit (a) after elimination | Acid pKa | Acid-decomposable unit | Formula A2 | Type | Amount (g) | Type | Amount (g) | Non-ionic aromatic | Type | Amount (g) | Type | Mass ratio | Acid generation amount (mmol/g) | LWR | Stability | LWR |
| Example 25 | A-23 | 10 | 108 | 2.00 | B | A | - | | D-1 | 0.2 | A | W-1 | 0.003 | SL-1/SL-2 | 60/40 | 2.63 | 4.9 | A | 4.9 |
| Comparative Example 1 | A-2 | 10 | 174 | 2.16 | A | A | - | | D-2 | 0.2 | B | W-4 | 0.003 | SL-1/SL-5 | 60/40 | 1.33 | 6.4 | D | 62 |
| Comparative Example 2 | AX-1 | 10 | 476 | -2.92 | A | A | - | | D-1 | 0.2 | A | W-1 | 0.003 | SL-1/SL-2 | 60/40 | 1.02 | 6.2 | C | 6.5 |
| Comparative Example 3 | AX-2 | 10 | 184 | -4.80 | A | A | - | | D-1 | 0,2 | A | W-1 | 0.003 | SL-1/SL-2 | 60/40 | 0.28 | 7.0 | A | 7.1 |
| Comparative Example 4 | AX-3 | 6 | - | - | A | A | B-5 | 4 | D-1 | 0.2 | A | W-1 | 0.003 | SL-1/SL-2 | 60/40 | 0.78 | 7.6 | A | 7.7 |
| Comparative Example 5 | AX-4 | 10 | 342 | -3.14 | A | A | - | | D-6 | 0.1 | B | W-4 | 0.003 | SL-1/SL-8 | 80/20 | 1.19 | 60 | C | 6.1 |

From the results shown in the table, it was confirmed that the resist composition according to the embodiment of the present invention was excellent in stability, LWR suppression property of the pattern to be formed was also excellent.
Even in a case where the base material on which the resist film was formed was changed from the Si wafer to a chrome substrate, the same results were obtained.
In a case where the resin (A) had the repeating unit having an acid-decomposable group, it was confirmed that the stability of the resist composition and/or the LWR suppression property of the pattern to be formed was more excellent (refer to comparison between Example 1 and Example 25, and the like).
From the viewpoint that the stability of the resist composition and/or the LWR suppression property of the pattern to be formed was more excellent, it was confirmed that the acid generation amount of the resist composition was preferably 0.70 mmol/g or more and more preferably 1.00 mmol/g or more (refer to comparison between examples of using the resin (A) having the repeating unit having an acid-decomposable group, and the like).
In a case where the basic composition had the non-ionic compound having an aromatic ring group, it was confirmed that the stability of the resist composition and/or the LWR suppression property of the pattern to be formed was more excellent (refer to comparison between Example 1 and Examples 23 and 24, and the like).
Furthermore, in a case where the resin (A) had the repeating unit (a) which generated an acid with a pKa of -1.5 or more by irradiation with actinic ray or radiation and had a molecular weight of 200 or less after the irradiation, the repeating unit having an acid-decomposable group, and the repeating unit represented by General Formula (A2), the basic composition had the non-ionic compound having an aromatic ring group, and the acid generation amount of the resist composition was 1.00 mmol/g or more, it was confirmed that the stability of the resist composition and/or the LWR suppression property of the pattern to be formed was particularly excellent (refer to the results of Examples 1 to 3, 6, and 9, and the like).
In addition, a resist composition was produced as in Example 1, except that the resin A-1 used in the resist composition was changed to a mixture of equivalent amounts of A-1 and A-8. As a result of performing the same tests as in Example 1 using the resist composition, the same results as in Example 1 were obtained.
In addition, a resist composition was produced as in Example 1, except that the basic compound D-1 used in the resist composition was changed to a mixture of equivalent amounts of D-1 and D-3. As a result of performing the same tests as in Example 1 using the resist composition, the same results as in Example 1 were obtained.
In addition, a resist composition was produced as in Example 3, except that the photoacid generator B-1 used in the resist composition was changed to a mixture of equivalent amounts of B-1 and B-3. As a result of performing the same tests as in Example 3 using the resist composition, the same results as in Example 3 were obtained.

## Claims

**1.** An actinic ray-sensitive or radiation-sensitive resin composition comprising:

a resin (A) having a repeating unit (a); and
a basic compound, a pKa of a conjugate acid of which is 13.00 or less,
wherein the repeating unit (a) has a non-ionic group which generates an acid in a case where a leaving group is eliminated by irradiation with an actinic ray or a radiation, in which a repeating unit obtained by replacing the leaving group with a hydrogen atom has a molecular weight of 300 or less,
in a case where the actinic ray-sensitive or radiation-sensitive resin composition does not contain a compound which generates an acid by irradiation with an actinic ray or a radiation, a molar amount of the repeating unit (a) is 0.50 mmol/g or more with respect to a total solid content of the actinic ray-sensitive or radiation-sensitive resin composition, and
in a case where the actinic ray-sensitive or radiation-sensitive resin composition contains the compound which generates an acid by irradiation with an actinic ray or a radiation, a total molar amount of the repeating unit (a) and the compound is 0.50 mmol/g or more with respect to the total solid content of the actinic ray-sensitive or radiation-sensitive resin composition.

**2.** The actinic ray-sensitive or radiation-sensitive resin composition according to claim 1,

wherein the repeating unit (a) is a repeating unit represented by General Formula (1),

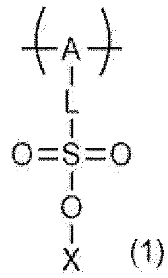

(1)

in General Formula (1), A represents a group constituting a main chain of a resin,
L represents a single bond or a divalent linking group, and
X represents a group which is eliminated by irradiation with an actinic ray or a radiation.

**3.** The composition according to claim 1 or 2,

wherein the repeating unit (a) is a repeating unit represented by General Formula (1-2),

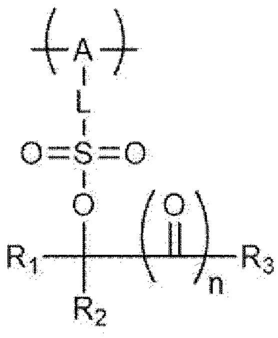

(1-2)

in General Formula (1-2), A represents a group constituting a main chain of a resin,
L represents a single bond or a divalent linking group,
$R_1$ and $R_2$ each independently represent a hydrogen atom or an organic group,
$R_3$ represents an organic group, and
n represents 0 or 1,
where two of $R_1$ to $R_3$ may be bonded to each other to form a ring.

**4.** The actinic ray-sensitive or radiation-sensitive resin composition according to claim 2 or 3,

wherein A is a group consisting of only atoms selected from the group consisting of a hydrogen atom and a carbon atom, and
L is a single bond or a group consisting of only atoms selected from the group consisting of a hydrogen atom and a carbon atom.

**5.** The actinic ray-sensitive or radiation-sensitive resin composition according to any one of claims 1 to 4, wherein the repeating unit (a) is a repeating unit which generates an acid having a pKa of -1.50 or more by irradiation with an actinic ray or a radiation.

**6.** The actinic ray-sensitive or radiation-sensitive resin composition according to any one of claims 1 to 5, wherein, in the repeating unit (a), the repeating unit obtained by replacing the leaving group with a hydrogen atom has a molecular weight of 200 or less.

**7.** The actinic ray-sensitive or radiation-sensitive resin composition according to any one of claims 1 to 6, wherein the resin (A) is a resin in which solubility in an alkali developer is improved by action of acid.

**8.** The actinic ray-sensitive or radiation-sensitive resin composition according to any one of claims 1 to 7,

wherein the resin (A) has a repeating unit represented by General Formula (A2),

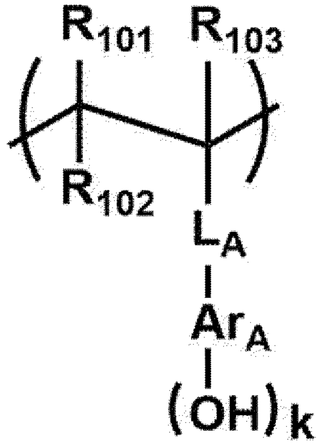

(A2)

in General Formula (A2), $R_{101}$, $R_{102}$, and $R_{103}$ each independently represent a hydrogen atom, an alkyl group, a cycloalkyl group, a halogen atom, a cyano group, or an alkyloxycarbonyl group,
$L_A$ represents a single bond or a divalent linking group,
$Ar_A$ represents an aromatic ring group, and
k represents an integer of 1 to 5,
where $R_{102}$ may be bonded to $Ar_A$, and in this case, $R_{102}$ represents a single bond or an alkylene group.

**9.** The actinic ray-sensitive or radiation-sensitive resin composition according to any one of claims 1 to 8,

wherein the resin (A) has a repeating unit having an acid-decomposable group, and
the repeating unit having an acid-decomposable group is decomposed by action of acid to generate one or more groups selected from the group consisting of a carboxyl group and an aromatic hydroxyl group.

**10.** The actinic ray-sensitive or radiation-sensitive resin composition according to claim 9,

wherein the repeating unit having an acid-decomposable group is a repeating unit represented by any one of General Formulae (3) to (7),

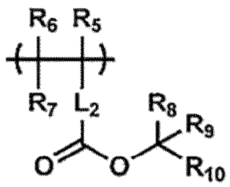

(3)

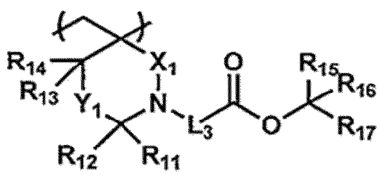

(4)

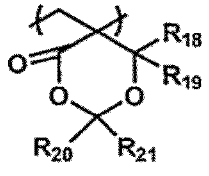

(5)

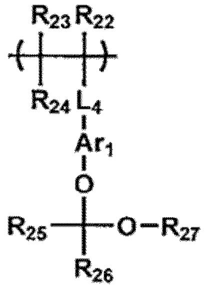

(6)

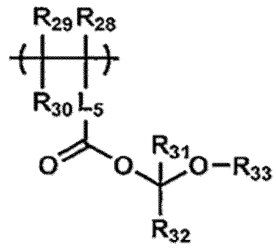

(7)

in General Formula (3), $R_5$ to $R_7$ each independently represent a hydrogen atom, an alkyl group, a cycloalkyl group, a halogen atom, a cyano group, or an alkoxycarbonyl group,
$L_2$ represents a single bond or a divalent linking group, and
$R_8$ to $R_{10}$ each independently represent an alkyl group, a cycloalkyl group, an aryl group, an aralkyl group, or an alkenyl group, where two of $R_8$ to $R_{10}$ may be bonded to each other to form a ring,
in General Formula (4), $R_{11}$ to $R_{14}$ each independently represent a hydrogen atom or an organic group, where at least one of $R_{11}$ or $R_{12}$ represents an organic group,
$X_1$ represents -CO-, -SO-, or $-SO_2-$,
$Y_1$ represents -O-, -S-, -SO-, $-SO_2-$, or $-NR_{34}-$, where $R_{34}$ represents a hydrogen atom or an organic group,
$L_3$ represents a single bond or a divalent linking group, and
$R_{15}$ to $R_{17}$ each independently represent an alkyl group, a cycloalkyl group, an aryl group, an aralkyl group, or an alkenyl group, where two of $R_{15}$ to $R_{17}$ may be bonded to each other to form a ring,
in General Formula (5), $R_{18}$ and $R_{19}$ each independently represent a hydrogen atom or an organic group, and
$R_{20}$ and $R_{21}$ each independently represent a hydrogen atom, an alkyl group, a cycloalkyl group, an aryl group, an aralkyl group, or an alkenyl group, where $R_{20}$ and $R_{21}$ may be bonded to each other to form a ring,
in General Formula (6), $R_{22}$ to $R_{24}$ each independently represent a hydrogen atom, an alkyl group, a cycloalkyl group, a halogen atom, a cyano group, or an alkoxycarbonyl group,
$L_4$ represents a single bond or a divalent linking group,
An represents an aromatic ring group, and
$R_{25}$ to $R_{27}$ each independently represent a hydrogen atom, an alkyl group, a cycloalkyl group, an aryl group, an aralkyl group, or an alkenyl group,
where $R_{26}$ and $R_{27}$ may be bonded to each other to form a ring, and
$R_{24}$ or $R_{25}$ may be bonded to An,
in General Formula (7), $R_{28}$ to $R_{30}$ each independently represent a hydrogen atom, an alkyl group, a cycloalkyl group, a halogen atom, a cyano group, or an alkoxycarbonyl group,
$L_5$ represents a single bond or a divalent linking group,
$R_{31}$ and $R_{32}$ each independently represent a hydrogen atom, an alkyl group, a cycloalkyl group, an aryl group, an aralkyl group, or an alkenyl group, and
$R_{33}$ represents an alkyl group, a cycloalkyl group, an aryl group, an aralkyl group, or an alkenyl group, where $R_{32}$ and $R_{33}$ may be bonded to each other to form a ring.

**11.** The actinic ray-sensitive or radiation-sensitive resin composition according to claim 10, wherein the repeating unit having an acid-decomposable group is a repeating unit represented by any one of General Formula (6) or (7).

**12.** The actinic ray-sensitive or radiation-sensitive resin composition according to any one of claims 1 to 11,

wherein, in the case where the actinic ray-sensitive or radiation-sensitive resin composition does not contain the compound which generates an acid by irradiation with an actinic ray or a radiation, the molar amount of the repeating unit (a) is 0.70 mmol/g or more with respect to the total solid content of the actinic ray-sensitive or radiation-sensitive resin composition, and
in the case where the actinic ray-sensitive or radiation-sensitive resin composition contains the compound which generates an acid by irradiation with an actinic ray or a radiation, the total molar amount of the repeating unit (a) and the compound is 0.70 mmol/g or more with respect to the total solid content of the actinic ray-sensitive or radiation-sensitive resin composition.

**13.** The actinic ray-sensitive or radiation-sensitive resin composition according to any one of claims 1 to 12,

wherein, in the case where the actinic ray-sensitive or radiation-sensitive resin composition does not contain the compound which generates an acid by irradiation with an actinic ray or a radiation, the molar amount of the repeating unit (a) is 1.00 mmol/g or more with respect to a total solid content of the actinic ray-sensitive or radiation-sensitive resin composition, and
in the case where the actinic ray-sensitive or radiation-sensitive resin composition contains the compound which generates an acid by irradiation with an actinic ray or a radiation, the total molar amount of the repeating unit (a) and the compound is 1.00 mmol/g or more with respect to the total solid content of the actinic ray-sensitive or radiation-sensitive resin composition.

**14.** The actinic ray-sensitive or radiation-sensitive resin composition according to any one of claims 1 to 13, wherein the basic compound is a compound having an aromatic ring group.

**15.** The actinic ray-sensitive or radiation-sensitive resin composition according to any one of claims 1 to 14, wherein the basic compound is a non-ionic compound having an aromatic ring group.

**16.** A resist film formed of the actinic ray-sensitive or radiation-sensitive resin composition according to any one of claims 1 to 15.

**17.** A positive tone pattern forming method comprising:

a step of forming a resist film on a substrate using the actinic ray-sensitive or radiation-sensitive resin composition according to any one of claims 1 to 15;
a step of exposing the resist film; and
a step of developing the exposed resist film using an alkali developer.

**18.** A method for manufacturing an electronic device, comprising: the positive tone pattern forming method according to claim 17.

## INTERNATIONAL SEARCH REPORT

International application No. **PCT/JP2021/047008**

### A. CLASSIFICATION OF SUBJECT MATTER

***C08F 212/14***(2006.01)i; ***C08F 220/38***(2006.01)i; ***C08F 220/54***(2006.01)i; ***C08F 228/02***(2006.01)i; ***G03F 7/004***(2006.01)i; ***G03F 7/039***(2006.01)i; ***G03F 7/20***(2006.01)i

FI: G03F7/039 601; C08F228/02; C08F212/14; C08F220/38; C08F220/54; G03F7/20 501; G03F7/004 503A; G03F7/004 501

According to International Patent Classification (IPC) or to both national classification and IPC

### B. FIELDS SEARCHED

Minimum documentation searched (classification system followed by classification symbols)

C08F212/14; C08F220/38; C08F220/54; C08F228/02; G03F7/004; G03F7/039; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| X | JP 2011-248019 A (FUJIFILM CORP.) 08 December 2011 (2011-12-08) claims, examples 5, 9 | 1-2, 4-18 |
| A | | 3 |
| X | WO 2016/158711 A1 (FUJIFILM CORP.) 06 October 2016 (2016-10-06) claims, examples | 1-18 |
| X | JP 2012-255845 A (FUJIFILM CORP.) 27 December 2012 (2012-12-27) claims, examples 15-16, 23, 25 | 1-2, 4-18 |
| A | | 3 |
| X | JP 2013-008022 A (SUMITOMO CHEMICAL CO., LTD.) 10 January 2013 (2013-01-10) claims, examples | 1-18 |

☐ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **07 February 2022** | **01 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/047008**

| Patent document cited in search report | Publication date (day/month/year) | Patent family member(s) | Publication date (day/month/year) |
|---|---|---|---|
| JP 2011-248019 A | 08 December 2011 | US 2013/0040096 A1<br>claims, examples 5, 9<br>WO 2011/149035 A1<br>claims, examples 5, 9<br>EP 2577397 A1<br>TW 201202849 A<br>CN 102906642 A<br>KR 10-2013-0106270 A | |
| WO 2016/158711 A1 | 06 October 2016 | US 2018/0017872 A1<br>claims, examples<br>TW 201638673 A | |
| JP 2012-255845 A | 27 December 2012 | (Family: none) | |
| JP 2013-008022 A | 10 January 2013 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011186341 A
- WO 2018193954 A
- WO 2020004306 A
- US 20160070167 A1
- US 20150004544 A1
- US 20160237190 A1
- US 20160274458 A1
- US 20120135348 A1
- US 20150309408 A1
- JP 2014041328 A
- JP 2013228681 A
- US 2015004533 A
- WO 201819395 A
- JP 2014059543 A
- JP 2013061648 A


### Non-patent literature cited in the description


- *Materials Letters,* 2008, vol. 62, 3152
- **TERUO NAGAO.** *Bulletin of Hakodate National College of Technology,* 1993, (27), 111-120